# EUROPEAN PATENT APPLICATION

(11) **EP 2 656 961 A1**
(43) Date of publication of application: **30.10.2013**
(21) Application number: 12744669.8
(22) Date of filing: 01.02.2012
(51) Int. Cl.: B23K 26/36, B23K 26/00, B23K 26/04, B23K 26/40, B81C 99/00, C03C 15/00, C03C 23/00

(54) **METHOD FOR MANUFACTURING SUBSTRATE HAVING MICROPORE, AND SUBSTRATE**

(30) Priority: 08.02.2011 JP 2011024998
(71) Applicant: Fujikura Ltd., Tokyo 135-8512 (JP); The University of Tokyo, Bunkyo-ku, Tokyo 113-8654 (JP)
(72) Inventor: NUKAGA Osamu, Sakura-shi, Chiba 285-8550 (JP); YAMAMOTO Satoshi, Sakura-shi, Chiba 285-8550 (JP); TABATA Kazuhito, Tokyo 113-8654 (JP); SUGIYAMA Masakazu, Tokyo 113-8654 (JP)
(74) Representative: Cabinet Plasseraud
(86) International application number: PCT/JP2012/052255
(87) International publication number: WO 2012/108316

(57) **Abstract**

A method of manufacturing a base body having a microscopic hole, includes: forming at least one of a first modified region and a second modified region by scanning inside of a base body with a focal point of a first laser light having a pulse duration on order of picoseconds or less; forming a periodic modified group formed of a plurality of third modified regions and fourth modified regions by scanning an inside of the base body with a focal point of a second laser light having a pulse duration on order of picoseconds or less; obtaining the base body which is formed so that the first modified region and the second modified region overlap or come into contact with the modified group; and forming a microscopic hole by removing the first modified region and the third modified regions by etching.

## Description

### TECHNICAL FIELD

The present invention relates to a method of manufacturing a base body having a microscopic hole, and a base body having a microscopic hole.
This application claims priority from Japanese Patent Application No. 2011-024998 filed on February 8, 2011, the content of which is incorporated herein by reference in their entirety.

### BACKGROUND ART

As a method of forming a microstructure in a substrate (materials to be processed), following conventional methods are adopted.
As a first method, a method of forming a microstructure using photolithographic technique is adopted.
This is a method of firstly forming a mask on a surface of a material, thereafter, forming a microstructure on the substrate surface by wet etching or dry etching (refer to Patent Document 1).

Additionally, as a second method, a method is known of collectively irradiating a substrate with a laser having a pulse duration on order of picoseconds or less, forming a structural modified portion at a light-collecting portion, thereafter, forming high aspect trenches, the microscopic holes, structures which are branched in a horizontal direction or branched-flexibly bent by wet etching using hydrofluoric acid or the like (refer to Patent Document 2).

However, generally in the aforementioned first photolithography, it is difficult to form a microscopic hole having a diameter on the order of several hundred nanometers (in nanometers) in, for example, materials to be processed such as silica glass or the like and form a microstructure in the microscopic hole.

Furthermore, in the case of using the secondary-described method combining the pulsed laser and the wet etching, it is possible to form a microscopic hole inside the substrate.
However, in this method, a processing method of forming a microscopic hole having a diameter on at least the order of micrometers such as several micron or more is mainly used, and it is difficult to realize formation of a microscopic hole having a diameter on the order of nanometers (processed width on the order of nanometers).

### PRIOR ART DOCUMENTS

### PATENT DOCUMENTS

Patent Document 1 Japanese Unexamined Patent Application, First Publication No. 2006-111525
Patent Document 2 Japanese Unexamined Patent Application, First Publication No. 2005-219105

### SUMMARY OF INVENTION

### PROBLEMS TO BE SOLVED BY THE INVENTION

The invention was conceived in view of the above-described situation, and has an object to provide a method of manufacturing a base body provided with a microscopic hole having a diameter on the order of nanometers and including a microscopic periodic structure and provide the base body.

### MEANS FOR SOLVING THE PROBLEMS

A method of manufacturing a base body of a first aspect of the invention is a method of manufacturing a base body having a microscopic hole. The method includes: forming at least one of a first modified region and a second modified region by scanning inside of a base body with a focal point of a first laser light having a pulse duration on order of picoseconds or less; forming a periodic modified group formed of a plurality of third modified regions and fourth modified regions by scanning an inside of the base body with a focal point of a second laser light having a pulse duration on order of picoseconds or less; obtaining the base body which is formed so that the first modified region and the second modified region overlap or come into contact with the modified group; and forming a microscopic hole by removing the first modified region and the third modified regions by etching.
The first modified region and the second modified region having a diameter on the order of nanometers (corresponding to a microscopic hole having a diameter on the order of nanometers by etching) are formed by use of the first laser light at the region including the region on which the microscopic hole is to be formed in the substrate, the third modified region and the fourth modified region are formed by use of the second laser light at a region on which a periodic structure is to be formed, the first modified region and the third modified region are removed from the substrate by the etching, and it is thereby possible to form the microscopic hole having a hole diameter on the order of nanometers and including a microscopic periodic structure in the substrate.

In the method of manufacturing a base body of the first aspect of the invention, it is preferable that each of the first modified region and the second modified region formed by the first laser light be constituted of a first part and a second part, modified states of the second part of the first modified region and the second part of the second modified region be transformed into a non-etching selectivity state by forming the modified group so as to overlap the second part of the first modified region and the second part of the second modified region after the first modified region and the second modified region are formed, and the first part of the first modified region, the first part of the second modified region, and the periodic modified group be formed so that the first part of the first modified region and the first part of the second modified region overlap or come into contact with the periodic modified group.
The modified state of each of the second parts constituting the first modified region and the second modified region is transformed into a non-etching selectivity state (modification history is erased), etching selectivities of the first part constituting the first modified region and the first part constituting the second modified region remain, and it is thereby possible to form the modified region (first part) in which the diameter of the first modified region and the diameter of the second modified region, on which the microscopic hole is to be formed, become smaller.
As a result, the diameter of the microscopic hole can be smaller than that of the case where a periodic structure is not formed.
That is, it is possible to form a smaller microscopic hole including a microscopic periodic structure and having a diameter on the order of nanometers.

In the method of manufacturing a base body of the first aspect of the invention, it is preferable that the first modified region and the second modified region be formed so as to locally overlap or comes into contact with the third modified regions and the fourth modified regions after the modified group is formed.
When the first modified region and the second modified region are formed so as to locally overlap or come into contact with each of the third modified region and the fourth modified region constituting the periodic modified group, the preliminarily-formed periodic modified group partially hinders the first modified region and the second modified region from being formed.
By this hindering, it is possible to form a modified region making the diameter of the first modified region and the diameter of the second modified region shorter.
As a result, the diameter of the microscopic hole can be smaller than that of the case where a periodic structure is not formed.
That is, it is possible to form a smaller microscopic hole including a microscopic periodic structure and having a diameter on the order of nanometers.

In the method of manufacturing a base body of the first aspect of the invention, it is preferable that an angle formed between a scanning direction of the first laser light and a polarization direction of the first laser light be greater than 88° and less than or equal to 90°.
It is possible to easily form the first and the second modified regions so that the diameter of the first modified region and the diameter of the second modified region become a diameter on the order of nanometers by controlling the angle defined by the scanning direction and the polarization direction to be within the above-described range.
In the method of manufacturing a base body of the first aspect of the invention, it is preferable that an angle formed between a scanning direction of the second laser light and a polarization direction of the second laser light be 0° to 88°.
It is possible to form the third modified region and the fourth modified region so as to intersect with the first modified region and the second modified region by controlling the angle defined by the scanning direction and the polarization direction to be within the above-described range.
Moreover, it is possible to easily form the third modified region and the fourth modified region constituting the periodic modified group at a period on the order of approximately nanometers or submicrons.
In the method of manufacturing a base body of the first aspect of the invention, it is preferable that, the modified group be formed in longitudinal directions of the first modified region and the second modified region.
It is possible to form the periodic structure extending in the longitudinal direction of the microscopic hole by forming the periodic modified group in the longitudinal directions of the first modified region and the second modified region.

A base body of a second aspect of the invention includes: a microscopic hole provided inside the base body; and a microscopic periodic structure formed in a longitudinal direction of the microscopic hole.
Since the periodic structure is formed in the longitudinal direction of the microscopic hole, fluid flows into the periodic structure when the fluid flows in the microscopic hole.
In the base body of the second aspect of the invention, it is preferable that a plurality of microscopic recessed portions, each of which has an opening portion opening at an inner wall of the microscopic hole, be arrayed in the periodic structure.
Since the periodic structure in which the microscopic recessed portions are arrayed is formed in the longitudinal direction of the microscopic hole, fluid flows into each recessed portion constituting the periodic structure when the fluid flows in the microscopic hole.
In the base body of the second aspect of the invention, it is preferable that the distance between the recessed portions be in the range of 0.05 to 1.2 µm.
It is possible to realize an extremely-microscopic periodic structure having a diameter on the order of nanometers or submicrons while maintaining the structural strength of each recessed portion constituting the periodic structure by determining a distance to be in the aforementioned range.
A base body of a third aspect of the invention includes: a plurality of microscopic holes provided inside a base body and arranged parallel to each other; and a microscopic periodic structure formed in a longitudinal direction of the microscopic holes.
Since the periodic structure is formed in the longitudinal direction of the microscopic holes, fluid flows into the periodic structure when the fluid flows in the microscopic hole.
In the third aspect of the invention, it is preferable that a plurality of microscopic through holes, each of which connects the microscopic holes to each other, be arrayed in the periodic structure.
Since the microscopic through holes are formed so as to connect the microscopic holes to each other (communicate), it is possible to apply fluid to flow from one of the microscopic holes (first microscopic hole) to the other of the microscopic holes (second microscopic hole) through the microscopic through hole.
In the third aspect of the invention, it is preferable that the distance between the microscopic through holes be in the range of 0.05 to 1.2 µm.
It is possible to realize an extremely-microscopic periodic structure having a diameter on the order of nanometers or submicrons while maintaining the structural strength of each microscopic through hole constituting the periodic structure by forming the microscopic through hole so that the distance is in the above-described range.

### Effects of the Invention

According to the method of the invention which manufactures a base body having a microscopic hole, it is possible to manufacture the base body (substrate or the like which is materials to be processed) in which a microscopic hole having a hole diameter on the order of nanometers is formed.

According to the base body of the invention, a periodic structure is formed in the longitudinal direction of the microscopic hole.
For this reason, it is possible to allow fluid to flow into the periodic structure when the fluid flows in the microscopic hole.
In addition, according to the base body of the invention, particles can be adsorbed to the opening portion (first end portion of the microscopic hole) of the microscopic hole opening at the surface of the base body.
Particularly, when a suction device is provided at a second end portion of the microscopic hole and the suction device suctions fluid including particles whose diameter is greater than the hole diameter of the microscopic hole from the first end portion of the microscopic hole through the inside of the microscopic hole, since the particles whose diameter is greater than the hole diameter of the microscopic hole cannot enter into the microscopic hole, the particle is captured at the first end portion of the microscopic hole.
Since the periodic structure is formed at the microscopic hole of the invention, the diameter of the first end portion of the microscopic hole is smaller than a diameter of a conventional microscopic hole.
When the particles are adsorbed to the first end portion, a single particle can be adsorbed to the first end portion.
That is, the risk that a plurality of particles are simultaneously captured at a first end portion is reduced.
For this reason, it is possible to easily perform an experiment such as measurement or observation of the captured particles.

### BRIEF DESCRIPTION OF THE DRAWINGS

FIG. 1 is a schematic perspective view showing an example of a base body having a microscopic hole related to the invention.
FIG. 2A is a schematic cross-sectional view corresponding to FIG. 1.
FIG. 2B is a schematic cross-sectional view taken along the line A-A shown in FIG. 2A.
FIG. 2C is a schematic cross-sectional view taken along the line B-B shown in FIG. 2A.
FIG. 3 is a schematic enlarged view corresponding to FIG. 2A.
FIG. 4 is a schematic perspective view showing an example of a base body having a microscopic hole related to the invention.
FIG. 5A is a schematic cross-sectional view corresponding to FIG. 4.
FIG. 5B is a schematic cross-sectional view taken along the line A-A shown in FIG. 5A.
FIG. 5C is a schematic cross-sectional view taken along the line B-B shown in FIG. 5A.
FIG. 6 is a schematic perspective view showing an example of a base body having a microscopic hole related to the invention.
FIG. 7A is a schematic cross-sectional view corresponding to FIG. 6.
FIG. 7B is a schematic cross-sectional view taken along the line A-A shown in FIG. 7A.
FIG. 7C is a schematic cross-sectional view taken along the line B-B shown in FIG. 7A.
FIG. 8 is a schematic perspective view showing an example of a base body having a microscopic hole related to the invention.
FIG. 9A is a schematic cross-sectional view corresponding to FIG. 8.
FIG. 9B is a schematic cross-sectional view taken along the line A-A shown in FIG. 8A.
FIG. 9C is a schematic cross-sectional view taken along the line B-B shown in FIG. 8A.
FIG. 10 is a schematic enlarged view corresponding to FIG. 9A.
FIG. 11 is a schematic perspective view showing an example of a base body having a microscopic hole related to the invention.
FIG. 12A is a schematic cross-sectional view corresponding to FIG. 11.
FIG. 12B is a schematic cross-sectional view taken along the line A-A shown in FIG. 12A.
FIG. 12C is a schematic cross-sectional view taken along the line B-B shown in FIG. 12A.
FIG. 13 is a schematic perspective view showing an example of a base body having a microscopic hole related to the invention.
FIG. 14A is a schematic cross-sectional view corresponding to FIG. 13.
FIG. 14B is a schematic cross-sectional view taken along the line A-A shown in FIG. 14A.
FIG. 14C is a schematic cross-sectional view taken along the line B-B shown in FIG. 14A.
FIG. 15 is a schematic perspective view showing an example of a base body having a microscopic hole related to the invention.
FIG. 16A a schematic cross-sectional view corresponding to FIG. 15.
FIG. 16B is a schematic cross-sectional view taken along the line A-A shown in FIG. 16A.
FIG. 16C is a schematic cross-sectional view taken along the line B-B shown in FIG. 16A.
FIG. 17 is a schematic perspective view showing an example of a base body having a microscopic hole related to the invention.
FIG. 18 is a schematic cross-sectional view corresponding to FIG. 17.
FIG. 19 is a schematic cross-sectional view showing a state where a particle is trapped at a first end portion of a microscopic hole in an example of a base body having a microscopic hole related to the invention.
FIG. 20 is a schematic cross-sectional view showing arrangement of a flow passage at which the microscopic holes are connected to each other in an example of a base body having a microscopic hole related to the invention.
FIG. 21 is a schematic cross-sectional view showing a state where electrodes usable for electrophysiological measurement are disposed in an example of a base body having a microscopic hole related to the invention.
FIG. 22 is a schematic perspective view showing a state where a particle is trapped at a first end portion of a microscopic hole in an example of a base body having a microscopic hole related to the invention.
FIG. 23 is a schematic perspective view showing a state where pluralities of particles are trapped at a first end portion of a microscopic hole in a base body of Comparative Example.
FIG. 24A is a schematic cross-sectional view showing an example of a method of manufacturing a base body having a microscopic hole related to the invention.
FIG. 24B is a schematic cross-sectional view showing an example of a method of manufacturing a base body having a microscopic hole related to the invention.
FIG. 24C is a schematic cross-sectional view showing an example of a method of manufacturing a base body having a microscopic hole related to the invention.
FIG. 25 is a schematic perspective view showing an example of a laser irradiating method α.
FIG. 26A is a view schematically illustrating the relationship between the irradiation intensity of the laser light and a modified region to be formed (low oxygen concentration portion).
FIG. 26B is a view schematically illustrating the relationship between the irradiation intensity of the laser light and a modified region to be formed (low oxygen concentration portion).
FIG. 27 is a schematic perspective view showing an example of a laser irradiating method β.
FIG. 28 is a schematic perspective view showing an example of a laser irradiating method β.
FIG. 29 is a schematic perspective view showing an example of a laser irradiating method.
FIG. 30 is a schematic perspective view showing an example of a laser irradiating method.
FIG. 31 A is a schematic cross-sectional view showing an example of a method of manufacturing a base body having a microscopic hole related to the invention.
FIG. 31 B is a schematic cross-sectional view showing an example of a method of manufacturing a base body having a microscopic hole related to the invention.

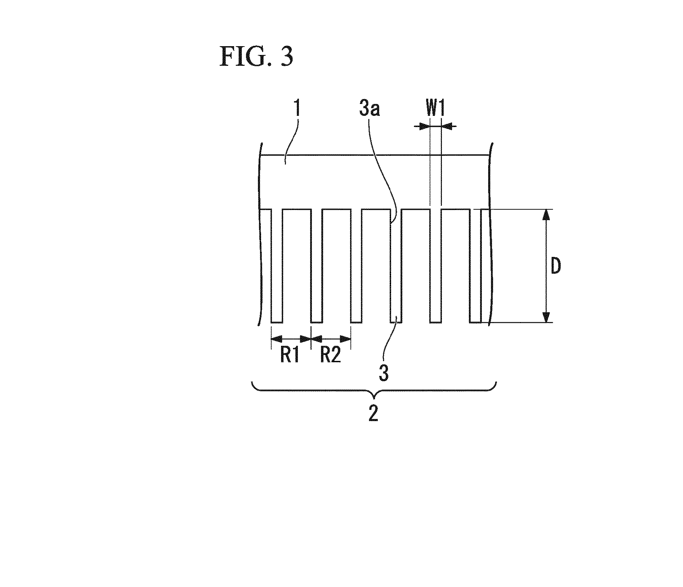

FIG. 3A 3B 3C C is a schematic cross-sectional view showing an example of a method of manufacturing a base body having a microscopic hole related to the invention.

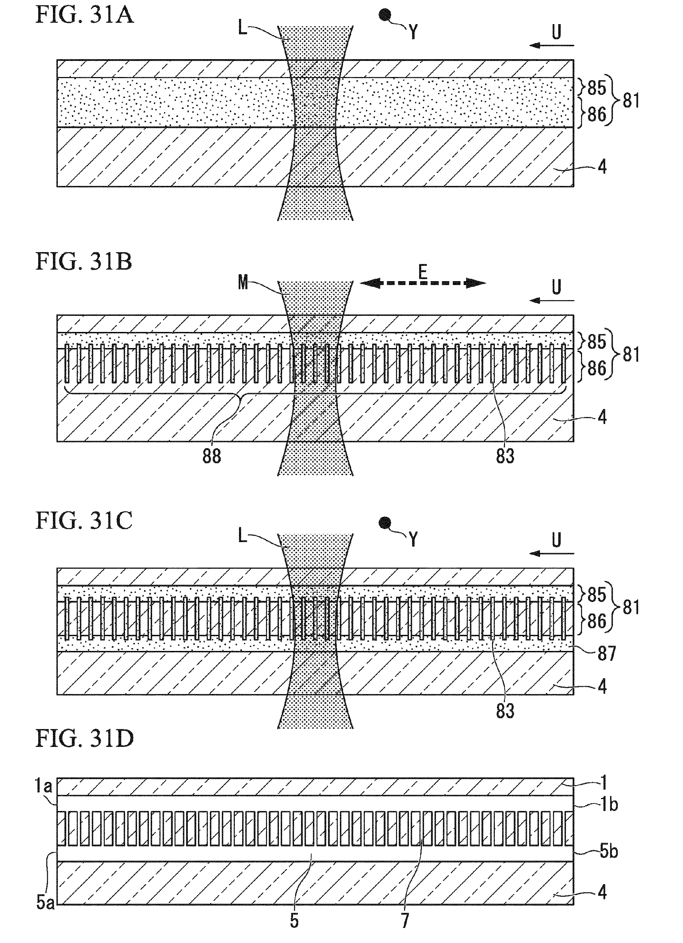

FIG. 31 D is a schematic cross-sectional view showing an example of a method of manufacturing a base body having a microscopic hole related to the invention.

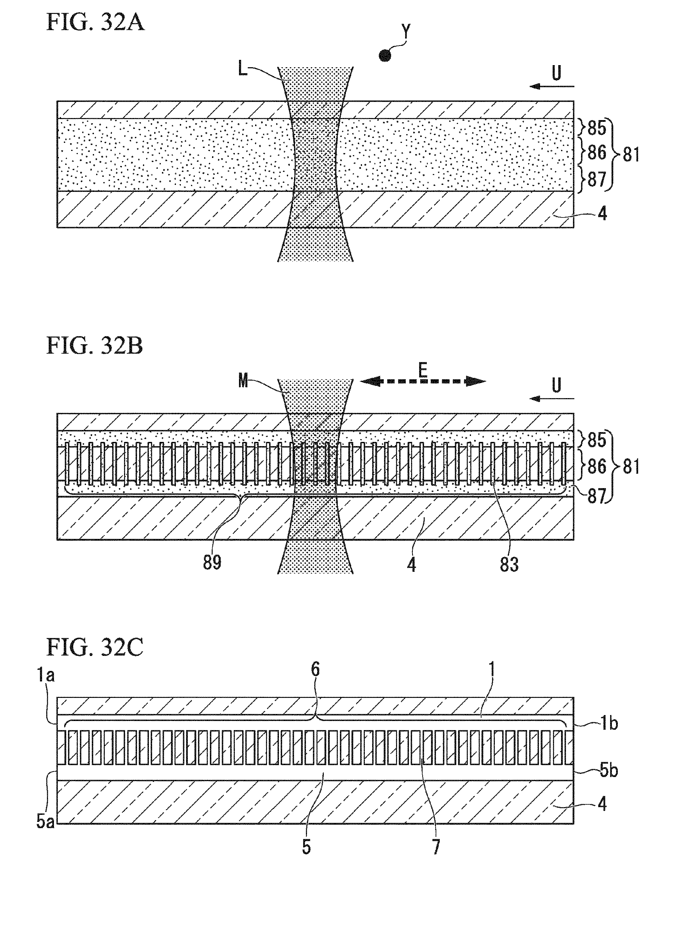

FIG. 32A is a schematic cross-sectional view showing an example of a method of manufacturing a base body having a microscopic hole related to the invention.
FIG. 32B is a schematic cross-sectional view showing an example of a method of manufacturing a base body having a microscopic hole related to the invention.
FIG. 32C is a schematic cross-sectional view showing an example of a method of manufacturing a base body having a microscopic hole related to the invention.

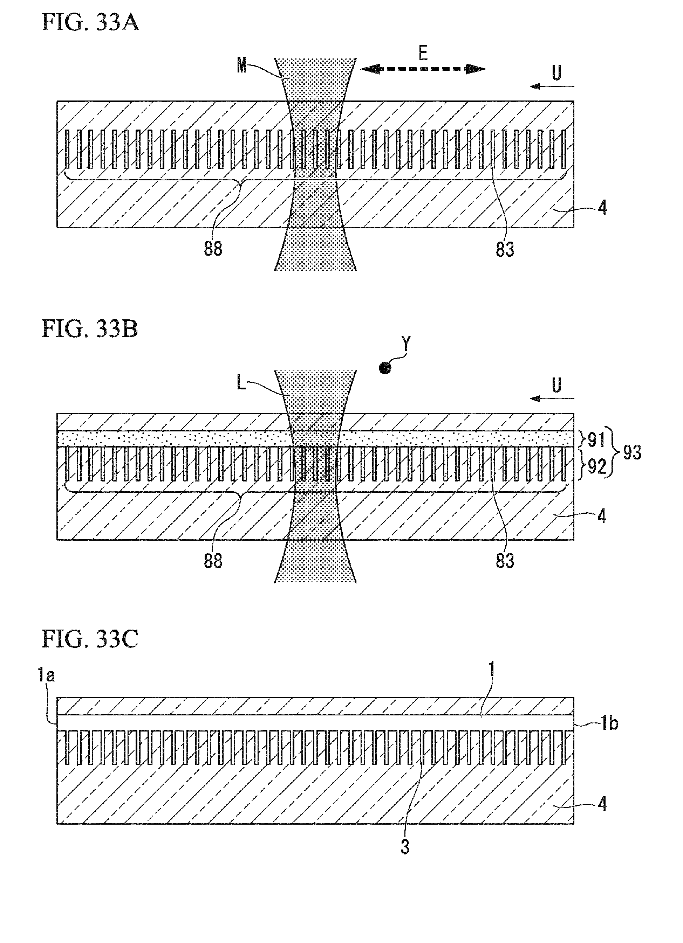

FIG. 33A is a schematic cross-sectional view showing an example of a method of manufacturing a base body having a microscopic hole related to the invention.
FIG. 33B is a schematic cross-sectional view showing an example of a method of manufacturing a base body having a microscopic hole related to the invention.
FIG. 33C is a schematic cross-sectional view showing an example of a method of manufacturing a base body having a microscopic hole related to the invention.

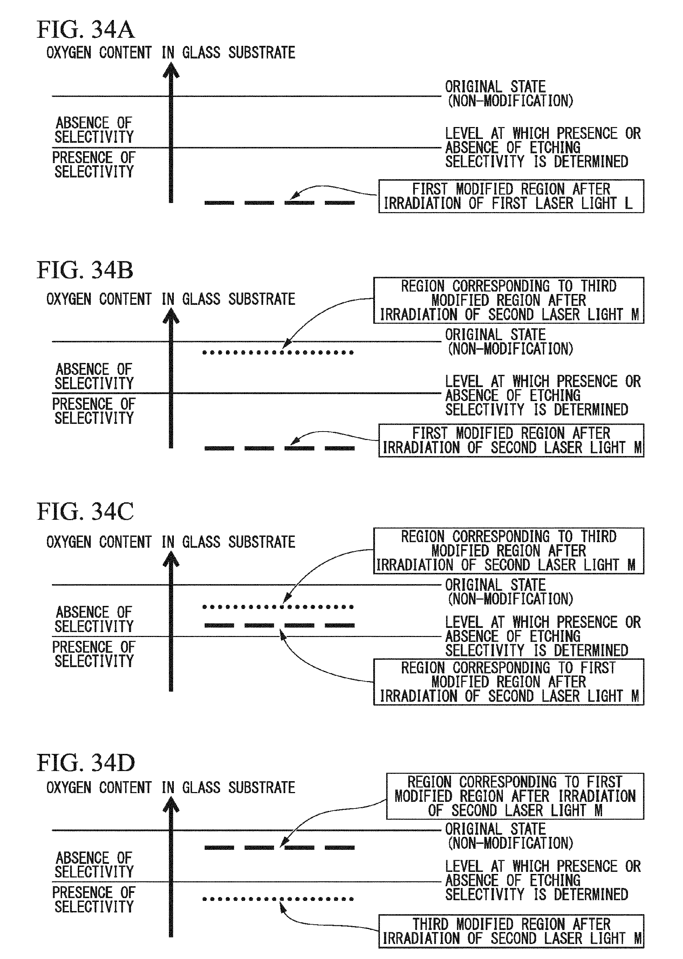

FIG. 34A is a conceptual diagram illustrating an overwriting mechanism by laser irradiation in a modified region.
FIG. 34B is a conceptual diagram illustrating an overwriting mechanism by laser irradiation in a modified region.
FIG. 34C is a conceptual diagram illustrating an overwriting mechanism by laser irradiation in a modified region.
FIG. 34D is a conceptual diagram illustrating an overwriting mechanism by laser irradiation in a modified region.

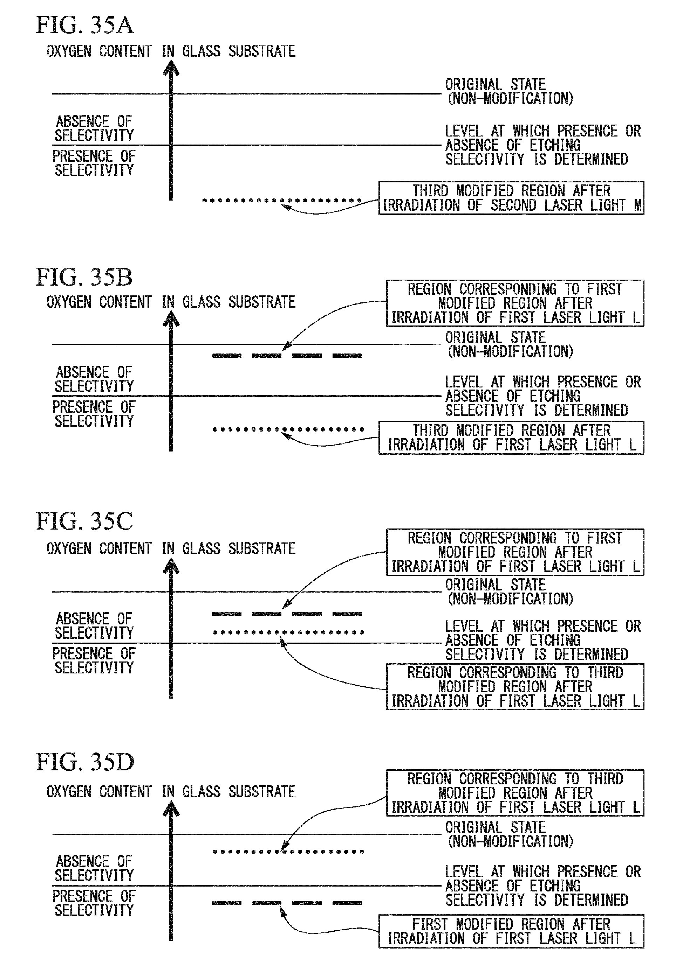

FIG. 35A is a conceptual diagram illustrating an overwriting mechanism by laser irradiation in a modified region.
FIG. 35B is a conceptual diagram illustrating an overwriting mechanism by laser irradiation in a modified region.
FIG. 35C is a conceptual diagram illustrating an overwriting mechanism by laser irradiation in a modified region.
FIG. 35D is a conceptual diagram illustrating an overwriting mechanism by laser irradiation in a modified region.

### EMBODIMENTS FOR CARRYING OUT THE INVENTION

Hereinafter, the invention will be described based on preferred embodiments with reference to drawings.

### Base Body Having Microscopic Hole

### Base Body 10A

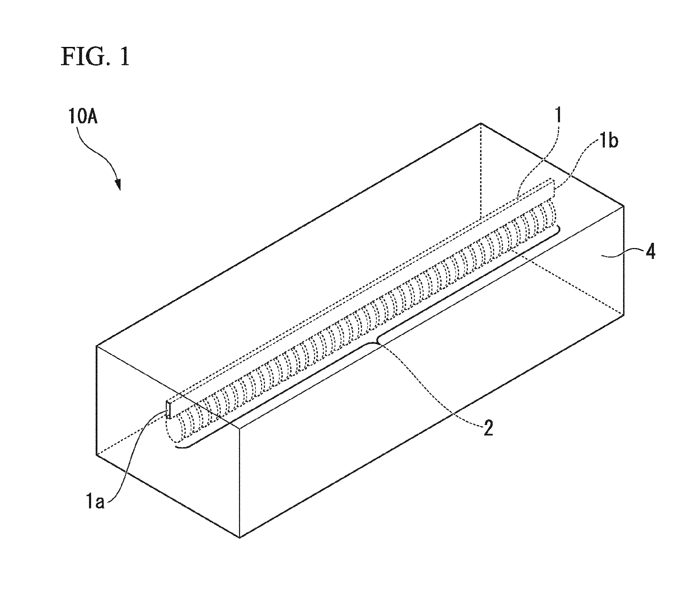

FIG. 1 is a perspective view showing a base body 10A which is an example of a base body having a microscopic hole related to the invention (hereinbelow, simply referred to as "base body").

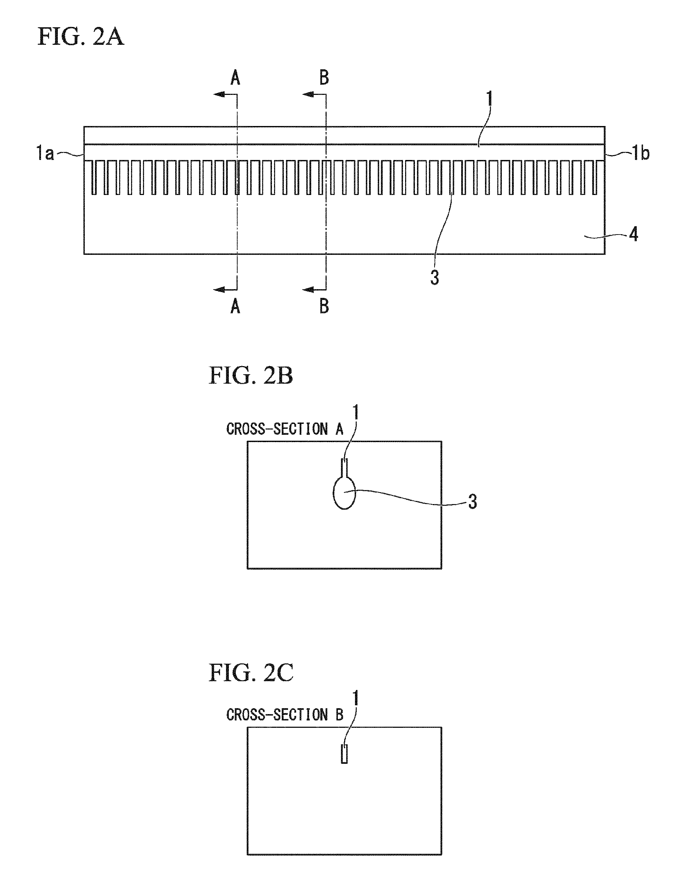

FIG. 2A is a schematic view showing a cross-section along a microscopic hole 1 shown in FIG. 1 (a vertical cross-sectional face of the microscopic hole 1).
FIG. 2B is a schematic cross-sectional view taken along the line A-A shown in FIG. 2A.
FIG. 2C is a schematic cross-sectional view taken along the line B-B shown in FIG. 2A.
FIG. 3 is an enlarged schematic view showing a recessed portion 3 shown in FIG. 2A.

In the base body 10A, the microscopic hole 1 is formed inside a base member 4 forming the base body 10A, and a microscopic periodic structure 2 is formed in the longitudinal direction of the microscopic hole 1 (direction from a first end portion 1 a of the microscopic hole 1 to a second end portion 1 b).
A plurality of microscopic-recessed portions 3, each of which has an opening portion 3a opening at an inner wall of the microscopic hole 1, are provided in a row in the periodic structure 2.

As shown in FIGS. 2B and 2C, a cross section A showing a horizontal cross section of the microscopic hole 1 shows a configuration similar to a key hole shape.
On the other hand, in a cross section B, the microscopic hole 1 is substantially rectangular in shape.
As a configuration of an opening portion of the microscopic hole 1 (first end portion 1 a or second end portion 1 b) opening at the surface of the base member 4, a key hole shape or substantially rectangular in shape may be adopted.
A configuration of the opening portion of the microscopic hole 1 may be selected depending on the intended use of the base body 10A.

In the case where a configuration of the opening portion of the microscopic hole 1 is substantially rectangular in shape, for example, the length of the long side is preferably 0.02 to 100 µm, is more preferably 0.02 to 20 µm, is furthermore preferably 0.02 to 10 µm, and is particularly preferably 0.02 to 5 µm.In addition, the length of the short side is preferably 0.01 µm (10 nm) to 1 µm, is more preferably 0.01 to 0.6 µm, and is furthermore preferably 0.01 to 0.35 µm.
In the case where a configuration of the opening portion of the microscopic hole 1 in a cross-sectional view is a key hole shape, the size of a rectangular part of the key hole shape may be the same as that of the above-exemplified rectangular part.
Regarding the size of a substantially ellipsoid portion of the key hole shape, the minor axis is, for example, preferably 0.05 to 50 µm, is more preferably 0.05 to 5 µm, and is furthermore preferably 0.05 to 3 µm. In addition, the major axis is preferably 0.1 to 100 µm, is more preferably 0.1 to 20 µm, is furthermore preferably 0.1 to 10 µm, and is particularly preferably 0.1 to 5 µm.
Such sizes may be selected depending on the intended use of the base body 10A.

Distances R1 and R2 between the recessed portions 3 forming the periodic structure 2 is preferably in the range of 0.05 to 1.2 µm and is more preferably in the range of 0.05 to 0.7 µm (FIG. 3).
The distances R (R1 and R2) are not necessarily the same.
As long as each distance R is in the aforementioned range, the distances R may be the same as or different from each other.
In the case of adopting the distance satisfying the above-described range, it is possible to periodically form the recessed portions 3 with a high level of density in the longitudinal direction of the microscopic hole 1 by the distance which is substantially the same as the minor axis in the diameter of the microscopic hole 1.
The reason is that, the minor axis in the diameter of the microscopic hole 1 is preferably 0.01 pm (10 nm) to 1 µm.
Additionally, when the distance R is on the order of submicrons (up to 1 pm), the microscopic hole 1 in which the periodic structure 2 is formed can be used as a molecular sieve.
If the distance is less than the aforementioned lower limit (i.e., 0.01 µm), in the case of, for example, suctioning fluid into the microscopic hole 1, there is a concern that sidewalls of the recessed portions 3 are broken and destroyed due to flow momentum of the fluid.
Moreover, there is a concern that the recessed portions 3 adjacent to each other are merged by etching in manufacturing.
Practically, it is difficult to manufacture the periodic structure 2 with a high level of yield so that a distance R becomes less than the aforementioned range.

Here, "a distance R between the recessed portions 3" corresponds to a recurrence cycle made of a recessed region and a non-recessed region as shown in FIG. 3 illustrating the longitudinal direction of the microscopic hole 1.

A depth D of the recessed portion 3 is preferably 0.1 to 100 µm, is more preferably 0.1 to 20 µm, is furthermore preferably 0.1 to 10 µm, and is particularly preferably 0.1 to 5 µm.
Furthermore, in the longitudinal direction of the microscopic hole 1, the width W1 of the recessed portion 3 is preferably 0.01 to 1 µm, is more preferably 0.01 to 0.6 µm, and is furthermore preferably 0.01 to 0.35 µm.
In addition, the width W2 of the recessed portion 3 in the direction perpendicular to the longitudinal direction of the microscopic hole 1 (direction perpendicular to W1) (vertical direction with respect to the paperface) is preferably 0.05 to 50 µm, is more preferably 0.05 to 5 µm, and is furthermore preferably 0.05 to 3 µm.
Configurations of the recessed portions 3 forming the periodic structure 2 may be the same as or different from each other.

Regarding the recessed portion 3, a ratio thereof of a depth D divided by a width W1 (aspect ratio) is preferably in the range of 0.5 to 500, is more preferably in the range of 0.8 to 200, and furthermore preferably in the range of 0.8 to 100.
If the aspect ratio is greater than the upper limit of the range (i.e., 500), in the case of, for example, suctioning fluid into the microscopic hole 1, there is a concern that sidewalls of the recessed portions 3 are broken and destroyed due to flow momentum of the fluid.
Moreover, there is a concern that the recessed portions 3 adjacent to each other are merged by etching in manufacturing.
Practically, it is difficult to manufacture the recessed portions 3 with a high level of yield so that the aspect ratio exceeds the aforementioned range.

As a material used to form the base member 4, a material allowing light having at least part of wavelengths of 0.1 to 10 µm to transmit therethrough is preferably used.
Specifically, the material preferably allows at least part of a laser used for processing having a general wavelength (0.1 to 10 µm) used for forming the microscopic hole 1 and the periodic structure 2 to transmit through the material.
By using a material allowing a laser light to transmit therethrough, it is possible to form a modified region inside the base member 4 by laser irradiation as described hereinbelow.
More specifically, for example, glass which is an amorphous material, silicon which is a crystalline material, silica, sapphire, or the like is adopted.
Among them, an amorphous material is preferably used because the material is less easily affected by anisotropy of processing due to crystal orientation.
In the case such material is used, processing accuracy of the microscopic hole 1 can be further improved, and it is possible to form the hole diameter of the opening portion of the microscopic hole 1 on the order of nanometers.

### Base Body 10B

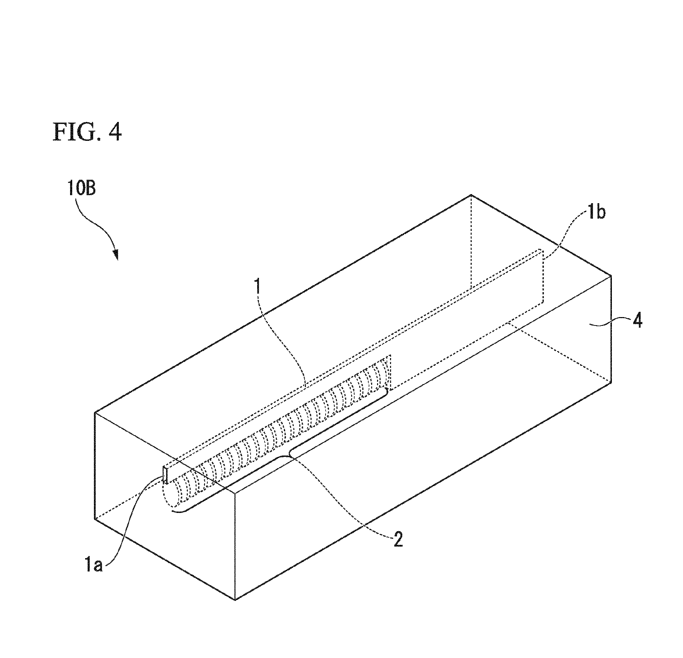

FIG. 4 is a perspective view showing an example of a base body 10B related to the invention having a microscopic hole.

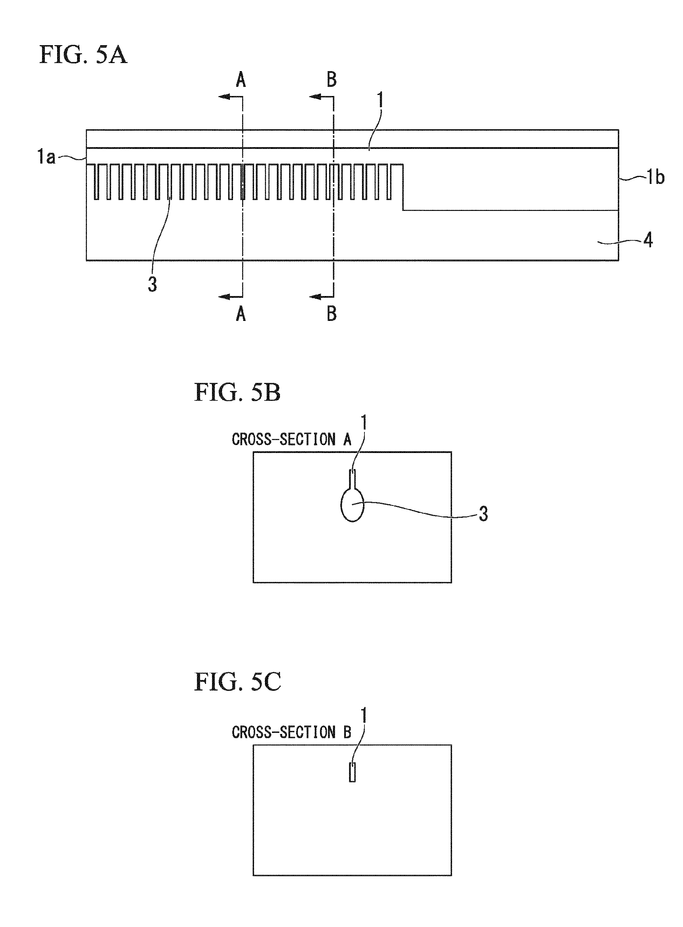

FIG. 5A is a schematic view showing a cross section (vertical cross-sectional face of the microscopic hole 1) along the microscopic hole 1 shown in FIG. 4.
FIG. 5B is a schematic cross-sectional view taken along the line A-A shown in FIG. 5A.
FIG. 5C is a schematic cross-sectional view taken along the line B-B shown in FIG. 5A.
In each drawing, identical symbols are used for the configurations which are identical to those of the base body 10A.

In a base body 10B, the opening portion (second opening portion 1 b) of the second end portion 1 b of the microscopic hole 1 is greater than the first end portion 1 a of the opening portion of the microscopic hole 1 (first opening portion 1 a).
In the case where a configuration of the opening portion 1 b of the second end portion is substantially rectangular in shape, for example, the length of the long side is preferably 0.02 to 100 µm, is more preferably 0.02 to 40 µm, is furthermore preferably 0.02 to 20 µm, and is particularly preferably 0.02 to 10 µm.In addition, the length of the short side is preferably 0.01 µm (10 nm) to 1 µm, is more preferably 0.01 to 0.6 µm, and is furthermore preferably 0.01 to 0.35 µm.
Moreover, to near the center of the microscopic hole 1 from the first end portion 1 a of the microscopic hole 1, the periodic structure 2 is formed.

### Base Body 10C

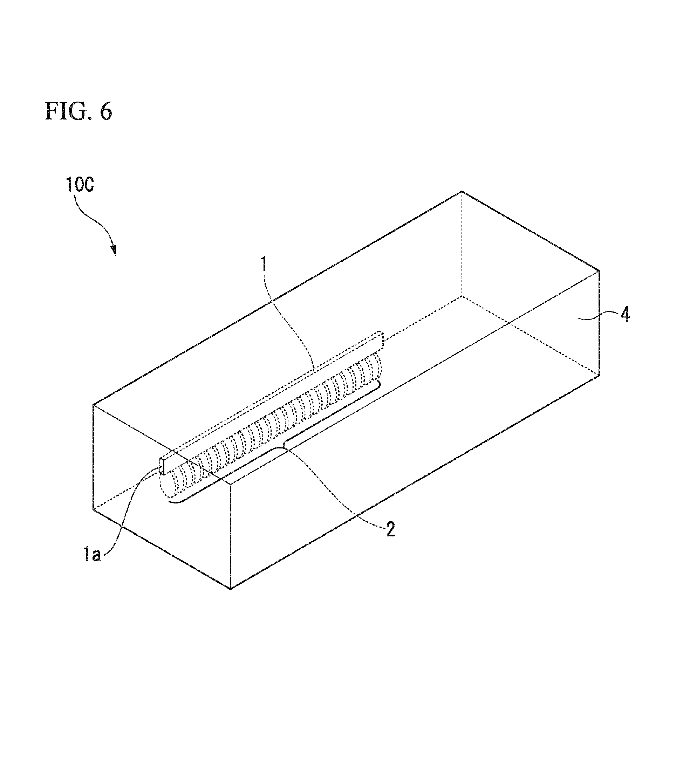

FIG. 6 is a perspective view showing an example of a base body 10C related to the invention having a microscopic hole.

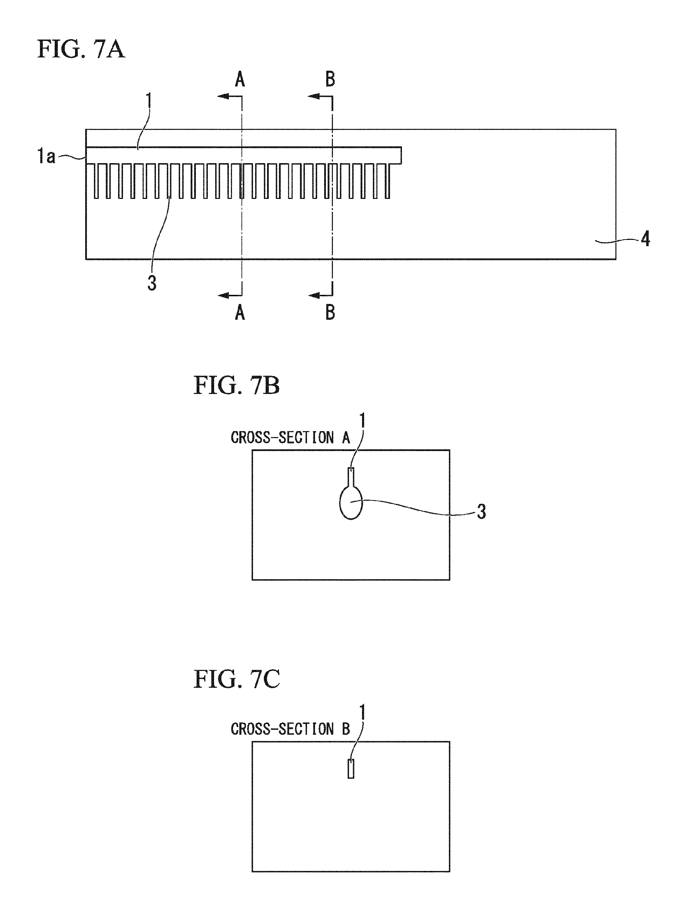

FIG. 7A is a schematic view showing a cross section (vertical cross-sectional face of the microscopic hole 1) along the microscopic hole 1 shown in FIG. 6.
FIG. 7B is a schematic cross-sectional view taken along the line A-A shown in FIG. 7A.
FIG. 7C is a schematic cross-sectional view taken along the line B-B shown in FIG. 7A.
In each drawing, identical symbols are used for the configurations which are identical to those of the base body 10A.

In the base body 10C, the microscopic hole 1 has only a first opening portion 1 a and does not have a second opening portion 1 b.
Particularly, the microscopic hole 1 in the base body 10C is not a through hole and is a hole formed by digging the base member 4.
In the base body of the invention, the microscopic hole 1 may penetrate through the base member 4 such as the base body 10A, and the microscopic hole 1 may not penetrate through the base member 4 such as the base body 10C.

### Base Body 10D

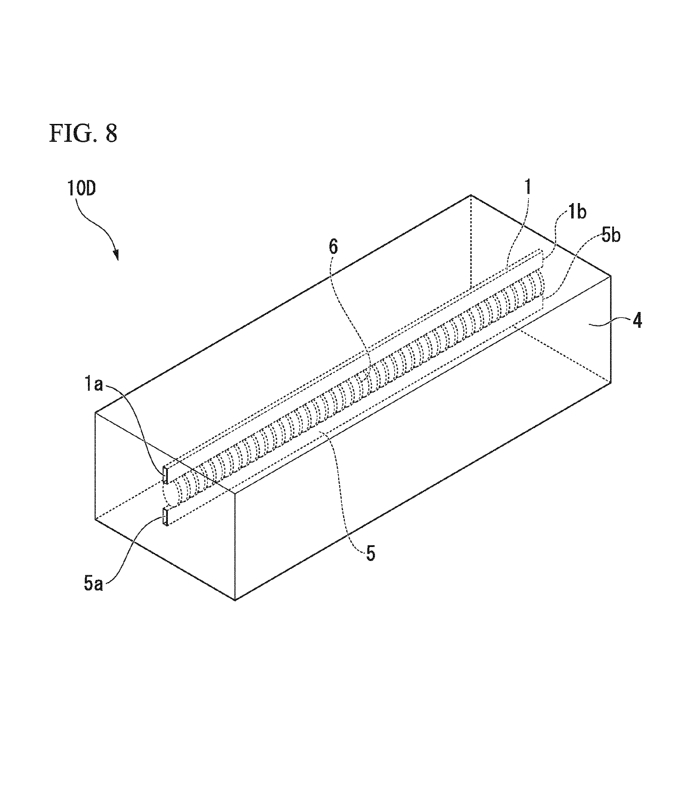

FIG. 8 is a perspective view showing an example of a base body 10D related to the invention having a microscopic hole.

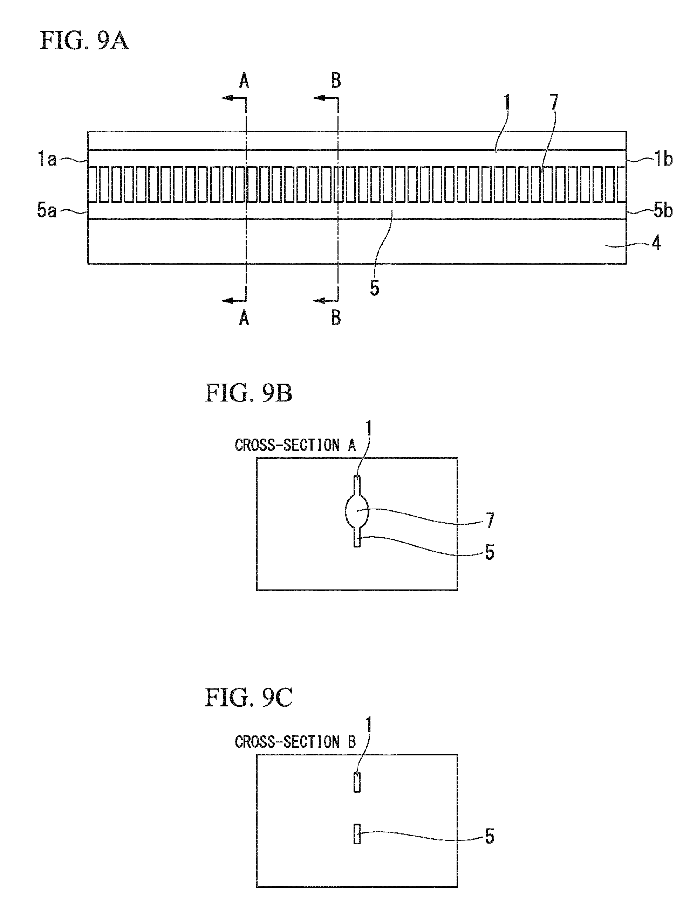

FIG. 9A is a schematic view showing a cross section (vertical cross-sectional face of the microscopic holes 1 and 5) along the microscopic holes 1 and 5 shown in FIG. 8.
FIG. 9B is a schematic cross-sectional view taken along the line A-A shown in FIG. 9A.
FIG. 9C is a schematic cross-sectional view taken along the line B-B shown in FIG. 9A.
In each drawing, identical symbols are used for the configurations which are identical to those of the base body 10A.

In the base body 10D, two microscopic holes 1 and 5 are arranged parallel to each other inside the base member 4.
At the side faces of the base member 4, the microscopic holes 1 and 5 have first opening portions 1 a and 5a and second opening portions 1b and 5b, respectively.
The configuration and the hole diameter of the second microscopic hole 5 may be the same as or different from the configuration and the hole diameter of the first microscopic hole 1.
The microscopic periodic structure 6 is formed in the longitudinal direction of the first microscopic hole 1 and the second microscopic hole 5.
A plurality of microscopic through holes 7, which connect (communicate) the first microscopic hole 1 to the second microscopic hole 5, are arrayed in a row in the periodic structure 6.

As shown in FIGS. 9A, 9B, and 9C, a cross section A showing a horizontal cross section of the microscopic holes 1 and 5 shows a configuration similar to a key hole shape.
On the other hand, in a cross section B, each of the microscopic holes 1 and 5 is substantially rectangular in shape.
As configurations of opening portions of the microscopic holes 1 and 5 opening at the surface of the base member 4, a key hole shape or substantially rectangular in shape may be adopted.
A configuration of the opening portion may be selected depending on the intended use of the base body.

In the case where a configuration of the opening portion is substantially rectangular in shape, for example, the length of the long side is preferably 0.02 to 100 µm, is more preferably 0.02 to 20 µm, is furthermore preferably 0.02 to 10 µm, and is particularly preferably 0.02 to 5 µm. In addition, the length of the short side is preferably 0.01 µm (10 nm) to 1 µm, is more preferably 0.01 to 0.6 µm, and is furthermore preferably 0.01 to 0.35 µm.
In the case where a configuration of the opening portion in a cross-sectional view is a key hole shape, the rectangular part having the key hole shape can be formed to have the size which is the same as the size illustrated in the cross-sectional configuration of the above-described substantially rectangular in shape.
The size of a substantially ellipsoid portion of the key hole shape is as follows.
The minor axis is, for example, preferably 0.05 to 50 µm, is more preferably 0.05 to 5 µm, and is furthermore preferably 0.05 to 3 µm.In addition, the major axis is preferably 0.1 to 100 µm, is more preferably 0.1 to 20 µm, is furthermore preferably 0.1 to 10 µm, and is particularly preferably 0.1 to 5 µm.
Such sizes may be selected depending on the intended use of the base body 10A.

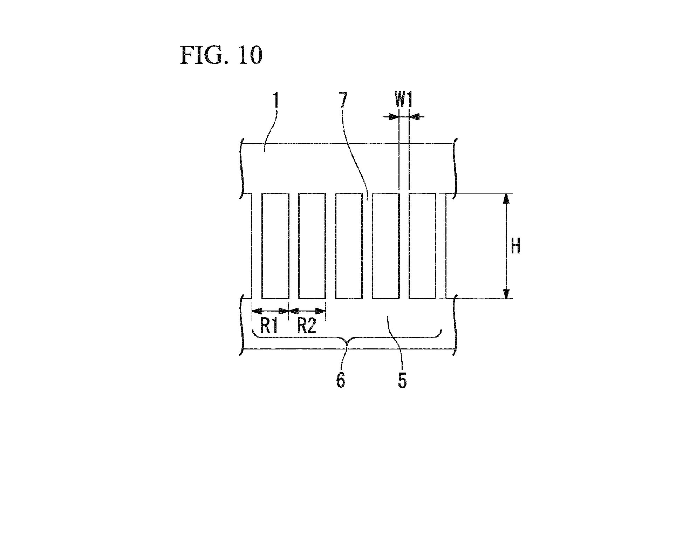

Distances (separation distance) R1 and R2 between the microscopic through holes 7 forming the periodic structure 6 is preferably in the range of 0.05 to 1.2 µm and is more preferably in the range of 0.05 to 0.7 µm (FIG. 10).
The distances R (R1 and R2) are not necessarily the same. As long as the distance is in the aforementioned range, the distance may be the same as or different from each other.
In the case of adopting the distance satisfying the above-described range, it is possible to arrange the periodically-formed microscopic through holes 7 with a high level of density in the longitudinal direction of the microscopic holes 1 and 5 by the distance which is substantially the same as the minor axis in the diameter of the microscopic holes 1 and 5.
The reason is that, the minor axes in the diameter of the microscopic holes 1 and 5 are preferably 0.01 to 1 µm.
Additionally, when the distance R is on the order of submicrons (up to 1 pm), the microscopic hole 1 in which the periodic structure 6 is formed can be used as a molecular sieve.
If the distance is less than the aforementioned lower limit (i.e., 0.01 µm), in the case of, for example, suctioning fluid into the microscopic holes 1 and 5, there is a concern that sidewalls of the microscopic through holes 7 are broken and destroyed due to flow momentum of the fluid.
Moreover, there is a concern that the microscopic through holes 7 adjacent to each other are merged by etching in manufacturing.
Practically, it is difficult to manufacture the periodic structure 6 with a high level of yield so that a pitch R becomes less than the aforementioned range.

Here, "a distance R between the microscopic through holes 7" corresponds to a recurrence cycle made of a microscopic-through-hole region and a non-microscopic-through-hole region as shown in FIG. 10 illustrating the longitudinal direction of the microscopic holes 1 and 5.

The distance between the first microscopic hole 1 and the second microscopic hole 5, that is, the length H of the microscopic through hole 7 is preferably 0.1 to 100 µm, is more preferably 0.1 to 20 µm, is furthermore preferably 0.1 to 10 µm, and is particularly preferably 0.1 to 5µm.
Furthermore, in the longitudinal direction of the microscopic holes 1 and 5, the width W1 of the microscopic through hole 7 is preferably 0.01 to 1 µm, is more preferably 0.01 to 0.6 µm, and is furthermore preferably 0.01 to 0.35 µm.
In addition, the width W2 of the microscopic through hole 7 in the direction perpendicular to the longitudinal direction of the microscopic hole 1 (direction perpendicular to W1) (vertical direction with respect to the paperface) is preferably 0.05 to 50 µm, is more preferably 0.05 to 5 µm, and is furthermore preferably 0.05 to 3 µm.
Configurations of the microscopic through holes 7 forming the periodic structure 6 may be the same as or different from each other.

Regarding the microscopic through hole 7, a ratio thereof of a length H divided by a width W1 (aspect ratio) is preferably in the range of 0.5 to 500, is more preferably in the range of 0.8 to 200, and furthermore preferably in the range of 0.8 to 100.
If the aspect ratio is greater than the upper limit of the range (i.e., 500), in the case of, for example, suctioning fluid into the microscopic hole 1, there is a concern that sidewalls of the microscopic through holes 7 are broken and destroyed due to flow momentum of the fluid.
Moreover, there is a concern that the microscopic through holes 7 adjacent to each other are merged by etching in manufacturing.
Practically, it is difficult to manufacture the microscopic through holes 7 with a high level of yield so that the aspect ratio exceeds the aforementioned range.

### Base Body 10E

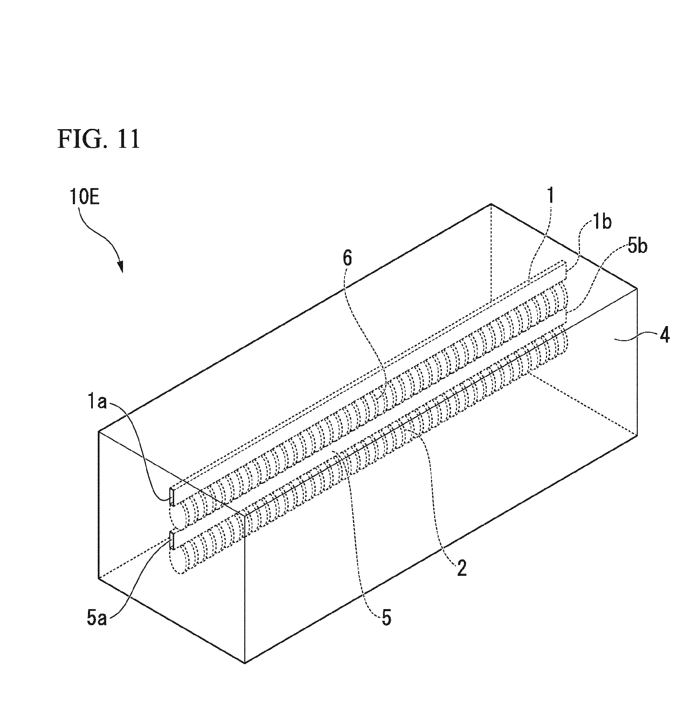

FIG. 11 is a perspective view showing an example of a base body 10E related to the invention having a microscopic hole.

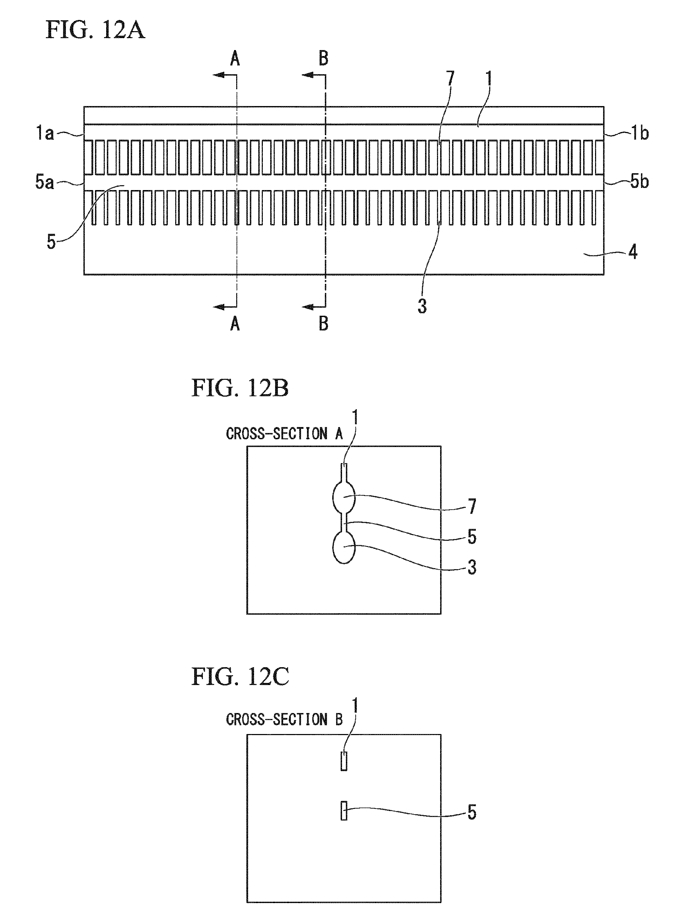

FIG. 12A is a schematic view showing a cross section (vertical cross-sectional face of the microscopic holes 1 and 5) along the microscopic holes 1 and 5 shown in FIG. 11.
FIG. 12B is a schematic cross-sectional view taken along the line A-A shown in FIG. 12A.
FIG. 12C is a schematic cross-sectional view taken along the line B-B shown in FIG. 12A.
In each drawing, identical symbols are used for the configurations which are identical to those of the base bodies 10A and 10D.

A microscopic the periodic structure 2 is formed in the longitudinal direction of the second microscopic hole 5 in the base body 10E in addition to the configuration of the microscopic hole 10D.
A plurality of microscopic-recessed portions 3, each of which has an opening portion opening at an inner wall of the second microscopic hole 5, are provided in a row in the periodic structure 2.
The explanation of the recessed portion 3 and the periodic structure 2 is the same as the explanation of the recessed portion 3 and the periodic structure 2 of the base body 10A.
The cross section A and the cross section B shown in FIGS. 12A, 12B, and 12C are schematic views, and the recessed portion 3 and the microscopic through hole 7 do not necessarily appear on the cross section A.
The recessed portion 3 and the microscopic through hole 7 may be disposed so as to be slightly displaced from each other in the longitudinal direction of the second microscopic hole 5.

### Base Body 10F

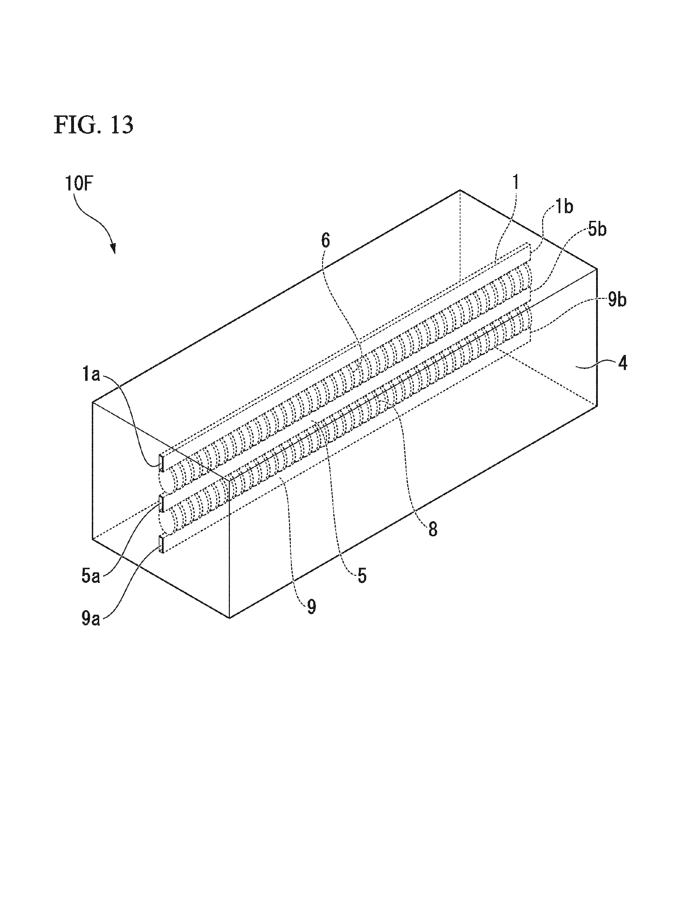

FIG. 13 is a perspective view showing an example of a base body 10F related to the invention having a microscopic hole.

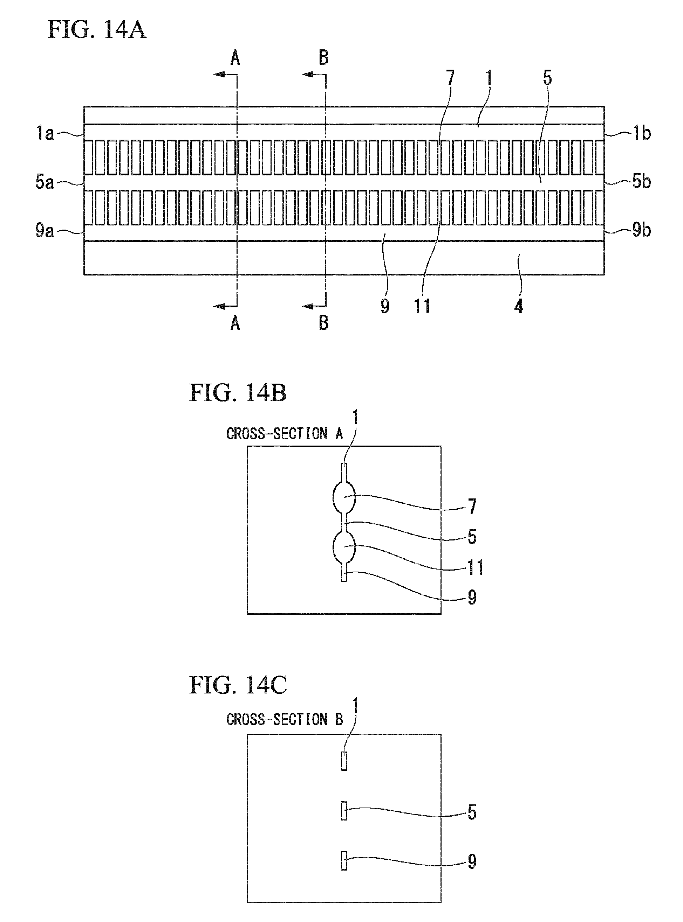

FIG. 14A is a schematic view showing a cross section (vertical cross-sectional face of the microscopic holes 1, 5, and 9) along the microscopic holes 1, 5, and 9 shown in FIG. 13.
FIG. 14B is a schematic cross-sectional view taken along the line A-A shown in FIG. 14A.
FIG. 14C is a schematic cross-sectional view taken along the line B-B shown in FIG. 14A.
In each drawing, identical symbols are used for the configurations which are identical to those of the base body 10E.

A third microscopic hole 9 and a second periodic structure 8 are formed in the base body 10F in addition to the configuration of the microscopic hole 10E.
The third microscopic hole 9 is arranged parallel to the first microscopic hole 1 and the second microscopic hole 5 inside the base member 4.
At the side faces of the base member 4, the third microscopic hole 9 has a first opening portion 9a and a second opening portion 9b.
The configuration and the hole diameter of the third microscopic hole 9 may be the same as or different from the configuration and the hole diameter of the first microscopic hole 1 or the second microscopic hole 5.

The second periodic structure 8 is formed in the longitudinal direction of the second microscopic hole 5 and the third microscopic hole 9.
A plurality of microscopic through holes 11, which connect (communicate) the second microscopic hole 5 to the third microscopic hole 9, are arrayed in a row in the second periodic structure 8.
The explanation of the microscopic through holes 11 and the second periodic structure 8 is the same as the explanation of the microscopic through holes 7 and the periodic structure 6 (first periodic structure 6) which connect the first microscopic hole 1 to the second microscopic hole 5.

### Base Body 10G

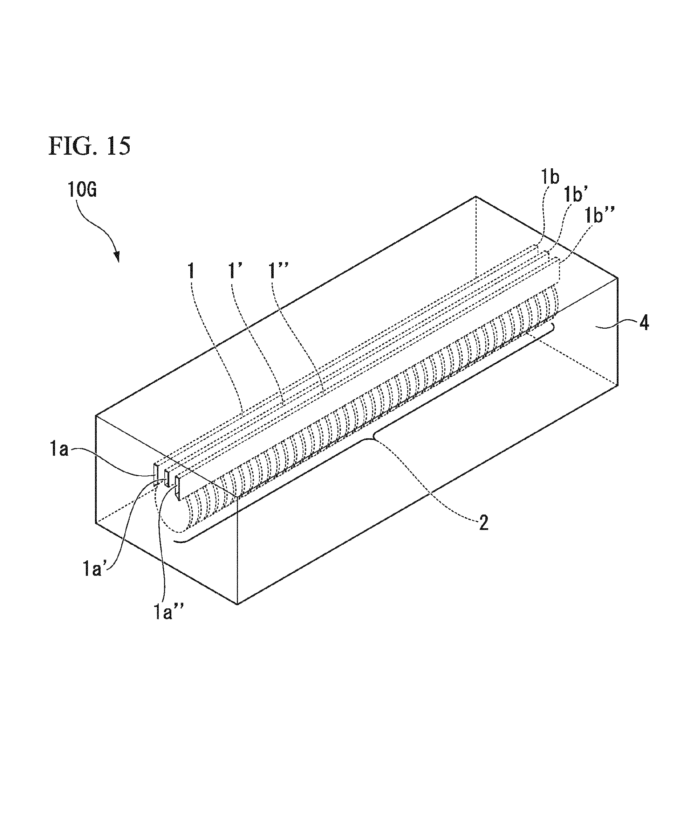

FIG. 15 is a perspective view showing an example of a base body 10G related to the invention having a microscopic hole.

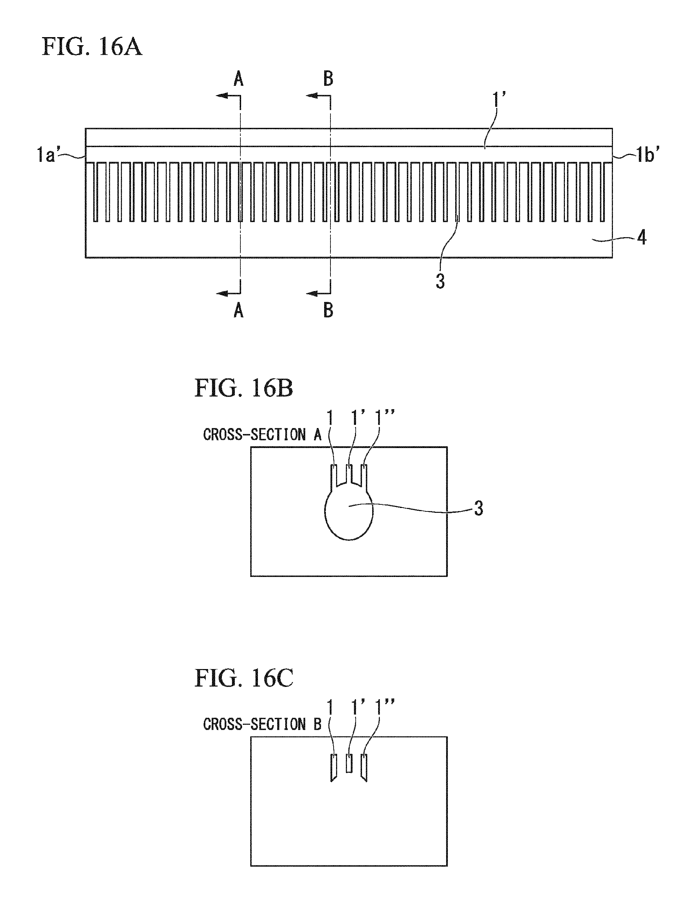

FIG. 16A is a schematic view showing a cross section (vertical cross-sectional face of the microscopic hole 1) along the microscopic holes 1, 1', and 1" shown in FIG. 15.
FIG. 16B is a schematic cross-sectional view taken along the line A-A shown in FIG. 16A.
FIG. 16C is a schematic cross-sectional view taken along the line B-B shown in FIG. 16A.
In each drawing, identical symbols are used for the configurations which are identical to those of the base body 10A.

In the base body 10G, the first microscopic hole 1, the second microscopic hole 1', and the third microscopic hole 1" are formed inside the base member 4 configuring the base body 10G.
The microscopic holes 1, 1', and 1" are arranged parallel to each other on a planar direction of the base member 4.
At the side faces of the base member 4, microscopic holes 1, 1', and 1" have first opening portions 1 a, 1a', and 1 a" and second opening portions 1 b, 1 b', and 1 b", respectively.
The configuration and the hole diameter of microscopic holes 1, 1', and 1" may be the same as or different from each other.
The explanation of the configuration and the hole diameter of the microscopic holes 1, 1', and 1" is the same as the explanation of the microscopic hole 1 of the base body 10A.

The distance between the first microscopic hole 1 and the second microscopic hole 1' and the distance between the second microscopic hole 1' and the third microscopic hole 1" are preferably in the range of 0.05 to 1.2 µm and is more preferably in the range of 0.05 to 0.7 µm.

The periodic structure 2 is formed in the longitudinal direction of the microscopic holes 1, 1', and 1".
A plurality of microscopic-recessed portions 3, each of which has an opening portion opening at an inner wall of the microscopic holes 1, 1', and 1 ", are provided in a row in the periodic structure 2.
One recessed portion 3 has three opening portions open at the inner walls of the microscopic holes 1, 1', and 1 ", respectively.
The explanation of the recessed portion 3 and the periodic structure 2 is the same as the explanation of the recessed portion 3 and the periodic structure 2 of the above-described base body 10A.

As stated above, a plurality of microscopic holes are arranged parallel to each other along the planar direction of the base body (substrate) inside the base body related to the invention. Furthermore, the microscopic periodic structure may be formed in the longitudinal direction of the microscopic holes.
The microscopic hole having the configuration can be applicable to the aforementioned base bodies 10A to 10F.
Particularly, in the base bodies 10D to 10F, a plurality of microscopic holes are arrayed in the thickness direction (direction vertical to the surface of the substrate) of the base body (substrate) and arranged parallel to each other inside the base body. Furthermore, the microscopic periodic structure is formed in the longitudinal direction of the microscopic holes.
The longitudinal direction of the microscopic holes which are arrayed inside the aforementioned base bodies 10A to 10F is the planar direction of the base body (substrate).

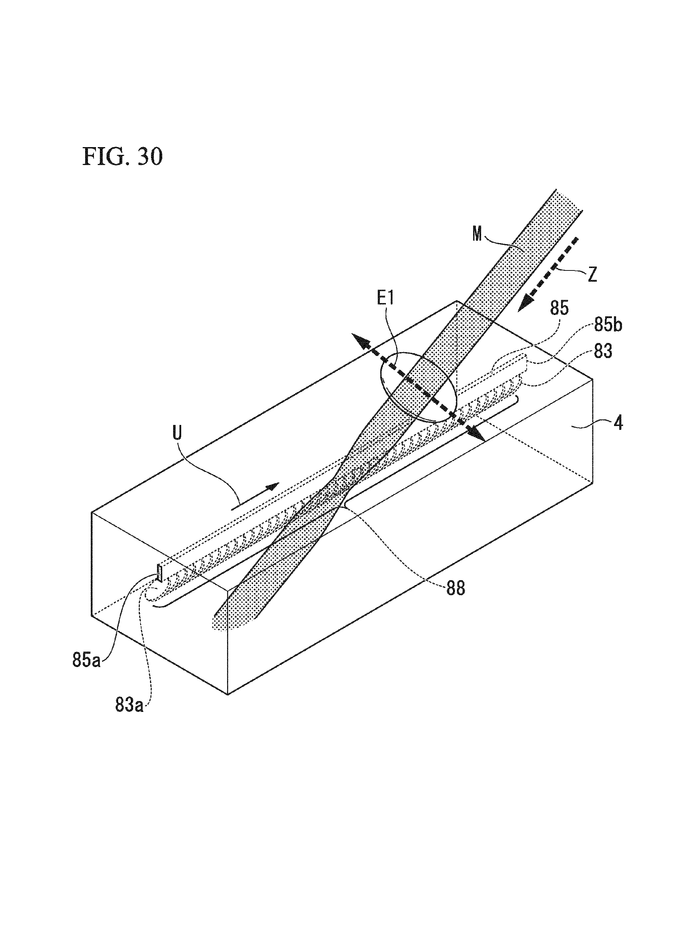

In the base bodies 10A to 10G related to the invention having the microscopic hole as described above, the recessed portion or the microscopic through hole which constitutes the periodic structure is formed so as to perpendicularly intersect with the longitudinal direction of the microscopic hole.
However, the base body related to the invention is not limited to the aforementioned examples, and the recessed portion or the microscopic through hole which constitutes the periodic structure may be arranged so as to obliquely intersect with the longitudinal direction of the microscopic hole at an angle (FIG. 30).

### Example Of Use Of Base Body Having Microscopic Hole

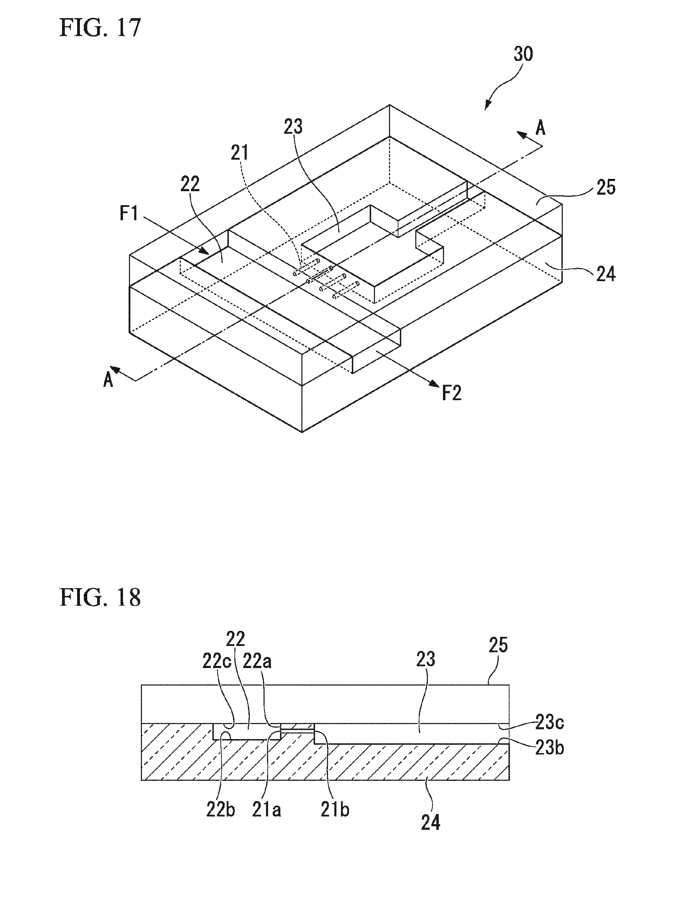

FIG. 17 is a perspective view showing the base body related to the invention 30.

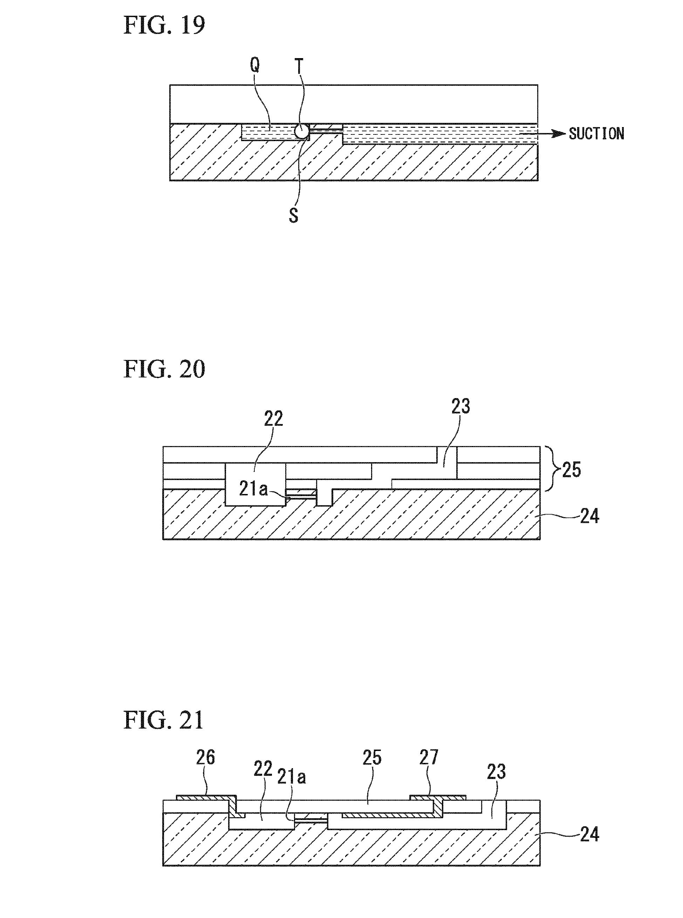

FIGS. 18 and 19 are schematic views showing a cross-sectional face taken along the line A-A shown in FIG. 17.

In the base body 30, the microscopic hole and the periodic structure which are illustrated using the aforementioned the base bodies 10A to 10G (excluding the base body 10C) are formed inside the base member 24.
The base body 30 can be applied to, for example, the intended use of capturing a particle T.
The base body 30 is provided with at least a first flow passage 22 allowing the fluid Q including the particles T to flow thereinto and constituting a space present in the base member 24, a second flow passage 23 capable of reducing the pressure inside thereof, and a microscopic hole 21 coupling (communicating) the first flow passage 22 to the second flow passage 23.
The above-described periodic structure is formed in the longitudinal direction in the microscopic holes 21.
However, the periodic structure is omitted and is not drawn in FIGS. 17 to 21.

The microscopic holes 21 are connected to outside the base member 24 through the second flow passage 23.
An opening portion (suction portion S), at which a first end portion 21 a of the microscopic hole 21 opens, is formed at the side face 22a of the first flow passage 22.
At least part of an upper face 22c of the first flow passage 22 or at least part of the lower face 22b thereof is constituted of a transparent member 25 so that the particle T which is trapped by the suction portion S can be optically observed.
Portion forming at least the microscopic hole 21 in the base member 24 is constituted of a single member.

In the base body 30, the base member 24 in which the microscopic holes 21 are formed is formed of a single member.
As the single member, for example, silicon, glass, silica, sapphire, or the like is adopted.
Such materials is excellent in workability of the microscopic holes 21, and is therefore preferable.
Among them, amorphous is preferable which is less easily susceptible to anisotropy of processing due to crystal orientation.
In order to observe the trapped particle by use of an optical device such as a microscope, it is preferable that glass, silica, or sapphire, which allow visible light beams (wavelength of the beam is in the range of 0.36 to 0.83 µm) to transmit therethrough, be used as the above-described material.

In addition, a material used to form the single member preferably allows light having at least part of wavelengths of 0.1 to 10 µm (material is transparent with respect to light having at least part of wavelengths) to transmit therethrough.
Specifically, it is preferable that the material transmit light in at least part of general wavelength regions (0.1 to 10 µm) used for a laser light used for processing.
Due to transmission of such laser light through the material, it is possible to form the modified region by irradiating the member with a laser as described later.
Furthermore, a material allowing light of a visible light region (approximately 0.36 to 0.83 µm) to transmit therethrough is more preferable.
It is possible to easily observe the captured particle T through the single member by use of an optical observation device by use of the material allowing the light in a visible light region to transmit therethrough.
Particularly, "transparent" of the invention means all states where light is incident to the member and a transmissive light is obtained from the member.
In FIG. 17, the single member configuring the base member 24 is a transparent glass substrate.

The fluid Q is liquid or gas and is, for example, blood, cell culture medium, liquid for beverage use, river water, or the like.
Furthermore, air is also included in the fluid Q.
The particles T which is captured by the base body 30 are not particularly limited as long as the particles can be included in the fluid Q, and particles which can flow in the flow passage is preferable.
For example, microorganisms, cells, particles configured by an organic material, particles configured by an inorganic material, or the like is adopted.
As the microorganisms, bacteria, mycete, fungus, large-scale virus, or the like are exemplary examples.
As the cells, cells which can be floating-cultivated such as erythrocyte, leucocyte, or the like are exemplary examples.
As the particles configured by an organic material, particles configured by a high-polymer molecule such as resins, polysaccharides, or the like, activated carbon particles, or the like are exemplary examples.
As the particles configured by an inorganic material, metal particles such as silica particles, gold colloid particles, or the like are exemplary examples.
The particles configured by the organic material and the particles configured by the inorganic material may be functional particles whose surface or inside is coupled to an antibody molecule or the like.
The configuration of the particle configured by the organic material and the configuration of the particle configured by the inorganic material is not particularly limited.
For example, all three-dimensional shape such as sphere, cube, cuboid, polytope, a doughnut-shaped solid, a string-shaped solid, or the like are adopted as the particle.
The size of the particle configured by the organic material and the particle configured by the inorganic material are not particularly limited as long as the particle is larger than the diameter of the opening of the first end portion of the microscopic hole forming the suction portion.
It is necessary that the size of the particle is not sized to pass through the microscopic hole.

As shown in FIGS. 18 and 19, the microscopic hole 21 couples the first flow passage 22 to the second flow passage 23.
The first end portion 21 a (first opening portion 21 a) of the microscopic hole 21 opens at (is exposed to) the side face 22a of the first flow passage 22 and forms the suction portion S.
The second end portion 21 b (second opening portion 21 b) of the microscopic hole 21 opens at (is exposed to) the side face of the second flow passage 23.

The microscopic holes 21 are formed in a single glass substrate 24 and do not have a seam joint or an attached surface.
Obviously, a seam joint or an attached surface is also not present at the suction portion S formed at the first end portion 21 a of the microscopic hole.
Here "the suction portion S" means a region, which is in contact with the particles T at the side face 22a of the first flow passage 22, or a region close to the region.

A hole shape or the size thereof of the first end portion 21 a of the microscopic hole 21 forming the suction portion S at the side face 22a of the first flow passage 22 is the same as the shape or the size of the opening portion (hole diameter) of the microscopic hole of the aforementioned base bodies 10A to 10G.
That is, a shape of the opening portion of the microscopic hole 21 may be any of rectangle, triangle, ellipse, or circle.
If the minor axis (shortest hole diameter) of the opening portion of the microscopic hole 21 is in the range of 0.02 to 5 µm, the particle T such as a microorganism, a cell, or the like can be trapped at the suction portion S.
With respect to a microorganism having the size smaller than that of the cell, the minor axis is preferably in the range of 0.02 to 0.8 µm.
In particular, the minor axis of the opening portion of the microscopic hole 21 may be to the extent that the particle T cannot pass through the microscopic suctioning hole 21.
For example, in the case where an erythrocytic cell (6 to 8 µm) is trapped, it is only necessary for the minor axis to be approximately 1 µm; and in the case where, a bacillus subtilis natto (hay bacillus; 0.7 to 2 µm) is trapped, it is only necessary for the minor axis to be approximately 0.2 µm.

The minor axis is preferably in the range of 0.02 to 2 µm.
If the minor axis is less than the aforementioned lower limit (i.e., 0.02 µm) of the aforementioned range, there is a concern that the suction power of the suction portion S is too weak to trap the particle T.
If the minor axis exceeds the upper limit (i.e., 2 µm) of the aforementioned range, there is a concern that the particle T passes through the microscopic hole 21 and it is impossible to trap the particle.
It is only necessary to appropriately adjust the size of the major axis of the hole (longest hole diameter) depending on the size of the particle T to be trapped, and the major axis is, for example, in the range of 0.2 to 10 µm.

In FIGS. 18 and 19, the microscopic holes 21 are formed substantially perpendicular to the side face 22a of the first flow passage 22, however, it is not necessarily substantially perpendicular thereto, and the microscopic hole 21 can be formed at an optionally-determined angle with respect to the side face 22a in the single glass substrate 24 depending on the design of the base body 30.
The reason that a plurality of microscopic holes 21 can be formed in the base body 30 is described based on the aforementioned base bodies 10A to 10G.
Since each microscopic hole 21 is provided with the suction portion S, a plurality of particles T can be trapped.

The lower face 22b of the first flow passage 22 is formed of the glass substrate 24.
The upper face 22c of the first flow passage 22 facing the lower face 22b is formed of a member 25 such as plastic, glass, or the like.
It is possible to observe the particle T trapped by the suction portion S through at least one of the upper face 22c and the lower face 22b by use of an optical observation device such as a microscope or the like.

The lower face 23b of the second flow passage 23 is formed of the glass substrate 24 and an upper face 23c of the second flow passage 23 is formed of the member 25.
That is, the second flow passage 23 is a semi-sealed space.
The second end portion 21 b of the microscopic hole 21 opens at the upstream side of the second flow passage 23.
A pressure reducing device such as a syringe, a pump, or the like, which is capable of reducing the inner pressure of the second flow passage 23, is provided at the downstream side of the second flow passage 23 (not shown in the figure).
Because of this, part of the fluid Q flowing (flow) from the upstream side F1 of the first flow passage 22 to the downstream side F2 of the first flow passage 22 is drawn into the second flow passage 23 through the microscopic holes 21 due to reduction in the inner pressure of the second flow passage 23.
At this time, the particle T included in the fluid Q is drawn into the suction portion S formed of the first end portion 21 a of the microscopic holes 21 and can be trapped (FIG. 19).

Additionally, as shown in FIG. 20, a part of the side face 22a of the first flow passage 22 may be formed of the member 25.
The flow rate of the fluid Q flowing in the first flow passage 22 can be appropriately regulated by adjusting the thickness of the member 25.
The diameter of the first flow passage 22 can increase by, for example, stacking two or more the members 25 in layers.
Furthermore, it is also possible to place the downstream side of the second flow passage 23 on the upper face of the base body 30 by adjusting the height (thickness) of the stacked member 25.

A material used to form the member 25 is not particularly limited.
A resin substrate such as PDMS, PMMA, or the like, or a glass substrate can be used.
In other cases, a member which allows light beam used for an observation device (for example, visible light beams) to transmit therethrough or which does not allow the light beam to transmit therethrough, may be used as a member forming the upper face 23c of the second flow passage 23.
When it is intended that particles are only captured, the member allowing the light beam used for the observation device to transmit therethrough is not necessarily used.
As long as the member allowing the light beam used for the observation device to transmit therethrough is used, an optical technique of observing from the upper face can be carried out, and therefore it is preferable.

In the case where electrophysiological measurement of the trapped cell (fine-particle) T is carried out, a method for arranging, for example, electrodes 26 and 27 at the first flow passage 22 and the second flow passage 23, respectively, is adopted as shown in FIG. 21.
Alternatively, electrophysiological measurement can be performed by use of electrodes which is provided outside and which is electrically connected to the trapped cell through an extracellular buffer, intracellular liquid, or the like.
Since the suction portion S is formed of a single glass substrate 24, with respect to a cellular membrane of the cell T, it is possible to form a high resistance seal.
For this reason, when electrophysiological measurement of the cell is carried out, a publicly known patch clamping method can be applied.
At this time, by making the diameter of the hole configured by the first end portion 21 a of the microscopic hole 21 forming the suction portion S smaller than the diameter of a hole such as a conventional patch pipet or the like (approximately 2 to 4 pm), it is possible to perform electrophysiological measurement with a higher level of accuracy than ever before.
In other cases, the electrodes 26 and 27 may be arranged at different flow passages connected the first flow passage 22 and the second flow passage 23.

As described above, it is possible to suction and capture the particle T at the suction portion S, which is configured by the first end portion 21 a of the microscopic hole 21 and which is opened at the first flow passage 22 into which the fluid Q including the particles T flows, by suctioning of the microscopic hole 21 from outside of the base member 4.
Since the suction portion S is formed of a single member, seams are not formed and difference in level are not substantially provided.
Consequently, the trapped particle T is sufficiently attached firmly to the suction portion S, a trapped state is stabilized, the state can be continued.
Therefore, the particle T is easily observed.
Furthermore, in the case where the particles T are microorganisms or cells, the electrophysiological measurement can be carried out with a high level of accuracy.

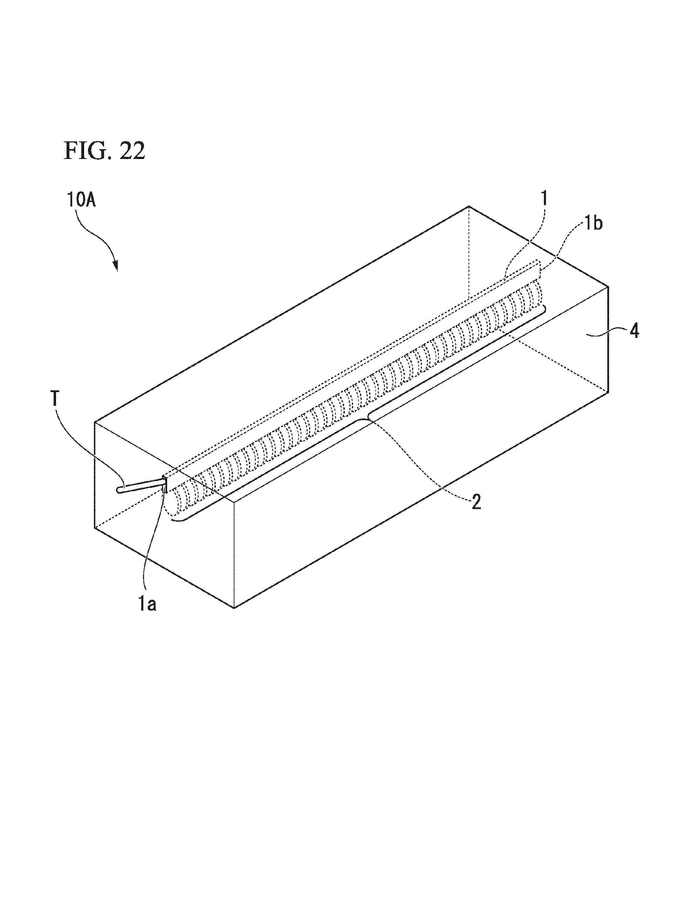

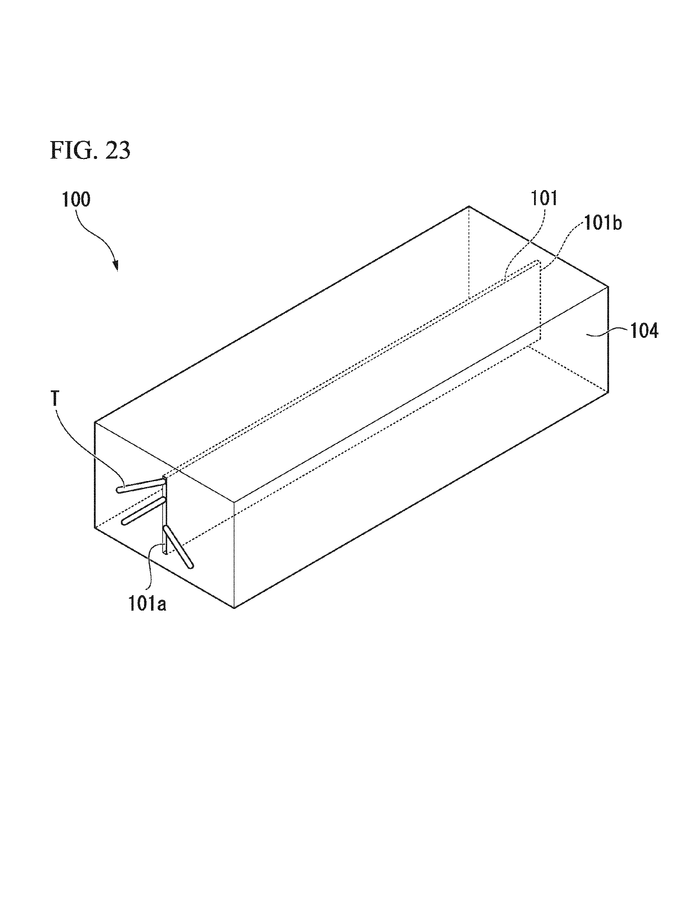

A state where the particle T is captured by the microscopic hole 1 of the base body 10A related to the invention is shown in FIG. 22.
The particle T included in the fluid Q is captured at the suction portion S formed of the first opening portion 1a of the microscopic hole 1 by suctioning of the fluid Q from the second opening portion 1 b of the microscopic hole 1.
As remarked above, since the periodic structure is formed in the microscopic hole formed of the base body related to the invention, the hole diameter of the opening portion of the microscopic hole 1 is small at the only region in which the periodic structure is formed.
Because of this, it is possible to only capture single particle T without possibility of capturing a plurality of the particles T at the suction portion S configured by the opening portion.
In contrast, in the case of a microscopic hole in which a periodic structure is not formed, since the opening portion thereof is large, a plurality of particles T are suctioned (FIG. 23).
In this case of unidirectionally observing the particles T (for example, from an upper face side of a base body 100), the particles T may overlap each other, and there is a problem in that it is difficult to perform observation or experiment operation.

According to the base body of the invention, particles can be adsorbed to the opening portion (first end portion of the microscopic hole) of the microscopic hole opening at the surface of the base body.
When a suction device is provided at a second end portion of the microscopic hole and the suction device suctions fluid including particles whose diameter is greater than the hole diameter of the microscopic hole from the first end portion of the microscopic hole through the inside of the microscopic hole, since the particles whose diameter is greater than the hole diameter of the microscopic hole cannot enter into the microscopic hole, the particle is captured at the first end portion of the microscopic hole.
In the case where the periodic structure is formed around the first end portion of the microscopic hole (opening portion) of base body of the invention, the diameter of the first end portion of the microscopic hole becomes smaller.
At the first end portion, a single particle is more easily suctioned by suctioning a particle.
That is, the risk that a plurality of particles are simultaneously captured at the first end portion is reduced.
For this reason, it is possible to easily perform an experiment such as measurement or observation of the captured particles.

In addition, a plurality of microscopic recessed portions or microscopic through holes are periodically formed in the longitudinal direction of the microscopic hole in the base body of the invention.
By utilizing the microscopic holes, the base body of the invention can be used as a device which separates fine-particles included in fluid into different sizes.
Particularly, in the case of suctioning the particles, which are smaller than the hole diameter of the microscopic hole and which have variations in the size thereof, from the first end portion of the microscopic hole, in the process in which the particles travel through the microscopic hole from the first end portion to the second end portion, since small particles diffuse in the periodic structure, the small particles, the time to reach the second end portion of the microscopic hole is long.
On the other hand, since a large particle does not enter the periodic structure and linearly travel in the longitudinal direction of the microscopic hole, the time to reach the second end portion of the microscopic hole is relatively short.
That is, according to the base body of the invention, it is possible to separate the particles into different sizes using a molecular sieve which uses gel filtration chromatography.

In addition, a plurality of microscopic recessed portions or microscopic through holes are periodically formed in the longitudinal direction of the microscopic hole in the base body of the invention.
In the case where fluid flows in the microscopic hole, the fluid flows or diffuses in the recessed portion or the microscopic through hole.
As a result, it is possible to make the rate of the fluid flowing from the first end portion of the microscopic hole to the second end portion slower than that in the microscopic hole in which the periodic structure is not formed.
That is, it is possible to control the rate of the fluid flowing in the microscopic hole by forming the periodic structure in the microscopic hole.
For example, the rate of the fluid in the case where the fluid flows from the first end portion 1 a of the microscopic hole 1 to the second end portion 1b in the above-described base body 10A tends to be slower than the rate of the fluid in the case where the fluid flows from the first end portion 1a of the microscopic hole 1 to the second end portion 1b in the above-described base body 10B.
The reason is that, the periodic structure 2, which is formed in the microscopic hole 1 of the base body 10A and becomes resistance in fluid, is longer than the periodic structure 2, which is formed in the microscopic hole 1 of the base body 10B and becomes resistance in fluid.
Accordingly, in the case where the microscopic hole has a constant length, the rate of the fluid flowing in the microscopic hole can be controlled by controlling the length of the periodic structure with respect to the longitudinal direction of the microscopic hole.

Furthermore, the rate of the fluid flowing in the microscopic hole can be controlled by controlling an angle with respect to the microscopic hole of the recessed portion or the microscopic through hole forming the periodic structure.
For example, as the base body shown in FIG. 30, it is thought that each recessed portion forming the periodic structure is formed inclined with respect to the longitudinal direction of the microscopic hole.
In this case, the rate of the fluid flowing in a forward direction from the first opening portion (85a side) of the microscopic hole to the second opening portion (85b side) tends to be faster than the rate of the fluid flowing in the reverse direction thereof.
In the flow in the forward direction, the fluid flowing in the microscopic hole is less likely to enter the back of each recessed portion and easily and smoothly flow from the first opening portion to the second opening portion.
On the other hand, in the flow in the reverse direction, the fluid flowing in the microscopic hole often enter the back of each recessed portion, since each recessed portion acts as resistance in flow, the rate of the fluid flowing from the second opening portion to the first opening portion is likely to be slow.
As stated above, the microscopic hole provided with the periodic structure can function as a flow-adjusting device controlling a state where the fluid flows in the microscopic hole by adjusting the angle (inclination) of each recessed portion or each microscopic through hole which forms the periodic structure with respect to the microscopic hole.

### Method Of Manufacturing Base Body Having Microscopic Hole

Next, an example of a method of manufacturing a base body related to the invention will be described.
The method of the invention which manufactures a base body having a microscopic hole includes: a step A of forming at least one of a first modified region and a second modified region by scanning inside of a base body with a focal point of a first laser light having a pulse duration on order of picoseconds or less; a step B of forming a periodic modified group formed of a plurality of third modified regions and fourth modified regions by scanning an inside of the base body with a focal point of a second laser light having a pulse duration on order of picoseconds or less; and a step C of removing the first modified region and the third modified regions by etching. After obtaining the base body which is formed so that the first modified region and the second modified region overlap or come into contact with the periodic modified group in the steps A and B, the step
C is carried out.

According to the manufacturing method, the first modified region and the second modified region having a diameter on the order of nanometers (corresponding to a microscopic hole having a diameter on the order of nanometers by etching) are formed by use of the first laser light at the region including the region on which the microscopic hole is to be formed in the substrate, the third modified region and the fourth modified region are formed by use of the second laser light at a region on which a periodic structure is to be formed, the first modified region and the third modified region are removed from the substrate by the etching, and it is thereby possible to form the microscopic hole having a hole diameter on the order of nanometers and including a microscopic periodic structure in the substrate.

In the invention, the first, second, third, and fourth modified regions mean the portion at which the base body is modified as described later.
Particularly, the "first modified region" is a portion at which interference occurs by plasmon which is generated by irradiation or by an interference wave of an electron plasma wave and incident light at a region (light-collecting portion) at which the base body is collectively irradiated with the first laser light.
The portion is easily and selectively etched by etching treatment in the step C and is a portion at which the microscopic hole can be formed after etching.
The "second modified region" is a portion at which the effect of the interference wave is less than that at the first modified region at a region (light-collecting portion) at which the base body is collectively irradiated with the first laser light.
The portion is less easily etched relatively by etching treatment in the step C.
The "third modified region" is a portion at which interference occurs by plasmon which is generated by irradiation or by an interference wave of an electron plasma wave and incident light at a region (light-collecting portion) at which the base body is collectively irradiated with the second laser light.
The portion is easily and selectively etched by etching treatment in the step C and is a portion at which a recessed portion or a microscopic through hole having the periodic structure can be formed after etching.
The "fourth modified region" is a portion at which the effect of the interference wave is less than that at the third modified region at a region (light-collecting portion) at which the base body is collectively irradiated with the second laser light.
The portion is less easily etched relatively by etching treatment in the step C.
Moreover, in the invention, the "modified region" means "a portion where the resistance to etching in a base member forming base body is converted from an original state".
By modifying combination of the kinds of base members and etching conditions, it is possible to vary the level of the resistance to etching regarding the same modified region.
That is, it is possible to optionally select the case of etching the first modified region and the third modified region or the case of etching the second modified region and the fourth modified region by modifying etching conditions.

In the manufacturing method of the invention, regarding the order of the steps, either the step A or the step B may be carried out first.
Hereinbelow, firstly, the case of performing the steps in the order from the step A to the step B will be described in a first to fourth embodiments.
Next to the embodiments, the case of performing the steps in the order from the step B to the step A will be described in a fifth embodiment.

In the case of performing the step B after the step A, it is preferable that the first modified region formed in the step A be constituted of only a first part and a second part excluding the first part, a modified state of the second part be transformed into a non-etching selectivity state (modification history is erased) by forming the modified group so as to overlap the second part (by overwriting the periodic modified group on the second part) in the step B after the step A, and the first part and the periodic modified group be formed so as to overlap or comes into contact with each other.

By erasing the history in the second part constituting the first modified region and by leaving the etching selectivity of the first part constituting the first modified region, it is possible to form the modified region (first part) having a diameter that is even smaller than the diameter of the first modified region on which the microscopic hole is to be formed.
As a result, the diameter of the microscopic hole can be smaller than that of the case where a periodic structure is not formed.
That is, it is possible to form a smaller microscopic hole having a diameter on the order of nanometers with a microscopic periodic structure.

When the first modified region is formed in the step A, it is possible to form the second modified region which is adjacent to the first modified region and whose major axis is substantially the same as that of the first modified region.
The second modified region likely to be formed in the case where the irradiation intensity of the first laser light is close to the processing upper limit threshold value or greater than or equal to the processing upper limit threshold value as described below.
The second modified region, which is formed adjacent to the first modified region, is constituted of a first part and a second part excluding the first part as with the first modified region.
After the step A, in the step B, the second part of the second modified region is also overwritten with the periodic modified group as with the second part of the first modified region, a modified state in the second modified region is transformed into a non-etching selectivity state (modification history in the second part is erased), and the first part of the second modified region and the periodic modified group are formed so as to overlap or come into contact with each other.
Because of this, the history in the second part constituting the second modified region is erased as with the first modified region, it is possible to leave the first part constituting the second modified region.
Here, by modifying conditions such as composition of an etching solution, etching time, or the like, it may be possible to preferentially or selectively etch the second modified region while leaving the first modified region.
Even in the case, since the modified region (first part) can be formed which is smaller than the diameter of the second modified region at which the microscopic hole is to be formed, the diameter of the microscopic hole formed by etching the second modified region can be smaller than that of the case where the periodic structure is not formed.
That is, it is possible to form a smaller microscopic hole having a diameter on the order of nanometers with a microscopic periodic structure even in cases where a second modified region is etched.

In the etching treatment in the step C, the first modified region and the third modified region are etched easier than the case where the second modified region and the fourth modified region are etched.
Therefore, it is desirable that the first modified region and the third modified region be etched.
In the embodiments (first to fifth) described below, the invention will be described with reference to a method of etching the first modified region and the third modified region; but the second modified region and the fourth modified region can be etched by modifying etching conditions in the same manner.
The configuration or the size of the microscopic hole and the configuration or the size of the periodic structure, which are formed in the case where the second modified region and the fourth modified region are etched, are similar to the configuration or the size of the microscopic hole and the configuration or the size of the periodic structure, which are formed in the case where the first modified region and the third modified region are etched.
The reason is that, the first modified region and the second modified region are adjacently formed so that the configurations or the sizes thereof are similar to each other, and the third modified region and the fourth modified region are adjacently formed so that the configurations or the sizes thereof are similar to each other.
However, in the case of forming only one (single) first modified region in the step A, two second modified regions may be formed at both sides of the first modified region.
In this case, whereas single microscopic hole is formed when the first modified region is etched, two microscopic holes are formed when the second modified region are etched.
The periodic structure can be formed so that the period of the periodic structure which is formed by etching the third modified region is displaced by one period with respect to the period of the periodic structure which is formed by etching the fourth modified region.
The reason is that, the third modified region and the fourth modified region constituting the periodic modified group are alternately formed and arranged.
Hereinbelow, an embodiment of a method of manufacturing a base body related to the invention will be more specifically described.

### First Embodiment Of Method Of Manufacturing Base Body

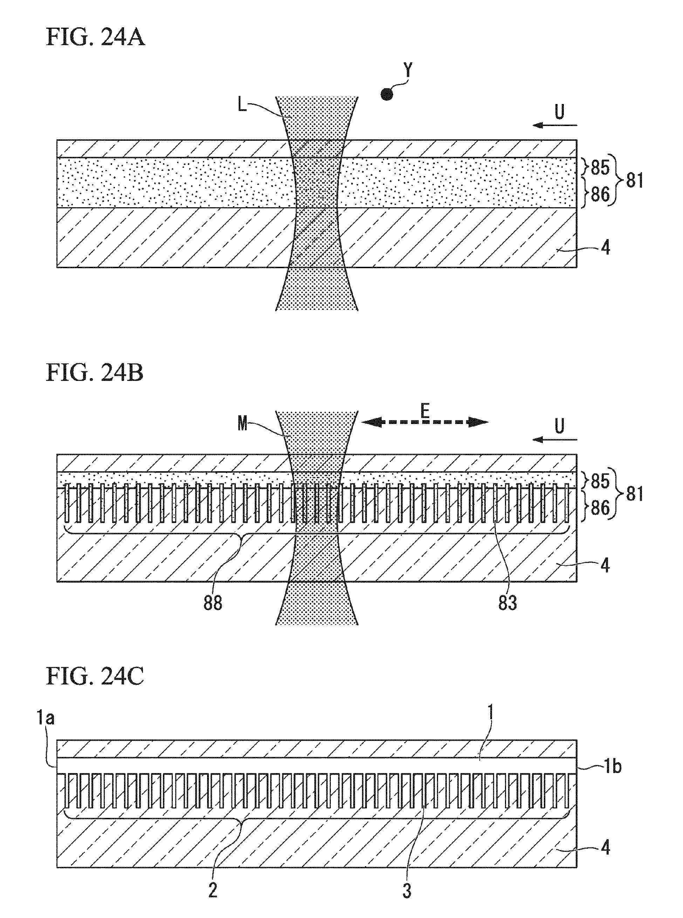

A manufacturing method of a first embodiment of the invention will be described with reference to FIGS. 24A to 24C using the aforementioned base body 10A as an example.

### Step A Of First Embodiment

Inside the base member 4 constituting the base body, a region 81 including a region 85 at which the microscopic hole 1 is to be formed is scanned with the focal point of the first laser light L having a pulse duration on order of picoseconds or less while the irradiation of the laser light, and a first modified region 81 is thereby formed on the region 81 (FIG. 24A).
The first modified region 81 is constituted of only a first part 85 and a second part 86 excluding the first part 85.
Particularly, the boundary between the first part 85 and the second part 86 is not present, and the first part 85 is to be etched in the subsequent step C.

In the step A, it is preferable that an angle formed between the polarization direction Y (electric field direction) of the first laser light L and the longitudinal direction of the first modified region 81 be greater than 88° and less than or equal to 90°.
That is, it is preferable that the angle formed between the scanning direction U (right and left directions on the paperface) of the first laser light L and the polarization direction Y of the first laser light L (deep direction presented as a point on the paperface) be greater than 88° and less than or equal to 90°. The angle is more preferably 88.5° to 90°, further preferably 89° to 90°, and most preferably 90°.
Additionally, it is preferable that the irradiation intensity of the first laser light L be less than the processing upper limit threshold value of the base member 4 and close to the processing upper limit threshold value thereof, or be less than the processing upper limit threshold value thereof as described below.

It is possible to easily form the diameter (minor axis) in the polarization direction Y out of the diameters of the first modified regions 81 to be formed, on the order of nanometers (approximately 1 nm to 900 nm) or sub-micrometers (approximately 0.9 to 1 µm) by irradiating the region with the first laser light L as configured above.
On the other hand, the diameter in the propagation direction of the first laser light L (major axis) out of the diameters of the first modified regions 81 to be formed is generally formed at approximately 0.5 to 5 µm.

When the first modified region 81 is formed as described above, a second modified region having substantially the same configuration as the first modified region 81 is formed adjacent to both side of the first modified region.
In FIG. 24A, the second modified region is formed parallel to the first modified region 81 at back side of the paperface and in front of the paperface (not shown in the figure).
At this time, as with the first modified region 81 which is constituted of the first part 85 and the second part 86, the second modified region is also constituted of a first part and a second part.
In the subsequent step B, when the modification history in the second part 86 of the first modified region 81 is erased, the modification history in the second part of the second modified region is similarly erased.

### Step B Of First Embodiment

A plurality of third modified regions 83 are formed so as to overlap or come into contact with the first part 85 of the first modified region 81 by scanning the region with the focal point of the second laser light M having a pulse duration on order of picoseconds or less in the longitudinal direction of the first modified region 81. At this time, the third modified regions 83 form a periodic modified group 88 (FIG. 24B).
In the drawing, ends of the third modified regions 83 (localized portions of the third modified regions) overlap the first part 85 of the first modified region 81.
The third modified regions 83, which is not shown in the figure, may be formed so that the ends of the third modified regions 83 come into contact with the first part 85 of the first modified region 81 without overlapping the first part 85 of the first modified region 81.
In any case, it is possible to form the microscopic hole 1 and the periodic structure 2 by etching of the step C so that the first part 85 of the first modified region 81 and the third modified regions 83 are removed from the inside of the base member 4 and the end portion of each recessed portion 3 opens at the inner wall of the microscopic hole 1.

In the step B, it is preferable that an angle formed between the polarization direction E (electric field direction) of the second laser light M and the longitudinal direction of the first modified region 81 be 0° to 88°. The angle is more preferably 0° to 15°, further preferably 0° to 5°, and most preferably 0°.
That is, it is preferable that the angle formed between the scanning direction U (right and left directions on the paperface) of the second laser light M and the polarization direction E (direction represented as a dotted line) of the second laser light M be 0° to 88°. The angle is more preferably 0° to 15°, further preferably 0° to 5°, and most preferably 0°.
FIG. 24B shows the case where the angle is 0°.
It is possible to form the third modified regions 83 so as to intersect with the first modified region 81 by adjusting the angle (defined angle) defined by the scanning direction U and the polarization direction E to be within the aforementioned range.
In the case where the angle is 0°, it is possible to form the third modified regions 83 so as to be orthogonal to the first modified region 81.
In this case, due to the periodic modified group 88 formed of a plurality of third modified regions 83, it is possible to effectively remove the first modified region 81 by a lower irradiation intensity of the laser light.
In the case where the angle is a low angle, the first modified region 81 can be formed by a lower irradiation intensity of the laser light, and is therefore preferable.

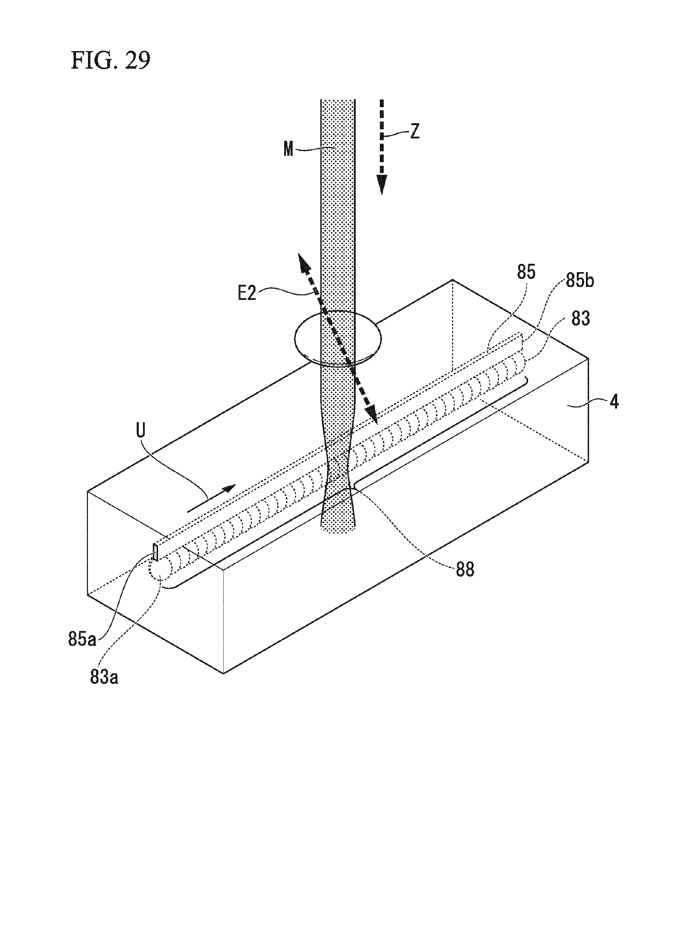

FIG. 29 shows the case where the angle is approximately 75°.
Even in the case, the periodic modified group 88 can be self-assembled in the scanning direction U (longitudinal direction of the first modified region 81) of the second laser light M by adjusting the irradiation intensity of the laser light to be greater than or equal to the processing upper limit threshold value.
At this time, interference of the laser light M and an electron plasma wave at a light focus area spreads in the polarization direction E2, each of the third modified regions 83 which are self-assembled is formed at angle of approximately 75° with respect to the scanning direction U.
Particularly, the front faces 83a of the third modified regions 83 (face having the largest surface area) is directed to a direction which is rotated by 75° with respect to the longitudinal direction of the first modified region 85.

Moreover, as described below, it is preferable that the irradiation intensity of the second laser light M be greater than or equal to the processing upper limit threshold value of the base member 4 or be greater than or equal to the processing upper limit threshold value thereof and close to the processing upper limit threshold value thereof.
By determining the irradiation intensity of the laser light as described above, the periodic modified group 88 formed of the third modified regions 83 can be self-assembled.
This mechanism will be described later.

The third modified regions 83 are formed so that the diameters thereof are on the order of nanometers or sub-micrometers by the irradiation of the second laser light M as mentioned above, and the period (distance between the recessed portions 3) of the periodic modified group 88 (periodic structure 2) can be 0.05 to 1.2 µm.
At this time, the thicknesses (width) of the third modified regions 83 to be formed can be thinnest as seen from a direction perpendicular to the polarization direction E.
In the case where the polarization direction E is parallel to, for example, the longitudinal direction of the first modified region 81, the thicknesses (width) of the third modified regions 83 to be formed can be thinnest in the longitudinal direction of the first modified region 81 (direction perpendicular to the longitudinal direction) (FIG. 24B).

In the step B, it is possible to form the third modified regions 83 by irradiating the second part 86 forming the first modified region 81 (region 86 which is irradiated with the second laser light M when the third modified regions 83 are formed) with the laser as described above simultaneously with erasing of the modification history in the second part 86 of the first modified region 81.

Modification history of the second part 86 of the first modified region 81 is erased by forming the periodic modified group 88 which is constituted of the third modified regions 83, and the first part 85 of the first modified region 81 remains.
As apparent from FIG. 24B, the major axis of the first part 85 (diameter of the first laser light L in the propagation direction thereof) is shorter than the total major axis of the first modified region 81 to which the first part 85 and the second part 86 are combined.
As a result, the major axis of the microscopic hole 1 which is formed after the first part 85 is etched is shorter than the major axis of the microscopic hole which is formed in the case where the periodic structure 2 (periodic modified group 88) is not formed.
That is, it is possible to form not only the minor axis of the microscopic hole 1 but also the major axis of the microscopic hole 1 on the order of nanometers by forming the periodic structure 2.

When the third modified regions 83 are formed, the modification history of the second part 86 of the first modified region 81 is erased, and a region on which the third modified region 83 is not formed is generated.
The region is a region which is sandwiched between the third modified regions 83 in the periodic modified group 88 in which the third modified regions 83 are arrayed.
The fourth modified regions are formed on the regions.
In other words, in the periodic structure 2 which is formed after the first modified region 81 and the third modified regions 83 are removed by etching and in which the recessed portions 3 are arrayed, the regions are non-recessed regions sandwiched between the recessed portions 3.
The non-recessed regions are regions whose state verge a previous state of modification by the process of modifying the non-recessed regions as the second part 86 of the first modified region 81 in the step A (after the resistance to etching in the second part 86 decreases), thereafter, reducing the degree of modification in the step B (resistance to etching in the second part 86, which was degraded one time, is improved).

That is, "modification history is erased" means that the resistance to etching, which was degraded one time, is improved so as to restore to original state in a portion in which the base member is modified so that the resistance to etching in the base member decreases.
However, "modification history is erased" does not necessarily mean that the portion in which the modification history is erased completely restored to a pre-modification original state.
The state of the portion in which the modification history is erased may be different from an original state.

An example of a base body, which is formed so as to remove the modification history of the second part 86 forming the first modified region 81 by the irradiation of the second laser light M, is the base body 10A.
The cross-sectional shape of the microscopic hole 1 in the cross section B shown in FIG. 2C is a portion corresponding to the first part 85 of the first modified region 81.
Since the modification history of the portion corresponding to the second part 86 of the first modified region 81 is erased by forming the third modified regions 83, the portion is not removed in an etching process and does not constitute the microscopic hole 1.
However, when the third modified regions 83 are formed, a portion, at which the modification history of the second part 86 forming the first modified region 81 is not sufficiently erased, may be generated depending on laser irradiation conditions.
In this case, since the portion, in which the modification history thereof is not erased and which remains, is removed by etching, the long side of the cross-sectional shape of the microscopic hole 1 is formed in the cross section B becomes further elongated.

When the third modified regions 83 are formed as described above, fourth modified regions having a shape similar to the third modified regions 83 are formed adjacent to both sides thereof.
In FIG. 24B, the fourth modified regions are formed at regions sandwiched between the third modified regions 83 in parallel with the third modified regions 83 (not shown in the figure).

### Step C Of First Embodiment

In the step C, the first part 85 of the first modified region 81 and the third modified regions 83 which are formed in the base member 4 are removed by etching.
At this time, in the second part 86 of the first modified region 81, the portion in which the modification history is erased is not etched and remains.
Consequently, the periodic structure 2 and the microscopic hole 1 are formed.
As mentioned above, since the material used to form the base member 4 in which a part 85 of the first modified region 81 and the third modified regions 83 are formed is modified so as to decrease the resistance to etching with respect to a predetermined etching solution, the material is removed from the base member 4 by etching of the step C.

The configuration of the opening portion of the microscopic hole 1, which opens at the side face of the base member 4 forming the resultant base body 10A, is a cross section A or a cross section B shown in FIGS. 2B and 2C.
It is also possible to obtain a preferred cross-sectional shape shown in the cross section A or the cross section B by exposing a fresh cross-sectional face by polishing or cutting the side face of the base body 4.
By carrying out the above- described steps A to C, it is possible to manufacture the base body 10A related to the invention.

Hereinbelow, the steps A to C will be further explained.
As the first laser light L and the second laser light M, a laser light having a pulse duration on order of picoseconds or less as a pulse duration is preferably used.
For example, a titanium-sapphire laser, a fiber laser having the pulse duration, or the like can be used.
However, it is necessary to use a wavelength which transmits through the base member 4.
More specifically, it is preferable that a laser light having 60% of transmissivity at which light transmits through the base member 4 be used.

It is preferable that a wavelength region of the first laser light L and the second laser light M is a commonly-used wavelength region (0.1 to 10 µm) used for a laser used for processing.
In such wavelength region, it is necessary to use a wavelength passing through the base member 4 which is a member to be processed.
It is possible to form the modified region in the base member 4 by applying the wavelength of a laser light transmitting through the base member 4.

As a material used to form the base member 4, the aforementioned materials are used. Particularly, for example, silicon, glass, silica, sapphire, or the like is adopted.
Such materials is excellent in workability of the microscopic hole 1, it is preferable.
Among them, amorphous is preferable which is less easily susceptible to anisotropy of processing due to crystal orientation.
Furthermore, in the case where glass, silica, or sapphire allowing visible light beams (wavelength of 0.36 to 0.83 µm) to transmit therethrough is adopted as the material used to form the base member 4, it is possible to observe the inside of the microscopic hole 1 by use of an optical device such as a microscope or the like, it is more preferable.

Furthermore, as a material used to form the base member 4, a material allowing light having at least part of wavelengths of 0.1 to 10 µm to transmit therethrough is preferably used.
Specifically, it is preferable that a material be used which transmits light having at least part of conventional wavelength regions (0.1 to 10 µm) used for a laser light used for processing.
By use of the laser light transmitting through the base member 4, it is possible to form the modified region by irradiating the base member 4 with the laser light.
Furthermore, a material allowing a visible light region (wavelength of approximately 0.36 to 0.83 µm) to transmit therethrough is more preferably used as the material used to form the base member 4.
By use of the material allowing the light in a visible light region to transmit therethrough, it is possible to easily observe the captured particle T in an optical device by use of an optical observation device.
Particularly, "transparent" of the invention means all states where light is incident to the base member and a transmissive light is obtained from the base member.
In FIGS. 24A to 24C, the base member 4 is a transparent single glass substrate (hereinbelow, referred to as glass substrate 4).

Hereinbelow, the case where the base member 4 is made of a glass substrate will be described; and even where the base member 4 is made of other base member such as silicon, silica, or sapphire, the base member can be used in the same manner.
From the viewpoint of workability such as a high level of processing accuracy and ease of processing, materials used to form the base member 4 are preferably silicon, silica, or glass.

As the glass substrate 4, for example, a glass substrate made of silica, a glass substrate made of glass containing silicate as a main component or borosilicate glass, or the like can be used.
The glass substrate made of synthetic silica is excellent in workability, preferable. Additionally, the thickness of the glass substrate 4 is not particularly limited.

Laser Irradiating Method In The Step A
When the region 81 including the region 85 in which the microscopic hole 1 is to be formed is irradiated with the first laser light L in the step A, it is preferable that the irradiation intensity be less than the processing upper limit threshold value of the glass substrate 4 and close to the processing upper limit threshold value thereof, or be less than the processing upper limit threshold value thereof, and the polarization direction of the first laser light L (electric field direction) be substantially perpendicular to scanning direction U.
That is, it is preferable that an angle formed between the polarization direction Y of the first laser light L and the scanning direction U of the focal point thereof be greater than 88° and less than or equal to 90°.
Hereinbelow, the laser irradiating method is referred to as laser irradiating method α.

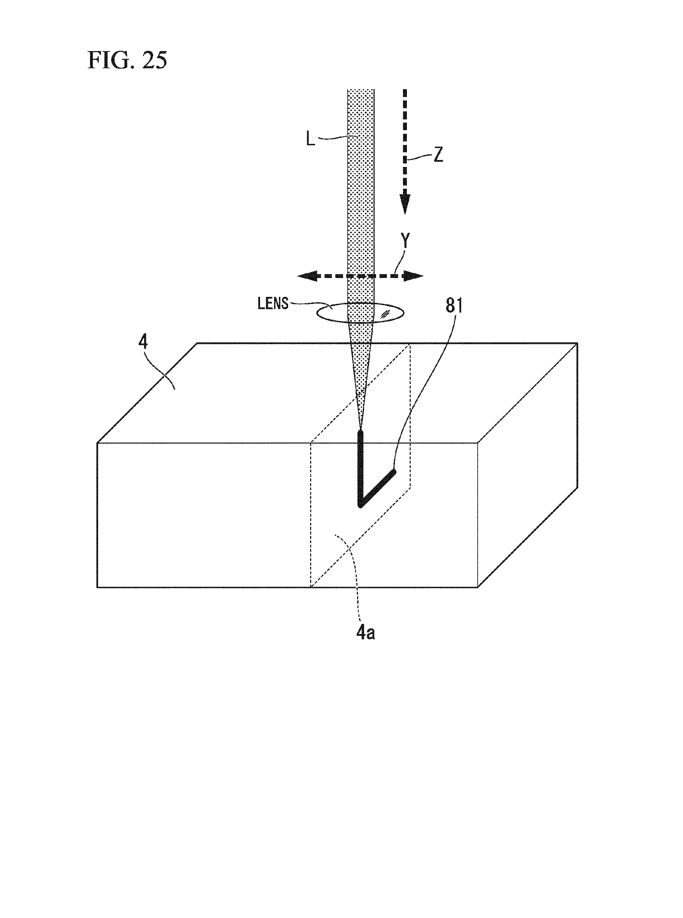

The laser irradiating method α will be described with reference to FIG. 25.
The propagation direction of the first laser light L is presented by arrow Z and the polarization direction of the first laser light L (electric field direction) is presented by arrow Y.
In the laser irradiating method α, an irradiated area of the first laser light L is set to a plane 4a formed by the propagation direction of the first laser light L and the direction perpendicular to the polarization direction of the first laser light L.
Additionally, the irradiation intensity of the laser light is less than the processing upper limit threshold value of the glass substrate 4 and close to the processing upper limit threshold value thereof, or be less than the processing upper limit threshold value thereof.

It is possible to form the first modified region 81 (a modified region to be formed in the region 81 including the region 85 in which the microscopic hole 1 is to be formed) having a hole diameter on the order of nanometers in the glass substrate 4 by the laser irradiating method α.
The first modified region 81 is obtained which has a cross-sectional face formed in a substantially elliptical shape having, for example, the minor axis of approximately 20 nm and the major axis of approximately 0.2 to 5 µm.
Regarding the substantially elliptical shape, in the case where, for example, the scanning direction U is substantially perpendicular to the propagation direction of the laser light L, the direction extending along the laser propagation direction is the major axis and the direction extending along the polarization direction of the laser is the minor axis.
The cross section may be close to be rectangular in shape depending on laser irradiation conditions.

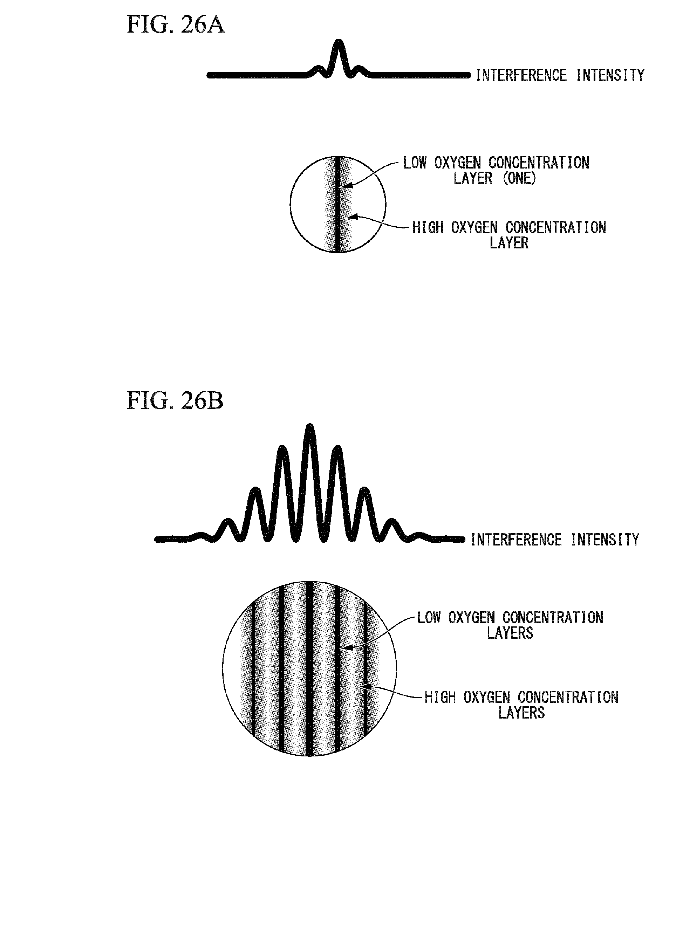

In the case where the irradiation intensity of the laser light is greater than or equal to the processing upper limit threshold value of the glass substrate 4, a plurality of first modified regions 81 may be formed along with a periodic modified group.
That is, due to collective irradiation of the light-collecting portion with the laser having a pulse duration on order of picoseconds or less at the processing upper limit threshold value or more, interference of an electron plasma wave and incident light occurs at the light-collecting portion, a plurality of first modified regions 81 which are arrayed in the polarization direction of the laser may be self-assembled with periodicity.
In the step A, when laser light scanning is carried out under the laser irradiation conditions, since the modified regions having periodicity formed by initial laser irradiation are continuously connected to the modified regions having periodicity formed by subsequent laser irradiation (subsequent laser pulse), it is possible to form the first modified regions 81 which are aligned in the polarization direction at a predetermined distance.
At this time, the longitudinal directions of the first modified regions 81 are substantially vertical to the polarization direction.
Additionally, as the formed first modified region 81 becomes closer to a center region in the first modified regions 81 which are formed parallel to each other, the degree of modification increases (refer to FIG. 26B).
Between the first modified regions 81 which are formed in parallel as described above, the second modified region is formed adjacent to the first modified region 81.
For example, the first modified region 81 and the second modified region may be alternately and collaterally formed.
As similar to the first modified regions 81, as the formed second modified region becomes closer to a center region in the second modified regions, the degree of modification increases.

The resistance to etching in the periodic modified group configured by the formed modified regions becomes low.
In the case where, for example, silica is used, layers lacking oxygen and layers in which oxygen increases are periodically arrayed (FIG. 26B), the resistance to etching in the first modified region formed as low oxygen concentration portions (and the third modified regions) is low.
It is possible to form recessed portions and protuberance portions (non-recessed region) which are periodically provided by etching the first modified region and the third modified regions.
As etching solution making the resistance to etching in the low oxygen concentration portion low, basic etchant such as hydrofluoric acid (HF) solution, KOH, or the like may be adopted.

High oxygen concentration portions (layers), which are formed adjacent to both sides of the low oxygen concentration portions (layers) shown in FIG. 26B, correspond to the second modified regions (and fourth modified regions).
The second modified region may be etched with priority over the first modified region by use of suitably selected etching solution.

In the step A, the modified regions having periodicity and the method of forming a periodic modified group which are described above are not necessary to use for the case of forming a single the first modified region 81, but, are extremely effective to use for forming the third modified regions 83 constituting the periodic modified group 88 in the step B.
In addition, even in the step A of the invention, the modified regions having periodicity and the method of forming a periodic modified group as described above are applied in the case of forming first modified regions 81, 81', and 81" corresponding to a plurality of microscopic holes 1, 1', and 1" which are arranged parallel to the planar direction of the glass substrate 4.

On the other hand, in the laser irradiating method α in the step A, the irradiation intensity of the laser light is less than the processing upper limit threshold value of the glass substrate 4 and is greater than or equal to the lower limit (processing lower limit threshold value) of the irradiation intensity of the laser light at which the resistance to etching can be reduced by modifying the glass substrate 4.
In the laser irradiating method α, the periodic modified group is not formed and one low oxygen concentration portion (layer having a low resistance to etching) is formed by laser irradiation (FIG. 26A).
When the etching of the low oxygen concentration portion is carried out, one microscopic hole 1 can be formed.

In FIG. 26A, two high oxygen concentration portions (layers) which are formed adjacent to both sides of one low oxygen concentration portion (layer) correspond to the second modified region.
The second modified region may be etched with priority over the first modified region by use of suitably selected etching solution.
In this case, it is possible to form two microscopic holes corresponding to the second modified region.

Even where only one layer having a low resistance to etching with respect to a predetermined etching solution is formed by laser irradiation, the low oxygen concentration portions become layers having an extremely high level of etching selectivity.
This is found out by the inventors with an intensive research.
In the invention, a layer having a high level of etching selectivity is formed as the first modified region 81.
As an example of the layer having a low resistance to etching with respect to a predetermined etching solution, low oxygen concentration portions formed in silica or glass are adopted.
The low oxygen concentration portions are formed as a layer having a low resistance to etching with respect to an etching solution containing, for example, hydrofluoric acid as a main component.

For this reason, the processing upper limit threshold value is defined as a lower limit of the irradiation intensity of the laser light capable of forming a periodic modified group.
The processing upper limit threshold value is substantially determined by a wavelength of a laser light and a material (material object) used to form the base member 4 to be irradiated with a laser or depending on laser irradiation conditions.
However, in the case where the polarization direction and the scanning direction of the laser light are relatively different from each other, the processing upper limit threshold values thereof may be slightly different from each other.
For example, the processing upper limit threshold value in the case where the scanning direction is perpendicular to the polarization direction may differ from that in the case where the scanning direction is parallel to the polarization direction.
Consequently, regarding a wavelength of a laser light to be used and a base member to be used, the processing upper limit threshold values in the case of varying the relationship between the polarization direction and the scanning direction of the laser light are preferably searched in advance.

Additionally, "the lower limit (processing lower limit threshold value) of the irradiation intensity of the laser light at which the resistance to etching can be reduced by modifying the glass substrate 4" is the limit value at which the microscopic hole 1 can be formed on the glass substrate 4 by etching treatment.
If a value is lower than the lower limit, since a layer having a low resistance to etching cannot be formed by laser irradiation, it is not possible to form the microscopic hole 1.
That is, "processing upper limit threshold value" is the lower limit of the irradiation intensity of the laser light, which causes interference of the incident laser light and the electron plasma wave generated by reciprocal action between the base member and the laser light at the focal point (light focus area) at which the inside of the base member is irradiated with the laser light and which can cause streaky modified regions in the base member to be self-assembled due to the interference.
Moreover, "processing lower limit threshold value" is the lower limit of the irradiation intensity of the laser light, which forms modified regions at which the base member is modified at the focal point (light focus area) at which the inside of the base member is irradiated with the laser light and which can decrease the resistance to etching in the modified regions to the extent that the modified regions can be selectively or preferentially etched by etching treatment as a post-process.
The region, which is irradiated with the irradiation intensity of the laser light less than the processing lower limit threshold value by laser irradiation, is difficult to be selectively or preferentially etched in etching treatment as a post-process.
Accordingly, in order to form a modified region at which a microscopic hole is to be formed after etching, it is preferable that the irradiation intensity of the laser light be greater than or equal to the processing lower limit threshold value and less than or equal to the processing upper limit threshold value.
The processing upper limit threshold value and the processing lower limit threshold value are substantially determined depending on a wavelength of a laser light, a material (material object) used to form a base member to be irradiated with a laser, and laser irradiation conditions.
However, in the case where the polarization direction and the scanning direction of the laser light are relatively different from each other, the processing upper limit threshold values thereof may be slightly different from each other and the processing lower limit threshold values thereof may be slightly different from each other.
For example, the processing upper limit threshold value and the processing lower limit threshold value in the case where the scanning direction is perpendicular to the polarization direction may differ from that in the case where the scanning direction is parallel to the polarization direction.
Consequently, it is preferable that the processing upper limit threshold values and the processing lower limit threshold values, which are related to a wavelength of a laser light to be used and a base member to be used, be researched in advance depending on variations in the relationship between the polarization direction and the scanning direction of the laser light are preferably searched in advance.

According to the aforementioned laser irradiating method α, the cross-sectional shape of the microscopic hole 1 can be an ellipse or substantially ellipse (substantially a rectangle).
Furthermore, the minor axis of the ellipse or substantially ellipse can be controlled to be on the order of nanometers by etching.
By reducing the minor axis of the elliptical-shaped or substantially elliptical-shaped opening portion of the microscopic hole 1 to be less than a particle size, it is possible to capture a particle at the opening portion.

In the case of forming the first modified region 81 by use of the above-described laser irradiating method α, it is possible to form the first modified region 81 while the width (minor axis) of the first modified region in the polarization direction Y of the first laser light L is controlled to be on the order of nanometers.
However, it is relatively difficult to control (major axis) of the first modified region 81 in the propagation direction Z of the first laser light L to be on the order of nanometers.
In order to solve the difficulty, by overwriting the second part 86 of the first modified region 81 with the third modified regions 83 (periodic modified group 88) in the step B and clearing the modification history of the second part 86, it is possible to shorten the width of the first modified region 81 in the propagation direction Z of the first laser light L.
Accordingly, it is possible to form the first modified region 81 (major axis) in the propagation direction Z of the first laser light L while the width thereof is controlled to be on the order of nanometers.

The polarization is described in detail on the assumption that it is linearly polarized.
However, even in the case of using a laser pulse in which the polarization includes a little elliptical polarization component, it is easily supposed that the same structure (modified region) is formed.

The scanning method of the focal point of the first laser light L when the first modified region 81 is formed is not particularly limited, however, the modified regions which can be formed by single-time continuous scanning is limited in the plane 4a which is defined by the direction substantially vertical to the polarization direction (direction presented by arrow Y) and the propagation direction of the laser light L (direction presented by arrow Z).
As long as it is in the plane 4a, it is possible to form the modified region having an optional configuration.

FIG. 25 shows the case where the propagation direction of the first laser light L is vertical to the upper face of the glass substrate 4, however, the direction is not necessarily vertical thereto.
The upper face may be irradiated with the first laser L at a desired incidence angle.
By appropriately changing the polarization direction of the laser (direction presented by arrow Y) in the glass substrate 4, it is possible to form the modified region having an optional configuration in three-dimensional directions.

Additionally, as shown in FIG. 25, the first modified region 81 may be formed by condensing the first laser light L using a lens and irradiating the glass substrate as described above.
As the lens, for example, a refraction object lens or a refraction lens can be used. Furthermore, in other cases, irradiation can be carried out by using a lens such as, for example, a Fresnel lens, a reflection type lens, an oil immersion type lens, or a water immersion type lens.
Moreover, by use of, for example, a cylindrical lens, a broad region of the glass substrate 4 can be irradiated with the laser at one time.
In addition, by use of, for example, a conical lens, a broad region of the glass substrate 4 in the vertical direction thereof can be irradiated with the laser light L at one time.
However, in the case of using a cylindrical lens, it is necessary for the polarization of the laser light L to align the horizontal direction with respect to the direction in which a lens has curvature.

As specific examples of the laser irradiation conditions α, various conditions described below are adopted.
In the case of using, for example, a titanium-sapphire laser (laser using a crystal having sapphire into which titanium is doped as a laser medium), an irradiating laser light having, for example, a wavelength of 800 nm and repetition rate of 200 kHz is used, and collective irradiation of the laser light L is carried out at a laser scanning rate of 1 mm/s.
Such wavelength, repetition rate, and scanning rate are shown as an example, however, the present invention is not limited thereto and can be optionally variable.

As a lens used for light condensing, for example, an object lens having N.A.<0.7 or less is preferably used.
As under an irradiation condition for forming a finer microscopic hole 1, irradiation is preferably carried out under the value close to the processing upper limit threshold value.
Specifically, for example, in the case of pulse duration of 300 fs, repetition rate of 200 kHz, and a scanning rate of approximately 1 mm/s as conditions, the irradiation is preferably performed at pulse energy of approximately 80 nJ/pulse or less, the irradiation intensity of approximately 550 kW/cm², and the laser fluence per one pulse of approximately 2.7 J/cm².
If the irradiation intensity or the laser fluence per one pulse is greater than or equal to the processing upper limit threshold value as under the condition, the periodic structure may be formed.
Furthermore, if the pulse duration is made even shorter, if the scanning rate is made slow, if the repetition rate increases, the optimal laser irradiation intensity or the optimal laser fluence per one pulse is made even lower.
Conversely, if the pulse duration is made longer, if the scanning rate is made fast, if the repetition rate decreases, the optimal irradiation intensity or the optimal laser fluence per one pulse shows a tendency to be even higher.
Additionally, the processing can be carried out even under the condition of N.A.≥0.7. However, since the spot size is made even smaller and the laser fluence per one pulse becomes higher, laser irradiation caused by a lower pulse energy is required.

On the other hand, in the case of forming the first modified regions and the second modified regions on the region by irradiation of the first laser light L, which is other than the region 81 including the region 85 in which the microscopic hole 1 is to be formed, the irradiation intensity may be a value which is sufficiently greater than the processing upper limit threshold value of the glass substrate 4.
As a result, it is possible to form the periodic modified group configured to include a plurality of first modified regions and second modified regions.

Laser Irradiating Method In The Step B
When the second part 86 of the first modified region 81 is irradiated with the second laser light M in the step B, it is preferable that the irradiation intensity be greater than or equal to the processing upper limit threshold value of the glass substrate 4 or be greater than or equal to the processing upper limit threshold value and close to the processing upper limit threshold value, and it is preferable that an angle formed between the polarization direction (electric field direction) of the second laser light M and the scanning direction U be 0° to 88°.
Hereinbelow, the laser irradiating method is referred to as laser irradiating method β.

The definitions of "processing upper limit threshold value" in the steps A and B are the same as each other, however, the processing upper limit threshold value the step B is not necessarily the same as that of the processing upper limit threshold value in the step A.
The reason is that, the relationship between the laser scanning direction and the polarization direction (electric field direction) in the step A are different from the relationship between the laser scanning direction and the polarization direction (electric field direction) in the step B.
Consequently, the processing upper limit threshold values (irradiation intensity of the laser light) may be different from each other in the step A (laser irradiating method α) and the step B (laser irradiating method β), and the laser irradiation conditions may be different from each other in the steps A and B.

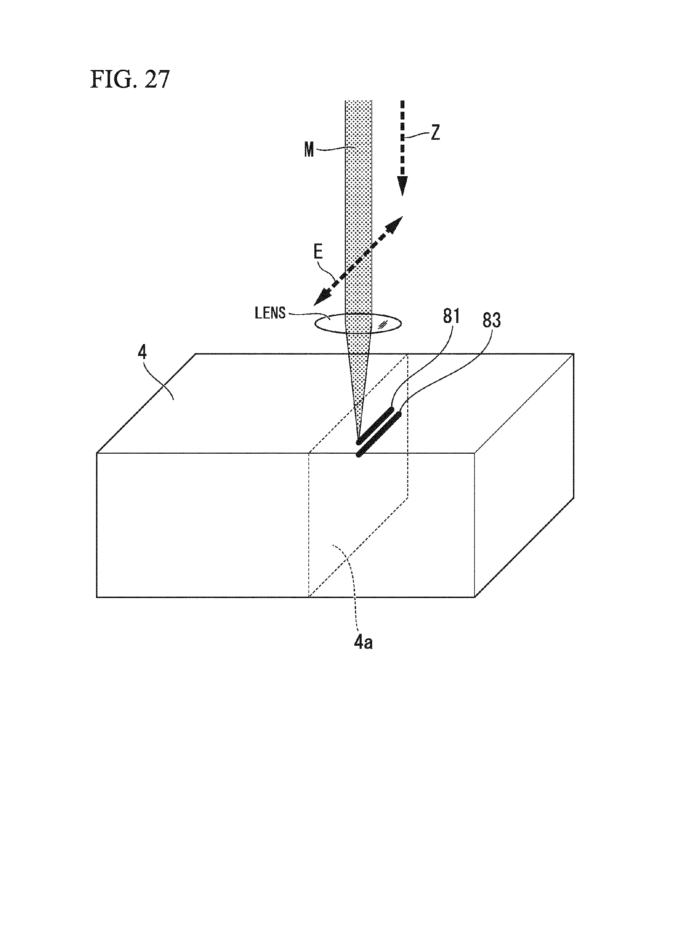

The laser irradiating method β will be described with reference to FIG. 27.
The propagation direction of the second laser light M is presented by arrow Z and the polarization direction of the second laser light M (electric field direction) is presented by arrow E.
Here, the polarization direction E of the second laser light M is set parallel to the scanning direction U of the second laser light M.
That is, an irradiated area of the second laser light M is set to a plane 4a formed by the propagation direction Z of the second laser light M and the direction parallel to the polarization direction E of the second laser light M.
Additionally, the irradiation intensity of the laser light is greater than or equal to the processing upper limit threshold value of the glass substrate 4, or is greater than or equal to the processing upper limit threshold value and close to the processing upper limit threshold value.

By use of the laser irradiating method β, the third modified regions 83 is formed and a modified state of the second part 86 forming the first modified region 81 can be transformed into a non-etching selectivity state (modification history is removed).
The period or the configuration of the periodic modified group 88 formed of the third modified regions 83 is the same as in the configuration which is explained by reference to the formed periodic structure 2 (or the periodic structure 6) in which the recessed portions 3 (or the microscopic through holes 7) are arrayed in the aforementioned base bodies 10A to 10G related to the invention.
In particular, the third modified regions 83 corresponds to the recessed portions 3 (or the microscopic through holes 7).

When the third modified regions 83 are formed, interference of an electron plasma wave and incident light occurs at the light-collecting portion by collectively irradiating the light-collecting portion with the laser having a pulse duration on order of picoseconds or less at the processing upper limit threshold value or more, the third modified regions 83 which are arrayed in the polarization direction of the laser can be self-assembled with periodicity.
That is, the periodic modified group (periodic structure having periodicity) in which the third modified regions 83 are arrayed can be self-assembled.
In the step B, after laser light scanning is carried out under laser irradiation conditions β, since the period of a plurality of third modified regions formed by the light focus area by initial laser irradiation (first laser pulse) coincides with and is aligned with the period of a plurality of third modified regions formed by the light focus area by laser irradiation (subsequent laser pulse) by which the position different from that of the initial laser irradiation is subsequently irradiated. Therefore, it is possible to form the periodic modified group 88 formed of the third modified regions 83 arranged at a predetermined distance in the scanning direction.
In other words, in the step B, the periodic modified group formed by the initial laser irradiation functions as a starting point, the third modified regions 83 having the same degrees of periodicity is self-assembled so as to align with the scanning direction from the starting point, and the periodic modified group 88 formed of the third modified regions 83 can be self-assembled.
The fourth modified regions are adjacently formed at both sides of the third modified region and on the region sandwiched between the third modified regions 83 formed in the above-described manner.
Moreover, when the third modified region and the fourth modified region are formed, the modification histories of the second part of the first modified region and the second part of the second modified region which were already formed are erased.

Layers having a low resistance to etching with respect to a predetermined etching solution are arrayed in the periodic modified group which is constituted of the formed third modified regions.
In the case of using, for example, silica, a layer lacking oxygen (third modified region) and a layer (fourth modified region) in which oxygen increases are periodically arrayed (FIG. 26B), the resistance to etching in the low oxygen concentration portion against, for example, etching solution containing hydrofluoric acid as a main component is made low, and the periodic recessed portions and the protuberance portions may be formed by etching.

Even where a plurality of layers having a low resistance to etching with respect to a predetermined etching solution is formed by laser irradiation, the low oxygen concentration portions become layers having an extremely high level of etching selectivity.
As an example of the layer having a low resistance to etching with respect to a predetermined etching solution, low oxygen concentration portions formed in silica or glass are adopted.
The low oxygen concentration portions are formed as a layer having a low resistance to etching with respect to an etching solution containing, for example, hydrofluoric acid as a main component.

For this reason, the irradiation intensity of the laser light in the laser irradiating method β in the step B is only necessary to be greater than or equal to the processing upper limit threshold value, and is preferably greater than or equal to the processing upper limit threshold value or is preferably greater than or equal to the processing upper limit threshold value and close to the processing upper limit threshold value.
In the case of carrying out laser irradiation at a high-irradiation intensity of the laser light which is extremely away from the processing upper limit threshold value, the third modified regions may be connected to each other as a crack is generated between the third modified regions constituting the periodic modified group.

Particularly, in the step B, the processing upper limit threshold value is defined as a lower limit of the irradiation intensity of the laser light capable of forming a periodic modified group.
Additionally, the processing upper limit threshold value in the step B is an irradiation intensity of the laser light which is greater than or equal to the aforementioned "the lower limit (processing lower limit threshold value) of the irradiation intensity of the laser light at which the resistance to etching can be reduced by modifying the glass substrate 4" or which exceeds the processing lower limit threshold value.
In other cases, the processing upper limit threshold value in the step A and the processing upper limit threshold value in the step B may be different from each other because the laser irradiating methods thereof are different from each other.

The polarization is described in detail on the assumption that it is linearly polarized.
However, even in the case of using a laser pulse in which the polarization includes a little elliptical polarization component, it is easily supposed that the same structure (modified region) is formed.

When the third modified regions 83 are formed in the step B, the first modified region 81 is scanned with the focal point of the second laser light M in the longitudinal direction thereof.
At this time, it is preferable that an angle formed between the polarization direction (electric field direction) of the second laser light M and the scanning direction U (longitudinal direction of the first modified region 81) be 0° to 88°.

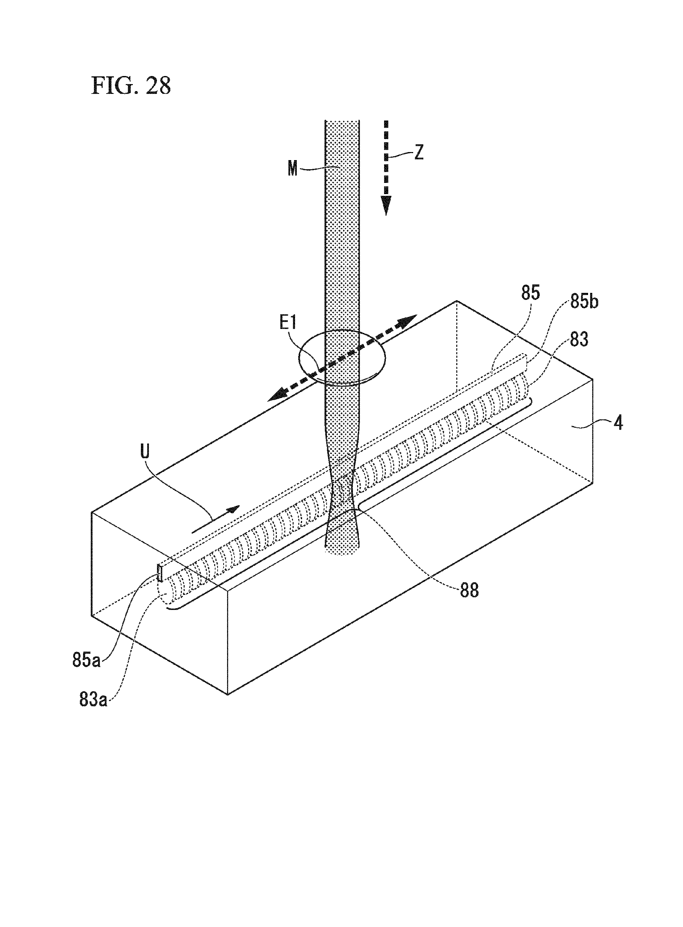

For example, the polarization direction E1 of the second laser light M is made parallel to the scanning direction U in FIG. 28.
That is, the angle formed between the polarization direction E1 and the scanning direction U is 0°.
In this case, the front faces 83a of the third modified regions 83 to be formed (face having the largest surface area) is directed to the longitudinal direction of the first modified region 81.
In other words, the front faces 83a of the third modified regions 83 to be formed is directed to the same direction as the polarization direction E1.
At this time, the third modified regions 83 are arrayed and the periodic modified group 88 is formed so that the thickness (width) of the third modified region 83 is visible thinnest when viewed from the direction perpendicular to the polarization direction E1.

Furthermore, in the other example cases, an angle between the polarization direction E of the second laser light M2 and the scanning direction U is set to 75° in FIG. 29.
In this case, the front faces 83a of the third modified regions 83 to be formed (face having the largest surface area) is directed to a direction which is rotated by 75° with respect to the longitudinal direction of the first modified region 85.
In this case, the front faces 83a of the third modified regions 83 to be formed is also directed to the same direction as the polarization direction E2.
At this time, the third modified regions 83 are arrayed and the periodic modified group 88 is formed so that the thickness (width) of the third modified region 83 is visible thinnest when viewed from the direction perpendicular to the polarization direction E2.

As stated above, the angle γ between the scanning direction U of the second laser light M and the polarization direction E is preferably 0° to 88°. The angle is more preferably 0° to 15°, further preferably 0° to 10°, particularly, preferably 0° to 5°, and most preferably 0°.
FIG. 28 shows the case where the angle γ is 0° and FIG. 29 shows the case where the angle γ is 75°.
Generally, in the case where the angle γ is 0°, the hole diameter (major axis) of the opening portion of the microscopic hole 1 to be formed is most easily reduced.
Additionally, as the angle γ becomes low, the modification history of the first modified region 81 can be effectively removed by the even lower irradiation intensity of the laser light, and it is preferable.
For example, if the angle γ is 0°, the first modified region 81 is effectively removed by the even lower irradiation intensity of the laser light using the aforementioned laser irradiating method β and it is possible to form the periodic modified group 88 formed of the third modified regions 83.

FIGS. 24B, 31 B, 32B, and 33A, which show examples of manufacturing methods related to the invention, show the case where the scanning direction U of the second laser light M is parallel to the polarization direction E (electric field direction).

FIGS. 27 to 29 show the cases where the propagation direction of the second laser light M is vertical to the upper face of the glass substrate 4, however, the direction is not necessarily vertical thereto.
The upper face may be irradiated with the second laser M at a desired incidence angle.
In this case, the third modified regions 83 configuring the periodic modified group 88 can be obliquely formed in the propagation direction Z of the second laser light M so as to be inclined with respect to the upper face without forming the third modified regions perpendicularly to the substrate surface (FIG. 30).
In the case where the longitudinal direction of the first modified region 81 is formed in the thickness direction of the substrate 4, it is only necessary to irradiate the side face of the substrate 4 with the second laser light M in order to form the third modified regions 83.

Generally, the transmissivity of a modified portion with respect to a laser is different from the transmissivity of a non-modified portion with respect to the laser.
For this reason, generally, it is difficult to control the position of the focal point of the laser light passing through the modified portion.
However, the second laser light M for forming the third modified regions 83 can be passed through the first modified region 81 formed in the step A with control and irradiation.
In fact, since the first modified region 81 does not make control of the irradiation of the second laser light M difficult, it is possible to irradiate the third modified regions 83 so as to overlap the first modified region 81.
The reason that the first modified region 81 does not affect the incident second laser light M is not unexplained, it is conceivable that a width of the first modified region 81 is on the order of nanometers.

Additionally, as shown in FIG. 27, the third modified region 83 may be formed by condensing the second laser light M using a lens and irradiating the glass substrate as described above.
As the lens, for example, a refraction object lens or a refraction lens can be used.
Furthermore, in other cases, irradiation can be carried out by using a lens such as, for example, Fresnel, reflection type, oil immersion type, water immersion type.
Moreover, by use of, for example, a cylindrical lens, a broad region of the glass substrate 4 can be irradiated with the laser at one time.
In addition, by use of, for example, a conical lens, a broad region of the glass substrate 4 in the vertical direction thereof can be irradiated with the second laser light M at one time.

As specific examples of the laser irradiation conditions β, various conditions described below are adopted.
In the case of using, for example, a titanium-sapphire laser (laser using a crystal having sapphire into which titanium is doped as a laser medium), an irradiating laser light having, for example, a wavelength of 800 nm and repetition rate of 200 kHz is used, and collective irradiation of the laser light L is carried out at a laser scanning rate of 1 mm/s.
Such wavelength, repetition rate, and scanning rate are shown as an example, however, the present invention is not limited thereto and can be optionally variable.

As a lens used for light condensing, for example, an object lens having N.A.<0.7 or less is preferably used.
As under an irradiation condition for forming a finer microscopic hole 1, irradiation is preferably carried out under the value which is greater than or equal to the processing upper limit threshold value and close to the processing upper limit threshold value.
Specifically, for example, in the case of pulse duration of 300 fs, repetition rate of 200 kHz, and a scanning rate of approximately 1 mm/s as conditions, the irradiation is preferably performed at pulse energy of approximately 80 nJ/pulse, the irradiation intensity of approximately 550 kW/cm², and the laser fluence per one pulse of approximately 2.7 J/cm².
Additionally, the processing can be carried out even under the condition of N.A.≥0.7. However, since the spot size is made even smaller when the pulse energies are the same as each other, and since the laser fluence per one pulse becomes higher, laser irradiation caused by a lower pulse energy is required.
The period of the periodic modified group is variable by changing a wavelength of the second laser light M or pulse energy.
Commonly, as a wavelength of the second laser light M becomes long or pulse energy of the second laser light M becomes large, the period has a tendency to increase.

### Regarding Etching In Step C

As an etching method, wet etching is preferable.
Since the resistances to etching of the first modified region 81 and the third modified regions 83 are sufficiently changed, etching can be selectively or preferentially carried out by use of a suitable etching solution.

The etching of the step C utilizes a phenomenon that the first modified region 81 and the third modified regions 83 are etched extremely faster than a non-modified portion of the glass substrate 4, the second modified region, and the fourth modified region.
As a result of this etching, it is possible to form the periodic structure 2 and the microscopic hole 1 corresponding to the configurations of the modified regions.
The etching solution is not particularly limited; as the etching solution, for example, a solution containing hydrofluoric acid (HF) as a main component, mixed acid containing hydrofluoric nitric acid series in which an appropriate amount of nitric acid or the like is added into hydrofluoric acid, or the like can be used.
Furthermore, the other chemical solution can be used depending on the material used to form the base member 4.
As the result of the etching, it is possible to form the microscopic hole 1 having a diameter on the order of nanometers at a predetermined position within the glass substrate 4.
Regarding the microscopic hole 1 and the periodic structure 2 which are formed by etching, the diameter of the microscopic hole 1, the configuration or the size of the opening portion, the configuration or the size of the periodic structure 2, the recessed portions 3 forming the periodic structure 2, or the period of the array of the microscopic through holes 7, are described based on the aforementioned base bodies 10A to 10G related to the invention.

The difference in size between the first modified region 81 and the microscopic hole 1 can be reduced or increased by controlling the processing time of the wet etching.
Similarly, the difference in size between the third modified region 83, and the recessed portions 3 constituting the periodic structure 2 or the microscopic through holes 7 can be reduced or increased.
For example, the microscopic hole 1 having the minor axis of several nm to several dozens of nm can be theoretically formed by shortening the processing time.
Conversely, the minor axis of the microscopic hole 1 can also be large by lengthening the processing time.

Here, the case was explained where the first modified region and the third modified regions are etched, but the second modified region and the fourth modified region can be preferentially or selectively etched relative to the first modified region and the third modified regions by modifying etching solutions and etching conditions.
When, for example, a glass substrate is used as the base member 4, a low oxygen concentration layer to be formed by laser irradiation corresponds to the first modified region and the third modified regions, and a high oxygen concentration layer corresponds to the second modified region and the fourth modified region.
In this case, if an etching solution containing hydrofluoric acid as a main component is used as described above, the first modified region and the third modified regions can be preferentially or selectively etched. If other suitable etching solutions are used, the second modified region and the fourth modified region can be etched.
Generally, since the etching selectivities of the first modified region and the third modified regions are high, the first modified region and the third modified regions are easily removed from the base member by etching, and it is preferable.

As etching of the step C, dry etching is applicable.
Regarding the dry etching, as an isotropic etching method, various dry etching methods such as barrel-type plasma etching, parallel-plate-type plasma etching, down-flow-type chemical dry etching, or the like are adopted.

Regarding the dry etching, as an anisotropic dry etching method, dry etching methods are adopted using reactive ion etching (hereinbelow, refer to RIE) such as parallel-plate-type RIE, magnetron-type RIE, ICP-type RIE, NLD-type RIE, or the like.
It is possible to use not only RIE but also etching using, for example, a neutral beam.
In the case of using such anisotropic dry etching methods, the mean free path of ion is shortened by use of technique of increasing a processing pressure or the like, and processing close to isotropic etching can be carried out.

The gas can be used which includes a gas capable of chemically etching a material, such as fluorocarbon-based gas, SF-based gas, CHF_{3,} fluorine gas, chlorine gas, or the like, as a main gas, and the other appropriate gas such as oxygen gas, argon, helium, or the like which are mixed into the main gas.
Furthermore, processing can be carried out by the other dry etching method.

### Second Embodiment Of Method Of Manufacturing Base Body

Next, the manufacturing method of a second embodiment of the invention will be described using the above-described base body 10D as an example with reference to FIGS. 31A to 31D.

### Step A Of Second Embodiment

Inside the base member 4 constituting the base body, a region 81 including a region 85 at which the microscopic hole 1 is to be formed is scanned with the focal point of the first laser light L having a pulse duration on order of picoseconds or less while the irradiation of the laser light, and a first modified region 81 is thereby formed on the region 81 (FIG. 31A).
The first modified region 81 is constituted of only a first part 85 and a second part 86 excluding the first part 85.
Particularly, the boundary between the first part 85 and the second part 86 is not present, and the first part 85 is to be etched in the subsequent step C.

In the step A, it is preferable that an angle formed between the polarization direction Y (electric field direction) of the first laser light L and the longitudinal direction of the first modified region 81 be greater than 88° and less than or equal to 90°.
That is, it is preferable that the angle formed between the scanning direction U (right and left directions on the paperface) of the first laser light L and the polarization direction Y of the first laser light L (deep direction presented as a point on the paperface) be greater than 88° and less than or equal to 90°. The angle is more preferably 88.5° to 90°, further preferably 89° to 90°, and most preferably 90°.
Additionally, it is preferable that the irradiation intensity of the first laser light L be less than the processing upper limit threshold value of the base member 4 and close to the processing upper limit threshold value thereof, or be less than the processing upper limit threshold value thereof.

It is possible to easily form the diameter (minor axis) in the polarization direction Y out of the diameters of the first modified regions to be formed, on the order of nanometers (approximately 1 nm to 900 nm) or sub-micrometers (approximately 0.9 to 1 µm) by irradiating the region with the first laser L as configured above.
On the other hand, the diameter in the propagation direction of the first laser light L (major axis) out of the diameters of the first modified regions to be formed is generally formed at approximately 0.5 to 5 µm.

When the first modified region 81 is formed as described above, a second modified region having substantially the same configuration as the first modified region 81 is formed adjacent to both side of the first modified region.
In FIG. 31 A, the second modified region is formed so as to be parallel to the first modified region 81 at back side of the paperface and in front of the paperface (not shown in the figure).
At this time, as with the first modified region 81 which is constituted of the first part 85 and the second part 86, the second modified region is also constituted of a first part and a second part.
In the subsequent step B, when the modification history in the second part 86 of the first modified region 81 is erased, the modification history in the second part of the second modified region is similarly erased.

### Step B Of Second Embodiment

A plurality of third modified regions 83 are formed so as to overlap or come into contact with the first part 85 of the first modified region 81 by scanning the region with the focal point of the second laser light M having a pulse duration on order of picoseconds or less in the longitudinal direction of the first modified region 81.
At this time, the third modified regions 83 form a periodic modified group 88 (FIG. 31 B).
In the drawing, ends of the third modified regions 83 (localized portions of the third modified regions) overlap the first part 85 of the first modified region 81.
The third modified regions 83 may be formed so that the ends of the third modified regions 83 come into contact with the first part 85 of the first modified region 81 without overlapping the first part 85 of the first modified region 81 (not shown in the figure).
In any case, it is possible to form the microscopic hole 1 and the periodic structure 2 by etching of the step C so as to connect the first part 85 of the first modified region 81 to the third modified regions 83.

In the step B, it is preferable that an angle formed between the polarization direction E (electric field direction) of the second laser light M and the longitudinal direction of the first modified region 81 be 0° to 88°. The angle is more preferably 0° to 15°, further preferably 0° to 5°, and most preferably 0°.
That is, it is preferable that the angle formed between the scanning direction U (right and left directions on the paperface) of the second laser light M and the polarization direction E (direction represented as a dotted line) of the second laser light M be 0° to 88°. The angle is more preferably 0° to 15°, further preferably 0° to 5°, and most preferably 0°.
FIG. 31 B shows the case where the angle is 0°.
It is possible to form the third modified regions 83 so as to intersect with the first modified region 81 by adjusting the angle (defined angle) defined by the scanning direction U and the polarization direction E to be within the aforementioned range.
In the case where the angle is 0°, it is possible to form the third modified regions 83 so as to be orthogonal to the first modified region 81.
In this case, due to the periodic modified group 88 formed of a plurality of third modified regions 83, it is possible to effectively remove the second part 86 of the first modified region 81 by a lower irradiation intensity of the laser light.

Moreover, as described above, the irradiation intensity of the second laser light M is set to be greater than or equal to the processing upper limit threshold value of the base member 4 or is set to be greater than or equal to the processing upper limit threshold value thereof and close to the processing upper limit threshold value thereof.
By determining the irradiation intensity of the laser light as described above, the periodic modified group 88 formed of the third modified regions 83 can be self-assembled.
The third modified regions 83 are formed so that the diameters thereof are on the order of nanometers or sub-micrometers by the irradiation of the second laser light M as mentioned above, and the period (distance between the recessed portions 3) of the periodic modified group 88 (periodic structure 2) can be 0.05 to 1.2 µm.

In the step B, it is possible to form the third modified regions 83 by irradiating the second part 86 forming the first modified region 81 (region 86 which is irradiated with the second laser light M when the third modified regions 83 are formed) with the laser as described above simultaneously with erasing of the modification history in the second part 86 of the first modified region 81.

Modification history of the second part 86 of the first modified region 81 is erased by forming the periodic modified group 88 which is constituted of the third modified regions 83, and the first part 85 of the first modified region 81 remains.
As apparent from FIG. 31 B, the major axis of the first part 85 (diameter of the first laser light L in the propagation direction thereof) is shorter than the total major axis of the first modified region 81 to which the first part 85 and the second part 86 are combined.
As a result, the major axis of the microscopic hole 1 which is formed after the first part 85 is etched is shorter than the major axis of the microscopic hole which is formed in the case where the periodic structure 2 (periodic modified group 88) is not formed.
That is, it is possible to form not only the minor axis of the microscopic hole 1 (diameter the first laser light L in the polarization direction thereof) but also the major axis of the microscopic hole 1 on the order of nanometers by forming the periodic structure 2.

When the third modified regions 83 are formed, the modification history of the second part 86 of the first modified region 81 is erased, and a region on which the third modified region 83 is not formed is generated.
The region is sandwiched between the third modified regions 83 in the periodic modified group 88 in which the third modified regions 83 are arrayed, and the fourth modified regions are formed on the regions.
In other words, in the periodic structure 2 which is formed after the first modified region 81 and the third modified regions 83 are removed by etching and in which the recessed portions 3 are arrayed, the regions are non-recessed regions sandwiched between the recessed portions 3.
The non-recessed regions are regions whose state verge a previous state of modification by the process of modifying the non-recessed regions as the second part 86 of the first modified region 81 in the step A (after the resistance to etching in the second part 86 decreases), thereafter, reducing the degree of modification in the step B (resistance to etching in the second part 86, which was degraded one time, is improved).

That is, "modification history is erased" means that the resistance to etching, which was degraded one time, is improved so as to restore to original state in a portion in which the base member is modified so that the resistance to etching in the base member decreases.
However, "modification history is erased" does not necessarily mean that the portion in which the modification history is erased completely restored to a pre-modification original state.
The state of the portion in which the modification history is erased may be different from an original state.

Up to here is the same as in the manufacturing method of the first embodiment of the aforementioned invention.
Subsequently, a fifth modified region 87 (a different first modified region 87) is formed on the region 87 by irradiating the region 87, in which the microscopic hole 5 is to be formed, with the first laser light L along the periodic modified group 88 in which the third modified regions 83 are provided in a row (FIG. 31C).
At this time, it is preferable that an angle formed between the polarization direction Y (electric field direction) of the first laser light L and the longitudinal direction of the fifth modified region 87 be greater than 88° and less than or equal to 90°.
That is, it is preferable that the angle formed between the scanning direction U (right and left directions on the paperface) of the first laser light L and the polarization direction Y of the first laser light L (deep direction presented as a point on the paperface) be greater than 88° and less than or equal to 90°. The angle is more preferably 88.5° to 90°, further preferably 89° to 90°, and most preferably 90°.
Additionally, it is preferable that the irradiation intensity of the first laser light L be less than the processing upper limit threshold value of the base member 4 and close to the processing upper limit threshold value thereof as described above, or be less than the processing upper limit threshold value thereof; and it is more preferable that the intensity be less than the processing upper limit threshold value and close to the processing lower limit threshold value.
If the irradiation intensity is less than the processing upper limit threshold value and close to the processing lower limit threshold value, it is possible to further-reliably inhibit modification history of the third modified region 86 from being erased when the fifth modified region 87 is formed.

It is possible to easily form the diameter (minor axis) in the polarization direction Y out of the diameters of the fifth modified region 87 to be formed, on the order of nanometers (approximately 1 nm to 900 nm) or sub-micrometers (approximately 0.9 to 1 µm) by irradiating the region with the first laser light L as configured above, particularly by determining the irradiation intensity to be close to the lower limit of the irradiation intensity of the laser light (processing lower limit threshold value) which is capable of reducing the resistance to etching.
Furthermore, it is possible to also form the diameter in the propagation direction of the first laser light L (major axis) out of the diameters of the formed fifth modified region 87 on the order of nanometers; and the diameters can be realized by irradiating the periodic modified group 88 with the first laser light L so as to partially (locally) overlap the periodic modified group.
Actually, the region, at which the fifth modified region 87 is formed after etching, is mainly irradiated with the first laser light L and in which the periodic modified group 88 is not formed.
The first laser light L, with which the periodic modified group 88 is irradiated and superimposed thereon, functions to overwrite the periodic modified group 88, but erasing of the modification history of the periodic modified group 88 and overwriting the fifth modified region 87 are not almost achieved.
The reason is that, short time irradiation causes that the irradiation intensity of the first laser light L is not high to the extent that the fifth modified region 87 can be overwritten.
However, if non-modified region, at which the periodic modified group 88 is not formed, is irradiated with the laser for the amount of laser irradiation time which is, for example, ten times or more required time of laser irradiation for forming the fifth modified region 87, the fifth modified region 87 may be formed so as to overwrite the periodic modified group 88.

In specific explanation, since the degree of modification is relatively low at end regions of the periodic modified group 88 in which a plurality of third modified regions 83 are formed, the modification history is erased due to irradiation of the first laser light L, and the fifth modified region 87 may be overwritten.
That is, particularly, end of the third modified regions 83 may be locally overwritten with the fifth modified region 87.
In this case as well, since the third modified regions 83 (periodic modified group 88) function to prohibit the fifth modified region 87 from being partially formed, it is possible to shorten the major axis of the diameter of the fifth modified region 87 (diameter of the first laser light L in the propagation direction thereof).

The third modified regions 83 are arranged in a line in the periodic modified group 88.
When such the third modified regions 83 are formed, fourth modified regions having a shape similar to the third modified regions 83 are formed adjacent to both sides thereof.
In FIG. 31 B, the fourth modified regions are formed at regions sandwiched between the third modified regions 83 in parallel with the third modified regions 83 (not shown in the figure).
In the case where the region sandwiched between the third modified regions 83 is irradiated with the first laser light L, seemingly, it is believed that the fifth modified region 87 is formed on the sandwiched region.
However, practically, the fifth modified region 87 is not formed on the region sandwiched between the third modified regions 83.
The reason is that, a fourth modified region (not shown in the figure) is formed on the region sandwiched between the third modified regions 83 by the irradiation of the second laser light M, and the fifth modified region 87 is prohibited from being formed.

In short, the modification history of the first modified region 81 formed by the first laser light L is cleared by the second laser light M, furthermore, it is possible to overwrite the periodic modified group 88 constituted of the third modified regions 83 and the fourth modified region.
On the other hand, the modification history of the periodic modified group 88, which is formed by the second laser light M and which is constituted of the third modified regions 83 and the fourth modified region, is not erased by the first laser light L (but, slight modification may occur) and is little overwritten with the fifth modified region 87.
The mechanism described above is common to a manufacturing method of a fifth embodiment of the invention which will be described later.

In the case of irradiation by use of the first laser light L in order to form the fifth modified region 87, it is preferable that the side at which the first part 85 of the first modified region is not formed be irradiated with the first laser light L.
For example, in FIGS. 31A to 31 D, the upper face of the base member 4 is preferably irradiated with the first laser light L for forming the first modified region 81 and the lower face of the base member 4 is preferably irradiated with the first laser light L for forming the fifth modified region 87.
When the fifth modified region 87 is formed by irradiation of the first laser light L, there is a case where it is difficult to focus the focal point (light focus area) of the first laser light L passing through the third modified region 86 (periodic modified group 88) on the position across the third modified region 86 while scanning the position with the focal point (light focus area).
In order to avoid the difficulties, it is preferable that the fifth modified region 87 be formed by irradiation of the first laser light L from the position at which it is not necessary for the laser to pass through the first modified region 81 and the third modified region 86.

### Step C Of Second Embodiment

In the step C, the first part 85 of the first modified region 81, the third modified regions 83, and the fifth modified region 87 (different another first modified region 87) which are formed in the base member 4 are removed by etching.
Consequently, the microscopic holes 1 and 5, in which the periodic structure 6 is formed, are formed.
The configuration of the opening portion of the microscopic holes 1 and 5, which opens at the side face of the base member 4 forming the resultant base body 10D, is a cross section A or a cross section B shown in FIGS. 9B and 9C.
It is also possible to obtain a preferred cross-sectional shape shown in the cross section A or the cross section B by exposing a fresh cross-sectional face by polishing or cutting the side face of the base body 4.
By carrying out the above- described steps A to C, it is possible to manufacture the base body 10D related to the invention.

### Third Embodiment Of Method Of Manufacturing Base Body

Next, the manufacturing method of a third embodiment of the invention will be described using the above-described base body 10D as an example with reference to FIGS. 32A to 32C.

### Step A Of Third Embodiment

Inside the base member 4 constituting the base body, a region 81 including a region 85 at which the microscopic hole 1 is to be formed and a region 87 at which the microscopic hole 5 is to be formed is scanned with the focal point of the first laser light L by irradiation of the base member with a first laser light L having a pulse duration on order of picoseconds or less, and a first modified region 81 is thereby formed on the region 81 (FIG. 32A).
The first modified region 81 is constituted of only the first parts 85 and 87 and the second part 86 excluding the first parts 85 and 87.
Particularly, the boundary between the first parts 85 and 87, and the second part 86 are not present, and portions to be etched in the subsequent step C are the first parts 85 and 87.

In the step A, it is preferable that an angle formed between the polarization direction Y (electric field direction) of the first laser light L and the longitudinal direction of the first modified region 81 be greater than 88° and less than or equal to 90°.
That is, it is preferable that the angle formed between the scanning direction U (right and left directions on the paperface) of the first laser light L and the polarization direction Y of the first laser light L (deep direction presented as a point on the paperface) be greater than 88° and less than or equal to 90°. The angle is more preferably 88.5° to 90°, further preferably 89° to 90°, and most preferably 90°.
Additionally, it is preferable that the irradiation intensity of the first laser light L be less than the processing upper limit threshold value of the base member 4 and close to the processing upper limit threshold value thereof, or be less than the processing upper limit threshold value thereof.

It is possible to easily form the diameter (minor axis) in the polarization direction Y out of the diameters of the first modified regions to be formed, on the order of nanometers (approximately 1 nm to 900 nm) or sub-micrometers (approximately 0.9 to 1 µm) by irradiating the region with the first laser L as configured above.
On the other hand, the diameter in the propagation direction of the first laser light L (major axis) out of the diameters of the first modified regions to be formed is generally formed at approximately 0.5 to 5 µm.

When the first modified region 81 is formed as described above, a second modified region having substantially the same configuration as the first modified region 81 is formed adjacent to both side of the first modified region.
In FIG. 32A, the second modified region is formed so as to be parallel to the first modified region 81 at back side of the paperface and in front of the paperface (not shown in the figure).
At this time, as with the first modified region 81 which is constituted of the first parts 85 and 87, and the second part 86, the second modified region is also constituted of a first part and a second part.
In the subsequent step B, when the modification history in the second part 86 of the first modified region 81 is erased, the modification history in the second part of the second modified region is similarly erased.

### Step B Of Third Embodiment

A plurality of third modified regions 83 are formed so as to overlap or come into contact with the first parts 85 and 87 of the first modified region 81 by scanning the region with the focal point of the second laser light M having a pulse duration on order of picoseconds or less in the longitudinal direction of the first modified region 81.
At this time, the third modified regions 83 form a periodic modified group 89 (FIG. 32B).
In the drawing, ends of the third modified regions 83 overlap the first parts 85 and 87 of the first modified region 81.
The third modified regions 83 may be formed so that the ends of the third modified regions 83 come into contact with the first parts 85 and 87 of the first modified region 81 without overlapping the first part 85 of the first modified region 81 (not shown in the figure).
In any case, it is possible to form the periodic structure 6, which is constituted of the microscopic holes 1 and 5 and a plurality of microscopic through holes 7, by etching of the step C, so as to connect the first part 85 of the first modified region 81 to the first part 87 with the third modified regions 83 interposed therebetween.

In the step B, it is preferable that an angle formed between the polarization direction E (electric field direction) of the second laser light M and the longitudinal direction of the first modified region 81 be 0° to 88°. The angle is more preferably 0° to 15°, further preferably 0° to 5°, and most preferably 0°.
That is, it is preferable that the angle formed between the scanning direction U (right and left directions on the paperface) of the second laser light M and the polarization direction E (direction represented as a dotted line) of the second laser light M be 0° to 88°. The angle is more preferably 0° to 15°, further preferably 0° to 5°, and most preferably 0°.
FIG. 32B shows the case where the angle is 0°.
It is possible to form the third modified regions 83 so as to intersect with the first modified region 81 by adjusting the angle (defined angle) defined by the scanning direction U and the polarization direction E to be within the aforementioned range.
In the case where the angle is 0°, it is possible to form the third modified regions 83 so as to be orthogonal to the first modified region 81.
In this case, due to the periodic modified group 89 formed of a plurality of third modified regions 83, it is possible to effectively remove the modification history of the second part 86 of the first modified region 81 by a lower irradiation intensity of the laser light.

Moreover, as described above, the irradiation intensity of the second laser light M is set to be greater than or equal to the processing upper limit threshold value of the base member 4 or set to be greater than or equal to the processing upper limit threshold value thereof and close to the processing upper limit threshold value thereof.
By determining the irradiation intensity of the laser light as described above, the periodic modified group 89 formed of the third modified regions 83 can be self-assembled.
The third modified regions 83 are formed so that the diameters thereof are on the order of nanometers or sub-micrometers by the irradiation of the second laser light M as mentioned above, and the period (distance between the microscopic through holes 7) of the periodic modified group 89 (periodic structure 6) can be 0.05 to 1.2 µm.

In the step B, it is possible to form the third modified regions 83 by irradiating the second part 86 forming the first modified region 81 (region 86 which is irradiated with the second laser light M when the third modified regions 83 are formed) with the laser as described above simultaneously with erasing of the modification history in the second part 86 of the first modified region 81.

At this time, the modification history of the second part 86 of the first modified region 81 is erased, and a region on which the third modified region 83 is not formed is generated.
The region is a region which is sandwiched between the third modified regions 83 in the periodic modified group 89 in which the third modified regions 83 are arrayed, and the fourth modified regions are formed on the regions.
In other words, in the periodic structure 6 which is formed after the first modified region 81 and the third modified regions 83 are removed by etching and in which the microscopic through holes 7 are arrayed, the regions are non-microscopic-through-hole regions sandwiched between the microscopic through holes 7.
The non-microscopic-through-hole regions are regions whose state verge a previous state of modification by the process of modifying the non-recessed regions as the second part 86 of the first modified region 81 in the step A (after the resistance to etching in the second part 86 decreases), thereafter, reducing the degree of modification in the step B (resistance to etching in the second part 86, which was degraded one time, is improved).

That is, "modification history is erased" means that the resistance to etching, which was degraded one time, is improved so as to restore to original state in a portion in which the base member is modified so that the resistance to etching in the base member decreases.
However, "modification history is erased" does not necessarily mean that the portion in which the modification history is erased completely restored to a pre-modification original state.
The state of the portion in which the modification history is erased may be different from an original state.

In the step B, the modification history of the second part 86 of the first modified region 81 is erased by forming the periodic modified group 89 constituted of the third modified regions 83, and the first parts 85 and 87 of the first modified region 81 remain.
As also apparent from FIG. 32B, each major axis of one first parts 85 and another (the other) first part 87 (diameter of the first laser light L in the propagation direction thereof) is shorter than the total major axis of the first modified region 81 which is the sum of the major axes of the first parts 85 and 87 and the second part 86.
As a result, each major axis of the microscopic holes 1 and 5 formed after etching the first parts 85 and 87 is shorter than the major axis of the microscopic hole of the case where the periodic structure 6 (periodic modified group 89) is not formed.
Particularly, it is possible to form not only the minor axes of the microscopic holes 1 and 5 (diameter the first laser light L in the polarization direction) but also the major axis of the microscopic hole 1 on the order of nanometers by forming the periodic structure 6.

### Step C Of Third Embodiment

In the step C, the first parts 85 and 87 of the first modified region 81 and the third modified regions 83 which are formed in the base member 4 are removed by etching.
Consequently, the microscopic holes 1 and 5, in which the periodic structure 6 is formed, are formed.
The configuration of the opening portion of the microscopic holes 1 and 5, which opens at the side face of the base member 4 forming the resultant base body 10D, is a cross section A or a cross section B shown in FIGS. 9B and 9C.
It is also possible to obtain a preferred cross-sectional shape shown in the cross section A or the cross section B by exposing a fresh cross-sectional face by polishing or cutting the side face of the base body 4.
By carrying out the above- described steps A to C, it is possible to manufacture the base body 10D related to the invention.

Next, the manufacturing method of a fourth embodiment of the invention will be described using the above-described base body 10G as an example with reference to FIGS. 24A to 24C.
FIGS. 24A to 24C illustrate the aforementioned manufacturing method of the first embodiment of the invention and is used for the explanation of this embodiment.

### Fourth Embodiment Of Method Of Manufacturing Base Body

### Step A Of Fourth Embodiment

Inside the base member 4 constituting the base body, a region including regions 85, 85', and 85" at which the microscopic holes 1, 1', and 1" are to be formed is scanned with the focal point of the first laser light L having a pulse duration on order of picoseconds or less while the irradiation of the laser light, and a first modified regions 81, 81', and 81" are thereby formed on the region (FIG. 24A).

The formed first modified region 81 is constituted of only the first part 85 and the second part 86 excluding the first part 85.
Particularly, the boundary between the first part 85 and the second part 86 is not present, and the first part 85 is to be etched in the subsequent step C.
Similarly, the first modified region 81' formed parallel to the first modified region 81 is configured to include the first part 85' and the second part 86', and the first modified region 81" is configured to include the first part 85" and the second part 86".

In the step A, it is preferable that an angle formed between the polarization direction Y (electric field direction) of the first laser light L and the longitudinal direction of the first modified regions 81, 81', and 81" be greater than 88° and less than or equal to 90°.
That is, it is preferable that the angle formed between the scanning direction U (right and left directions on the paperface) of the first laser light L and the polarization direction Y of the first laser light L (deep direction presented as a point on the paperface) be greater than 88° and less than or equal to 90°. The angle is more preferably 88.5° to 90°, further preferably 89° to 90°, and most preferably 90°.
Additionally, as described above, it is preferable that the irradiation intensity of the first laser light L be greater than or equal to the processing upper limit threshold value of the base member 4 or be greater than or equal to the processing upper limit threshold value and close to the processing upper limit threshold value.

It is possible to easily form the diameter (minor axis) in the polarization direction Y out of the diameters of the first modified regions 81, 81', and 81" to be formed, on the order of nanometers (approximately 1 nm to 900 nm) or sub-micrometers (approximately 0.9 to 1 µm) by irradiating the region with the first laser light L as configured above.
On the other hand, the diameter in the propagation direction of the first laser light L (major axis) out of the diameters of the first modified regions 81, 81', and 81" to be formed is generally formed at approximately 0.5 to 5 µm.

Here, the first modified regions 81, 81', and 81 ", which are formed parallel to the planar direction of the base member 4, are simultaneously formed by scanning of the laser light L one time.
The reason is that, by determining the irradiation intensity of the laser light L to be greater than or equal to the processing upper limit threshold value of the base member 4 or to be greater than or equal to the processing upper limit threshold value and close to the processing upper limit threshold value, interference of an electron plasma wave and incident light occurs at the light-collecting portion, and a periodic structure which aligns at a predetermined distance in the polarization direction of the laser and has periodicity is self-assembled.
By controlling the irradiation intensity of the laser light, it is possible to form substantially 2 to 10 of the first modified regions in parallel with each other.

When the first modified regions 81, 81', and 81" are formed as described above, the second modified region having substantially the same configuration as the first modified regions 81, 81', and 81" can be formed adjacent to both sides of each first modified region.
In FIG. 24A, the second modified regions are formed parallel to the first modified regions 81, 81', and 81" at back side of the paperface and in front of the paperface (not shown in the figure).
At this time, each first modified region is formed by the first part 85 and the second part 86 while each second modified region is also formed by the first part and the second part.
In the subsequent step B, when the modification history of the second part of each first modified region is erased, the modification history in the second part of the second modified region is similarly erased.

### Step B Of Fourth Embodiment

A plurality of third modified regions 83 are formed so as to overlap or come into contact with the parts 85, 85', and 85" of the first modified regions 81, 81', and 81" by scanning the region with the focal point of the second laser light M having a pulse duration on order of picoseconds or less in the longitudinal direction of the first modified regions 81, 81', and 81 ".
At this time, the third modified regions 83 form a periodic modified group 88 (FIG. 24B).
In the drawing, ends of the third modified regions 83 overlap the first parts 85, 85', and 85" of the first modified regions 81, 81', and 81".
The third modified regions 83 may be formed so that the ends of the third modified regions 83 come into contact with the first parts 85, 85', and 85" of the first modified regions 81, 81', and 81" without overlapping the first part 85 of the first modified region 81 (not shown in the figure).
In any case, it is possible to form the microscopic holes 1, 1', and 1" and the periodic structure 2 by etching of the step C so that the first parts 85, 85', and 85" of the first modified regions 81, 81', and 81" are connected to the third modified regions 83.

In the step B, it is preferable that an angle formed between the polarization direction E (electric field direction) of the second laser light M and the longitudinal direction of the first modified regions 81, 81', and 81" be 0° to 88°. The angle is more preferably 0° to 15°, further preferably 0° to 5°, and most preferably 0°.
That is, it is preferable that the angle formed between the scanning direction U (right and left directions on the paperface) of the second laser light M and the polarization direction E (direction represented as a dotted line) of the second laser light M be 0° to 88°. The angle is more preferably 0° to 15°, further preferably 0° to 5°, and most preferably 0°.
FIG. 24B shows the case where the angle is 0°.
It is possible to form the third modified regions 83 so as to intersect with the first modified regions 81, 81', and 81" by adjusting the angle (defined angle) defined by the scanning direction U and the polarization direction E to be within the aforementioned range.
In the case where the angle is 0°, it is possible to form the third modified regions 83 so as to be orthogonal to the first modified regions 81, 81', and 81 ".
In this case, due to the periodic modified group 88 formed of a plurality of third modified regions 83, it is possible to effectively remove the modification histories of the second parts 86, 86', and 86" of the first modified regions 81, 81', and 81" by a lower irradiation intensity of the laser light.

Moreover, as described above, it is preferable that the irradiation intensity of the second laser light M be greater than or equal to the processing upper limit threshold value of the base member 4 or be greater than or equal to the processing upper limit threshold value thereof and close to the processing upper limit threshold value thereof.
By determining the irradiation intensity of the laser light as described above, the periodic modified group 88 formed of the third modified regions 83 can be self-assembled.
The third modified regions 83 are formed so that the diameters thereof are on the order of nanometers or sub-micrometers by the irradiation of the second laser light M as mentioned above, and the period (distance between the recessed portions 3) of the periodic modified group 88 (periodic structure 2) can be 0.05 to 1.2 µm.

In the step B, it is possible to form the third modified regions 83 by irradiating the second parts 86, 86', and 86" forming the first modified regions 81, 81', and 81" (regions which are irradiated with the second laser light M when the third modified regions 83 are formed) with the laser as described above simultaneously with erasing of the modification histories in the second parts 86, 86', and 86" of the first modified regions 81, 81', and 81".

Modification history of the second part 86 of the first modified region 81 is erased by forming the periodic modified group 88 which is constituted of the third modified regions 83, and the first part 85 of the first modified region 81 remains.
As apparent from FIG. 24B, the major axis of the first part 85 (diameter of the first laser light L in the propagation direction thereof) is shorter than the total major axis of the first modified region 81 to which the first part 85 and the second part 86 are combined.
As a result, the major axis of the microscopic hole 1 which is formed after the first part 85 is etched is shorter than the major axis of the microscopic hole which is formed in the case where the periodic structure 2 (periodic modified group 88) is not formed.
That is, it is possible to form not only the minor axis of the microscopic hole 1 (diameter the first laser light L in the polarization direction thereof) but also the major axis of the microscopic hole 1 on the order of nanometers by forming the periodic structure 2.
Similarly, the minor axis and the major axis of the microscopic holes 85' corresponding to the first modified region 81' and the microscopic holes 85" corresponding to the first modified region 81" can be formed on the order of nanometers.

When the third modified regions 83 are formed, the modification histories of the second parts 86, 86', and 86" of the first modified regions 81, 81', and 81" are erased, and a region on which the third modified region 83 is not formed is generated.
The region is a region which is sandwiched between the third modified regions 83 in the periodic modified group 88 in which the third modified regions 83 are arrayed, and the fourth modified regions are formed on the regions.
In other words, in the periodic structure 2 which is formed after the first modified regions 81, 81', and 81" and the third modified regions 83 are removed by etching and in which the recessed portions 3 are arrayed, the regions are non-recessed regions sandwiched between the recessed portions 3.
The non-recessed regions are regions whose state verge a previous state of modification by the process of modifying the non-recessed regions as the second parts 86, 86', and 86" of the first modified regions 81, 81', and 81" in the step A (after the resistance to etching in the other part decreases), thereafter, reducing the degree of modification in the step B (resistance to etching in the other part, which was degraded one time, is improved).

That is, "modification history is erased" means that the resistance to etching, which was degraded one time, is improved so as to restore to original state in a portion in which the base member is modified so that the resistance to etching in the base member decreases.
However, "modification history is erased" does not necessarily mean that the portion in which the modification history is erased completely restored to a pre-modification original state.
The state of the portion in which the modification history is erased may be different from an original state.

### Step C Of Fourth Embodiment

In the step C, the first parts 85, 85', and 85" of the first modified regions 81, 81', and 81" and the third modified regions 83 which are formed in the base member 4 are removed by etching.
Consequently, the periodic structure 2 and the microscopic holes 1, 1', and 1" are formed.
The configurations of the opening portions of the microscopic holes 1, 1', and 1 ", which open at the side face of the base member 4 forming the resultant base body 10G, is a cross section A or a cross section B shown in FIGS. 16B and 16C.
It is also possible to obtain a preferred cross-sectional shape shown in the cross section A or the cross section B by exposing a fresh cross-sectional face by polishing or cutting the side face of the base body 4.
By carrying out the above- described steps A to C, it is possible to manufacture the base body 10G related to the invention.

### Fifth Embodiment Of Method Of Manufacturing Base Body

In the manufacturing method of the invention, regarding the order of the steps, either the step A or the step B may be carried out first.
Up to here, the case of performing the steps in the order from the step A to the step B are explained in a first to fourth embodiments.
Next firstly, the case of performing the steps in the order from the step A to the step B will be described in a fifth embodiment.

In the case In the case of performing the step A after the step B, it is preferable that the first modified region be formed so as to locally overlap or come into contact with the third modified regions and the fourth modified regions in the step A after a periodic modified group is formed in the step B.

When the first modified region is formed so as to locally overlap or come into contact with the third modified regions and the fourth modified regions, which constitute the periodic modified group, the first modified region is prohibited from being formed by the preliminarily-formed periodic modified group.
By this hindering, it is possible to form a modified region making the diameter of the first modified region shorter.
As a result, the diameter of the microscopic hole can be smaller than that of the case where a periodic structure is not formed.
That is, it is possible to form a smaller microscopic hole having a diameter on the order of nanometers with a microscopic periodic structure.

The manufacturing method of a fifth embodiment of the invention will be described using the above-described base body 10A as an example with reference to FIGS. 33A to 33C.

### Step B Of Fifth Embodiment

In the inside of the base member 4, a plurality of third modified regions 83 are formed by scanning the region with the focal point of the second laser light M having a pulse duration on order of picoseconds or less in the longitudinal direction of the first modified region 81 to be formed in the subsequent step A, and the periodic modified group 88 is formed by third modified regions 83 (FIG. 33A).

In the step B, it is preferable that the angle formed between the scanning direction U (right and left directions on the paperface) of the second laser light M and the polarization direction E (direction represented as a dotted line) of the second laser light M be 0° to 88°. The angle is more preferably 0° to 15°, further preferably 0° to 5°, and most preferably 0°.
FIG. 33A shows the case where the angle is 0°.
It is possible to form the third modified regions 83 so as to intersect with the scanning direction U by adjusting the angle (defined angle) defined by the scanning direction U and the polarization direction E to be within the aforementioned range.
In the case where the angle is 0°, it is possible to form the third modified regions 83 so as to be orthogonal to the scanning direction U.

Additionally, it is preferable that the irradiation intensity of the second laser light M be greater than or equal to the processing upper limit threshold value of the base member 4, or be greater than or equal to the processing upper limit threshold value and close to the processing upper limit threshold value as described above.
The periodic modified group 88 formed of the third modified regions 83 can be self-assembled due to determining the irradiation intensity of the laser light as described above.
The mechanism is explained above.

The third modified regions 83 are formed so that the diameters thereof are on the order of nanometers or sub-micrometers by the irradiation of the second laser light M as mentioned above, and the period (distance between the recessed portions 3) of the periodic modified group 88 (periodic structure 2) can be 0.05 to 1.2 µm.
At this time, the thicknesses (width) of the third modified regions 83 to be formed can be thinnest as seen from a direction perpendicular to the polarization direction E.
In the case where, for example, the polarization direction E is parallel to the scanning direction U, the thicknesses (width) of the third modified regions 83 to be formed can be thinnest as seen from the direction perpendicular to the scanning direction U (FIG. 33A).

The fourth modified regions having substantially the same configuration as the third modified regions 83 are adjacently formed at both sides of the third modified region and on the region sandwiched between the third modified regions 83 formed in the above-described manner (not shown in the figure).

### Step A Of Fifth Embodiment

After the aforementioned step B is carried out, the step A is performed.
A region 93 including a region 85 at which the microscopic hole 1 is to be formed is scanned with the focal point of the first laser light L having a pulse duration on order of picoseconds or less while the irradiation of the laser light in the direction of the periodic modified group 88.
At this time, it is preferable that the periodic modified group 88 be irradiated with the focal point of the first laser light L (light-collecting portion) so as to partially overlap the periodic modified group.
Due to the irradiation as described above, the first modified region 91 is formed on a region 91, which is not mainly superimposed on the periodic modified group 88, out of the irradiated areas 93 (FIG. 33B).
On the other hand, the modified regions are not almost formed on a region 92 (hereinbelow, referred to as superimposed region 92) out of the irradiated area 93, which is superimposed on the periodic modified group 88.
As a result, the third modified regions 83 forming the periodic modified group 88 come into contact with the first modified region 91, furthermore, it is possible to form the first modified region 91 so as to provide in a row in the longitudinal direction of the first modified region 91.
In addition, the boundaries between the first modified region 91 and the third modified regions 83 is not present, and both modified regions are etched and removed in the subsequent step C.

In specific explanation, since the degree of modification is relatively low at end regions of the periodic modified group 88 in which a plurality of third modified regions 83 are formed, the modification history is erased due to irradiation of the first laser light L, and the first modified region 91 may be overwritten.
That is, particularly, end of the third modified regions 83 may be locally overwritten with the first modified region 91.
In this case as well, since the third modified regions 83 (periodic modified group 88) function to prohibit the first modified region 91 from being partially formed, it is possible to shorten the major axis of the diameter of the first modified region 91 (diameter of the first laser light L in the propagation direction thereof).

In the step A, it is preferable that an angle formed between the polarization direction Y (electric field direction) of the first laser light L and the longitudinal direction of the first modified region 91 be greater than 88° and less than or equal to 90°.
That is, it is preferable that the angle formed between the scanning direction U (right and left directions on the paperface) of the first laser light L and the polarization direction Y of the first laser light L (deep direction presented as a point on the paperface) be greater than 88° and less than or equal to 90°. The angle is more preferably 88.5° to 90°, further preferably 89° to 90°, and most preferably 90°.
Additionally, it is preferable that the irradiation intensity of the first laser light L be less than the processing upper limit threshold value of the base member 4 and close to the processing upper limit threshold value thereof, or be less than the processing upper limit threshold value thereof as described above.

It is possible to easily form the diameter (minor axis) in the polarization direction Y out of the diameters of the first modified regions 91 to be formed, on the order of nanometers (approximately 1 nm to 900 nm) or sub-micrometers (approximately 0.9 to 1 µm) by irradiating the region with the first laser light L as configured above.
Furthermore, it is possible to also form the diameter in the propagation direction of the first laser light L (major axis) out of the diameters of the formed first modified region 91 on the order of nanometers. The reason is that, the periodic modified group 88 is partially irradiated with the focal point of the first laser light L so that the the focal point partially (locally) overlaps the periodic modified group 88.
That is, the major axis of the first modified region 91 becomes shortened by the amount at which a modified region is not formed on the superimposed region 92 (FIG. 33B).

As shown in FIG. 33B, the superimposed region 92 is not modified in spite of being irradiated with the first laser light L.
The first laser light L functions to overwrite the periodic modified group 88 in the superimposed region 92, but erasing of the modification history of the periodic modified group 88 and overwriting the first modified region are not almost achieved.
The reason is that, the irradiation intensity of the first laser light L is not high to the extent that the first modified region can be overwritten.

The third modified regions 83 are arranged in a line in the periodic modified group 88.
When such the third modified regions 83 are formed, fourth modified regions having a shape similar to the third modified regions 83 are formed adjacent to both sides thereof.
In FIG. 33B, the fourth modified regions are formed at regions sandwiched between the third modified regions 83 in parallel with the third modified regions 83 (not shown in the figure).
In the case where the region sandwiched between the third modified regions 83 is irradiated with the first laser light L, seemingly, it is believed that the first modified region 91 is formed on the sandwiched region.
However, practically, the first modified region 91 is not formed on the region sandwiched between the third modified regions 83.
The reason is that, a fourth modified region (not shown in the figure) is formed on the region sandwiched between the third modified regions 83 by the irradiation of the second laser light M, and the first modified region 91 is prohibited from being formed.

In short, the modification history of the periodic modified group 88, which is formed by the second laser light M and which is constituted of the third modified regions 83 and the fourth modified region, is not erased by the first laser light L (but, slight modification may occur) and, the modification history of the modified group 88 is little overwritten with the first modified region 81.

### Step C Of Fifth Embodiment

In the step C, the first modified region 91 and the third modified regions 83 which are formed in the base member 4 are removed by etching.
Consequently, the periodic structure 2 and the microscopic hole 1 are formed.
As mentioned above, since the material used to form the base member 4 in which the first modified region 91 and the third modified regions 83 are formed is modified so as to decrease the resistance to etching with respect to a predetermined etching solution, the material is removed from the base member 4 by etching of the step C.

The configuration of the opening portion of the microscopic hole 1, which opens at the side face of the base member 4 forming the resultant base body 10A, is a cross section A or a cross section B shown in FIGS. 2B and 2C.
It is also possible to obtain a preferred cross-sectional shape shown in the cross section A or the cross section B by exposing a fresh cross-sectional face by polishing or cutting the side face of the base body 4.
As described above, in the manufacturing method of the invention, even where the step B, the step A, and the step C are carried out in this order, it is possible to manufacture the base body 10A related to the invention.

### Overwriting Mechanism In Modified Region

In the manufacturing methods of the first to fourth embodiments of the invention, after the first modified region and the second modified region are formed by the first laser light L, the modified region of modification histories of the first modified region and the second are removed by the second laser light M, the regions are overwritten with the third modified region and the fourth modified region, and the third modified region and the fourth modified region are thereby formed.
As an example, in the case of using a silica substrate or a glass substrate, this overwriting mechanism can be described as follows with reference to FIGS. 34A to 34D.
By irradiating the base body 10 with the first laser light L, an oxygen content decreases in the first modified region, and etching selectivity is applied thereto.
On the other hand, in the second modified region, since an oxygen content increases more than before irradiation of the laser light L, the region is less easily etched than before being irradiated with the laser light L.
Consequently, in order to apply etching selectivity to the region by overwriting the second modified region with the second laser light M by irradiation, the irradiation intensity of the laser light is necessary which is further greater than the irradiation intensity required for modifying the region, which was irradiated with the laser light L, so as to apply etching selectivity to the region.
Because of this, even in cases where etching selectivity is not obtained when the second modified region is irradiated with the second laser light M, etching selectivity may be obtained at a region which is not irradiated with the first laser light L and is only irradiated with the second laser light M.
In the explanation described below, the first modified region can be read as the second modified region and the third modified region can be read as the fourth modified region.
In the case of reading as mentioned above, "decrease in oxygen content" is read as "increase in oxygen content" while "increase in oxygen content" is read as "decrease in oxygen content".

Firstly, the first modified region is formed by the first laser light L.
The oxygen content in the first modified region is made low to the extent that selective (preferential) etching can be carried out (FIG. 34A).
Subsequently, if the first modified region is irradiated with the second laser light M so as to be superimposed thereon, three cases may occur.

In the first case, the oxygen content in the first modified region slightly increases and the degree of modification is a low level (the degree of modification becomes slightly close to a previous state of modification), but it is not enough to erase the modification history of the first modified region.
The reason is that, the irradiation intensity of the second laser light M (the number of laser pulses or the like) is low.
In the first case, the first modified region is only removed by etching, and the microscopic holes is thereby only formed (FIG. 34B).

In the second case, as a result of the degree of modification becoming close to a previous state of modification due to a significant increase in the oxygen content in the first modified region, the modification history of the first modified region is erased, however, the third modified region is not formed.
The reason is that, the irradiation intensity of the second laser light M (the number of laser pulses or the like) is not still enough.
In the second case, since a modified region which is to be selectively removed by etching is not present, a microscopic hole or a periodic structure is not formed (FIG. 34C).

In the third case, as a result of the degree of modification becoming close to a previous state of modification due to a sufficient increase in the oxygen content in the first modified region, the modification history of the first modified region is erased, furthermore, the third modified region is formed.
The reason is that, the irradiation intensity of the second laser light M (the number of laser pulses or the like) is enough.
In the third case, since the third modified region is removed by etching, for example, the aforementioned periodic structure (periodic modified group) is formed.
Moreover, in this regions, the microscopic hole is not formed (FIG. 34D).
The manufacturing methods of the first to fourth embodiments of the invention mainly use the method of the third case.
However, since the intensity of the laser irradiation is at its peak at the center of the light-collecting portion and the intensity gradually reduces in the direction from the center to the periphery thereof, a portion, which is partially in the state of the above-described first case or the second case, is at least present at the periphery of the light-collecting portion.

In the manufacturing method related to the fifth embodiment of the invention, even though the third modified regions are irradiated with the first laser light L so as to be superimposed thereon after the third modified regions (periodic modified group) are formed by the second laser light M, the modification histories of the third modified regions are not removed.
That is, due to use of the first laser light L, a modified region formed by the second laser light M is not necessary to be overwritten.
As an example, in the case of using a glass substrate or a silica substrate, this mechanism can be described as follows with reference to FIGS. 35A to 35D.
By irradiating the base body 10 with the second laser light M, an oxygen content decreases in the third modified region, and etching selectivity is applied thereto.
On the other hand, in the fourth modified region, since an oxygen content increases more than before irradiation of the laser light M, the region is less easily etched than before being irradiated with the laser light M.
Consequently, in order to apply etching selectivity to the region by overwriting the third modified region with the first laser light L by irradiation, the irradiation intensity of the laser light is necessary which is further greater than the irradiation intensity required for modifying the region, which was irradiated with the laser light M, so as to apply etching selectivity to the region.
Because of this, even in cases where etching selectivity is not obtained when the fourth modified region is irradiated with the first laser light L, etching selectivity may be obtained at a region which is not irradiated with the second laser light M and is only irradiated with the first laser light L.

Firstly, the third modified region is formed by the second laser light M.
The oxygen content in the third modified region is made low to the extent that selective (preferential) etching can be carried out (FIG. 35A).
Subsequently, if the third modified region is irradiated with the first laser light L so as to be superimposed thereon, three cases may occur.

In the first case, the oxygen content in the third modified region slightly increases and the degree of modification is a low level (the degree of modification becomes slightly close to a previous state of modification), but it is not enough to erase the modification history of the third modified region.
The reason is that, the irradiation intensity of the first laser light L (the number of laser pulses or the like) is low.
In the first case, the third modified region is removed by etching, and the microscopic holes is thereby only formed (FIG. 35B).
The manufacturing method of the fifth embodiment of the invention uses the method of the first case.

In the second case, as a result of the degree of modification becoming close to a previous state of modification due to a significant increase in the oxygen content in the third modified region, the modification history of the third modified region is erased, however, the first modified region is not formed.
The reason is that, the irradiation intensity of the first laser light L (the number of laser pulses or the like) is not still enough.
In the second case, since a modified region which is to be selectively removed by etching is not present, a microscopic hole or a periodic structure is not formed at a region corresponding to the first modified region which was irradiated with at least the first laser light or at the periphery of the region (at near the region) (FIG. 35C).

In the third case, as a result of the degree of modification becoming close to a previous state of modification due to a sufficient increase in the oxygen content in the third modified region, the modification history of the third modified region is erased, furthermore, the first modified region is formed.
The reason is that, the irradiation intensity of the first laser light L (the number of laser pulses or the like) is enough.
In the third case, since the first modified region is removed by etching, for example, the periodic structure is formed.
Particularly, a periodic structure is not formed at a region corresponding to the first modified region which was irradiated with at least the first laser light or at the periphery of the region (at near the region) (FIG. 35D).

However, it is preferable that the first laser light L be set up so that the polarization direction thereof is substantially perpendicularly to the scanning direction and the irradiation intensity of the laser light is less than the processing upper limit threshold value.
On the other hand, it is preferable that the second laser light M be set up so that the polarization direction thereof is substantially parallel to the scanning direction and the irradiation intensity of the laser light is greater than or equal to the processing upper limit threshold value.
In order to realize the first case of the above-described explanation of the fifth embodiment, under such preferred laser irradiation conditions, it is preferable that the degree of modification in irradiation time per one hour in the case of using the second laser light M is higher.
In order to overwrite the third modified region formed by the second laser light M with the first laser light L and to realize the second and third cases of the above-described explanation of the fifth embodiment, it is necessary to, for example, carry out irradiation of the first laser light L with overlapping two or more times, elongate irradiation time, or make the degree of modification of the second laser light M lower.

### Industrial Applicability

The base body having the microscopic hole and the method of manufacturing the base body related to the invention is widely available to use and manufacture microfluidic devices or the like for performing various observation, analyzation, and measurement by trapping fine-particles such as a microorganism, a cell, or the like included in water, air, or the like.

## Claims

1. A method of manufacturing a base body having a microscopic hole, comprising:
forming at least one of a first modified region and a second modified region by scanning inside of a base body with a focal point of a first laser light having a pulse duration on order of picoseconds or less;
forming a periodic modified group formed of a plurality of third modified regions and fourth modified regions by scanning an inside of the base body with a focal point of a second laser light having a pulse duration on order of picoseconds or less;
obtaining the base body which is formed so that the first modified region and the second modified region overlap or come into contact with the modified group; and
forming a microscopic hole by removing the first modified region and the third modified regions by etching.

2. The method of manufacturing a base body having a microscopic hole according to claim 1, wherein
each of the first modified region and the second modified region formed by the first laser light is constituted of a first part and a second part,
modified states of the second part of the first modified region and the second part of the second modified region are transformed into a non-etching selectivity state by forming the modified group so as to overlap the second part of the first modified region and the second part of the second modified region after the first modified region and the second modified region are formed, and
the first part of the first modified region, the first part of the second modified region, and the periodic modified group are formed so that the first part of the first modified region and the first part of the second modified region overlap or come into contact with the periodic modified group.

3. The method of manufacturing a base body having a microscopic hole according to claim 1, wherein
the first modified region and the second modified region are formed so as to locally overlap or come into contact with the third modified regions and the fourth modified regions after the modified group is formed.

4. The method of manufacturing a base body having a microscopic hole according to any one of claims 1 to 3, wherein
an angle formed between a scanning direction of the first laser light and a polarization direction of the first laser light is greater than 88° and less than or equal to 90°.

5. The method of manufacturing a base body having a microscopic hole according to any one of claims 1 to 4, wherein
an angle formed between a scanning direction of the second laser light and a polarization direction of the second laser light is 0° to 88°.

6. The method of manufacturing a base body having a microscopic hole according to any one of claims 1 to 5, wherein
the modified group is formed in longitudinal directions of the first modified region and the second modified region.

7. A base body comprising:
a microscopic hole provided inside the base body; and
a microscopic periodic structure formed in a longitudinal direction of the microscopic hole.

8. The base body according to claim 7, wherein
a plurality of microscopic recessed portions, each of which has an opening portion opening at an inner wall of the microscopic hole, are arrayed in the periodic structure.

9. The base body according to claim 8, wherein
a distance between the recessed portions is in the range of 0.05 to 1.2 µm.

10. A base body comprising:
a plurality of microscopic holes provided inside a base body and arranged parallel to each other; and
a microscopic periodic structure formed in a longitudinal direction of the microscopic holes.

11. The base body according to claim 10, wherein
a plurality of microscopic through holes, each of which connects the microscopic holes to each other, are arrayed in the periodic structure.

12. The base body according to claim 11, wherein
a distance between the microscopic through holes is in the range of 0.05 to 1.2 µm.
